# EUROPEAN PATENT APPLICATION

(11) **EP 4 318 622 A1**
(43) Date of publication of application: **07.02.2024**
(21) Application number: 22781713.7
(22) Date of filing: 01.04.2022
(51) Int. Cl.: H01L 51/00, H01L 51/50

(54) **COMPOSITION FOR ORGANIC OPTOELECTRONIC DEVICE, ORGANIC OPTOELECTRONIC DEVICE, AND DISPLAY DEVICE**

(30) Priority: 01.04.2021 KR 20210042905
(71) Applicant: Samsung SDI Co., Ltd., Yongin-si, Gyeonggi-do 17084 (KR)
(72) Inventor: LUI, Jinhyun, Suwon-si, Gyeonggi-do 16678 (KR); LYU, Seungchul, Suwon-si, Gyeonggi-do 16678 (KR); CHO, Pyeongseok, Suwon-si, Gyeonggi-do 16678 (KR); JUNG, Sung-Hyun, Suwon-si, Gyeonggi-do 16678 (KR); SHIN, Jihun, Suwon-si, Gyeonggi-do 16678 (KR); KIM, Hyung Sun, Suwon-si, Gyeonggi-do 16678 (KR); JUNG, Ho Kuk, Suwon-si, Gyeonggi-do 16678 (KR); LEE, Hanill, Suwon-si, Gyeonggi-do 16678 (KR); HUH, Dalho, Suwon-si, Gyeonggi-do 16678 (KR); KIM, Changwoo, Suwon-si, Gyeonggi-do 16678 (KR); SHIN, Chang Ju, Suwon-si, Gyeonggi-do 16678 (KR)
(74) Representative: Michalski Hüttermann & Partner Patentanwälte mbB
(86) International application number: PCT/KR2022/004749
(87) International publication number: WO 2022/211594

(57) **Abstract**

Provided are a composition for an organic optoelectronic device, an organic optoelectronic device, and a display device, the composition for an organic optoelectronic device including a Pt dopant represented by Chemical Formula 1, a first host including an electron transport group represented by Chemical Formula 2, and a second host including at least one hole transport group, wherein a HOMO energy level of the second host is higher than a HOMO energy level of the first host, and a difference between a LUMO energy level of the first host and the HOMO energy level of the second host is greater than 2.505 eV.
Details of Chemical Formula 1 and Chemical Formula 2 are as defined in the
specification.

## Description

### [Technical Field]

An organic optoelectronic device and a display device are disclosed.

### [Background Art]

An organic optoelectronic device (organic optoelectronic diode) is a device capable of converting electrical energy and optical energy to each other.

Organic optoelectronic devices may be largely divided into two types according to a principle of operation. One is a photoelectric device that generates electrical energy by separating excitons formed by light energy into electrons and holes, and transferring the electrons and holes to different electrodes, respectively and the other is a light emitting device that generates light energy from electrical energy by supplying voltage or current to the electrodes.

Examples of the organic optoelectronic device include an organic photoelectric device, an organic light emitting diode, an organic solar cell, and an organic photoconductor drum.

Among them, organic light emitting diodes (OLEDs) are attracting much attention in recent years due to increasing demands for flat panel display devices. The organic light emitting diode is a device that converts electrical energy into light, and the performance of the organic light emitting diode is greatly influenced by an organic material between electrodes.

### [Disclosure]

### [Technical Problem]

An embodiment provides a composition for an organic optoelectronic device capable of realizing a highly efficient organic optoelectronic device driven at a low voltage.

Another embodiment provides an organic optoelectronic device including the composition for an organic optoelectronic device.

Another embodiment provides a display device including the organic optoelectronic device.

### [Technical Solution]

According to an embodiment, a composition for an organic optoelectronic device including a Pt dopant represented by Chemical Formula 1, a first host including an electron transport group represented by Chemical Formula 2, and a second host including at least one hole transport group, wherein a HOMO energy level of the second host is higher than a HOMO energy level of the first host, and a difference between the LUMO energy level of the first host and the HOMO energy level of the second host is greater than 2.505 eV.

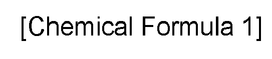

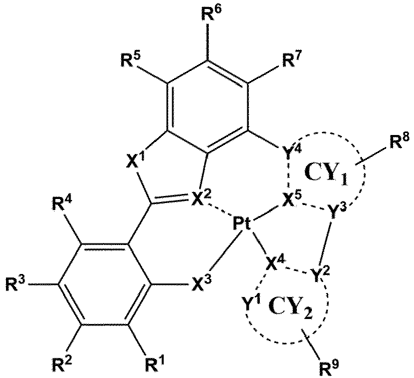

In Chemical Formula 1,
X¹ is selected from O, S, N-[(L¹)_{b1}-(R¹⁰)_{c1}], C(R¹⁰)(R¹¹), Si(R¹⁰)(R¹¹), and C(=O),
R¹⁰ and R¹¹ are each independently linked to each other via a first linking group to form a substituted or unsubstituted C5 to C30 carbocyclic group or a substituted or unsubstituted C1 to C30 heterocyclic group,
L¹ is selected from a substituted or unsubstituted C5 to C30 carbocyclic group and a substituted or unsubstituted C1 to C30 heterocyclic group,
b1 is selected from integers of 0 to 5,
c1 is selected from integers of 0 to 5,
R¹ to R⁹ are each independently selected from hydrogen, deuterium, -F, - Cl, -Br, -I, -SF₅, a hydroxyl group, a cyano group, a nitro group, an amidino group, a hydrazine group, a hydrazone group, a carboxylic acid group, or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C1 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted monovalent non-aromatic condensed polycyclic group, and a substituted or unsubstituted monovalent non-aromatic heterocondensed polycyclic group,
X³ is O or S and a bond between X³ and Pt is a covalent bond,
X², X⁴, and X⁵ are each independently N or C, one of a bond between X² and Pt, a bond between X⁴ and Pt, and a bond between X⁵ and Pt is a covalent bond, and the other two bonds are is a coordinative bond,
Y¹ to Y⁴ are each independently C or N,
CY₁ is a benzene group or a naphthalene group, and
CY₂ is a pyridine group or an isoquinoline group; 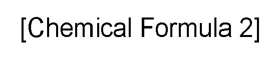 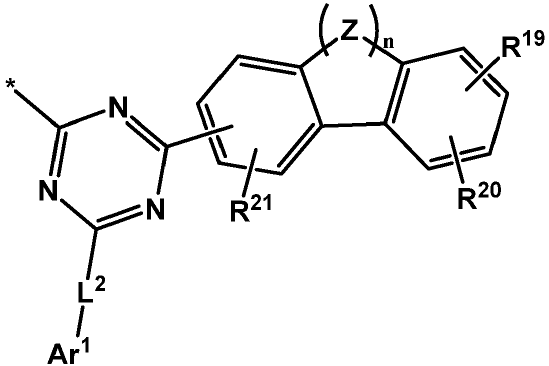
wherein, in Chemical Formula 2,
n is an integer of 0 or 1,
when n is 1, Z is O, S, CR^{a}R^{b}, or NR^{c},
R^{a}, R^{b}, R^{c}, and R¹⁹ to R²¹ are each independently hydrogen, deuterium, a cyano group, a halogen, a substituted or unsubstituted C1 to C30 alkyl group, or a substituted or unsubstituted C6 to C30 aryl group,
L² is a single bond, a substituted or unsubstituted C6 to C30 arylene group or a substituted or unsubstituted C2 to C30 heteroarylene group,
Ar¹ is a substituted or unsubstituted C6 to C30 aryl group or a substituted or unsubstituted C2 to C30 heteroaryl group, and
* is a linking point.

According to another embodiment, an organic optoelectronic device including the composition for an organic optoelectronic device is provided.

According to another embodiment, a display device including the organic optoelectronic device is provided.

### [Advantageous Effects]

A high-efficiency organic optoelectronic device driven at a low voltage may be implemented.

### [Description of the Drawings]

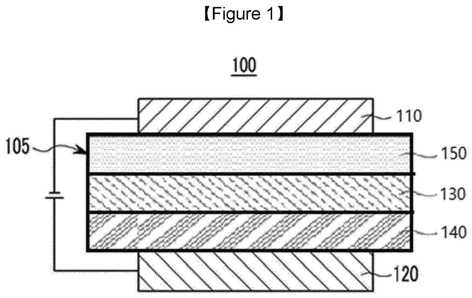

FIG. 1 is a cross-sectional view illustrating an organic light emitting diode according to an exemplary embodiment.

### <Description of Symbols>

100: organic light emitting diode
105: organic layer
110: cathode
120: anode
130: light emitting layer
140: hole transport region
150: electron transport region

### [Mode for Invention]

Hereinafter, embodiments of the present invention are described in detail. However, these embodiments are exemplary, the present invention is not limited thereto and the present invention is defined by the scope of claims.

In the present specification, when a definition is not otherwise provided, "substituted" refers to replacement of at least one hydrogen of a substituent or a compound by deuterium, a halogen, a hydroxyl group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, a C1 to C20 alkoxy group, a C1 to C10 trifluoroalkyl group, a cyano group, or a combination thereof.

In one example of the present invention, the "substituted" refers to replacement of at least one hydrogen of a substituent or a compound by deuterium, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, or a cyano group. In specific example of the present invention, the "substituted" refers to replacement of at least one hydrogen of a substituent or a compound by deuterium, a C1 to C20 alkyl group, a C6 to C30 aryl group, or a cyano group. In specific example of the present invention, the "substituted" refers to replacement of at least one hydrogen of a substituent or a compound by deuterium, a C1 to C5 alkyl group, a C6 to C18 aryl group, or a cyano group. In specific example of the present invention, the "substituted" refers to replacement of at least one hydrogen of a substituent or a compound by deuterium, a cyano group, a methyl group, an ethyl group, a propyl group, a butyl group, a phenyl group, a biphenyl group, a terphenyl group, or a naphthyl group.

In the present specification, when a definition is not otherwise provided, "hetero" refers to one including one to three heteroatoms selected from N, O, S, P, and Si, and remaining carbons in one functional group.

In the present specification, "an aryl group" refers to a group including at least one hydrocarbon aromatic moiety, and all elements of the hydrocarbon aromatic moiety have p-orbitals which form conjugation, for example a phenyl group, a naphthyl group, and the like, two or more hydrocarbon aromatic moieties may be linked by a sigma bond and may be, for example a biphenyl group, a terphenyl group, a quarterphenyl group, and the like, and two or more hydrocarbon aromatic moieties are fused directly or indirectly to provide a non-aromatic fused ring, for example a fluorenyl group.

The aryl group may include a monocyclic, polycyclic, or fused ring polycyclic (i.e., rings sharing adjacent pairs of carbon atoms) functional group.

In the present specification, "a heterocyclic group" is a generic concept of a heteroaryl group, and may include at least one heteroatom selected from N, O, S, P, and Si instead of carbon (C) in a cyclic compound such as an aryl group, a cycloalkyl group, a fused ring thereof, or a combination thereof. When the heterocyclic group is a fused ring, the entire ring or each ring of the heterocyclic group may include one or more heteroatoms.

For example, "a heteroaryl group" refers to an aryl group including at least one heteroatom selected from N, O, S, P, and Si. Two or more heteroaryl groups are linked by a sigma bond directly, or when the heteroaryl group includes two or more rings, the two or more rings may be fused. When the heteroaryl group is a fused ring, each ring may include one to three heteroatoms.

More specifically, the substituted or unsubstituted C6 to C30 aryl group may be a substituted or unsubstituted phenyl group, a substituted or unsubstituted naphthyl group, a substituted or unsubstituted anthracenyl group, a substituted or unsubstituted phenanthrenyl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted o-terphenyl group, a substituted or unsubstituted chrysenyl group, a substituted or unsubstituted triphenylene group, a substituted or unsubstituted perylenyl group, a substituted or unsubstituted fluorenyl group, a substituted or unsubstituted indenyl group, a substituted or unsubstituted furanyl group, or a combination thereof, but is not limited thereto.

More specifically, the substituted or unsubstituted C2 to C30 heterocyclic group may be a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted carbazolyl group, a substituted or unsubstituted dibenzofuranyl group, a substituted or unsubstituted dibenzothiophenyl group, a substituted or unsubstituted benzofuranpyrimidinyl group, a substituted or unsubstituted benzothiophenepyrimidinyl group, or a combination thereof, but is not limited thereto.

In the present specification, "deuterium substitution (-D)" may include "tritium substitution (-T)".

In the present specification, hole characteristics refer to an ability to donate an electron to form a hole when an electric field is applied and that a hole formed in the anode may be easily injected into the light emitting layer and transported in the light emitting layer due to conductive characteristics according to a highest occupied molecular orbital (HOMO) level.

In addition, electron characteristics refer to an ability to accept an electron when an electric field is applied and that electron formed in the cathode may be easily injected into the light emitting layer and transported in the light emitting layer due to conductive characteristics according to a lowest unoccupied molecular orbital (LUMO) level.

Hereinafter, an organic optoelectronic device according to an embodiment is described.

The organic optoelectronic device may be any device to convert electrical energy into photoenergy and vice versa without particular limitation, and may be, for example an organic photoelectric device, an organic light emitting diode, an organic solar cell, and an organic photoconductor drum.

Herein, an organic light emitting diode as one example of an organic optoelectronic device is described, but the present invention is not limited thereto, and may be applied to other organic optoelectronic device in the same way.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

FIG. 1 is a schematic cross-sectional view of an organic light emitting diode according to an embodiment.

Referring to FIG. 1, an organic light emitting diode 100 according to an embodiment includes an anode 120 and a cathode 110 facing each other and an organic layer 105 disposed between the anode 120 and cathode 110.

The anode 120 may be made of a conductor having a large work function to help hole injection, and may be for example a metal, a metal oxide and/or a conductive polymer. The anode 120 may be, for example a metal such as nickel, platinum, vanadium, chromium, copper, zinc, gold, and the like or an alloy thereof; a metal oxide such as zinc oxide, indium oxide, indium tin oxide (ITO), indium zinc oxide (IZO), and the like; a combination of a metal and an oxide such as ZnO and Al or SnO₂ and Sb; a conductive polymer such as poly(3-methylthiophene), poly(3,4-(ethylene-1,2-dioxy)thiophene) (PEDOT), polypyrrole, and polyaniline, but is not limited thereto.

The cathode 110 may be made of a conductor having a small work function to help electron injection, and may be for example a metal, a metal oxide, and/or a conductive polymer. The cathode 110 may be for example a metal such as magnesium, calcium, sodium, potassium, titanium, indium, yttrium, lithium, gadolinium, aluminum silver, tin, lead, cesium, barium, and the like, or an alloy thereof; a multi-layer structure material such as LiF/Al, LiO₂/Al, LiF/Ca, LiF/Al, and BaF₂/Ca, but is not limited thereto.

The organic layer 105 may include a light emitting layer 130, and the light emitting layer 130 may include a composition for an organic optoelectronic device including a Pt dopant represented by Chemical Formula 1, a first host including an electron transport group represented by Chemical Formula 2, and a second host including at least one hole transport group.

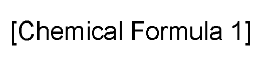

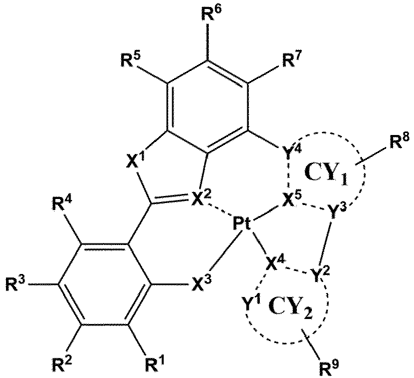

In Chemical Formula 1,
X¹ is selected from O, S, N-[(L¹)_{b1}-(R¹⁰)_{c1}], C(R¹⁰)(R¹¹), Si(R¹⁰)(R¹¹), and C(=O),
R¹⁰ and R¹¹ are each independently linked to each other via a first linking group to form a substituted or unsubstituted C5 to C30 carbocyclic group or a substituted or unsubstituted C1 to C30 heterocyclic group,
L¹ is selected from a substituted or unsubstituted C5 to C30 carbocyclic group and a substituted or unsubstituted C1 to C30 heterocyclic group,
b1 is selected from integers of 0 to 5,
c1 is selected from integers of 0 to 5,
R¹ to R⁹ are each independently selected from hydrogen, deuterium, -F, - Cl, -Br, -I, -SF₅, a hydroxyl group, a cyano group, a nitro group, an amidino group, a hydrazine group, a hydrazone group, a carboxylic acid group, or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C1 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted monovalent non-aromatic condensed polycyclic group, and a substituted or unsubstituted monovalent non-aromatic heterocondensed polycyclic group,
X³ is O or S, and a bond between X³ and Pt is a covalent bond,
X², X⁴, and X⁵ are each independently N or C, one of a bond between X² and Pt, a bond between X⁴ and Pt, and a bond between X⁵ and Pt is a covalent bond, and the other two bonds are is a coordinative bond,
Y¹ to Y⁴ are each independently C or N,
CY₁ is a benzene group or a naphthalene group, and
CY₂ is a pyridine group or an isoquinoline group.

Since the Pt dopant has an orientation close to a planar form, a driving voltage and luminous efficiency of an organic light emitting diode to which the Pt dopant is applied may be improved by mitigating a hole trap phenomenon that reduces the hole transport capability of the light emitting layer if doped into the host.

For example, the Pt dopant may be a phosphorescent dopant, for example, a red, green, or blue phosphorescent dopant, or for example, a green or red phosphorescent dopant.

The Pt dopant is a material that emits light by being mixed in a small amount with a host composition described later, and may be an organometallic compound that emits light by multiple excitation to a triplet state or higher.

The Pt dopant may be, for example, represented by Chemical Formula 1-1. 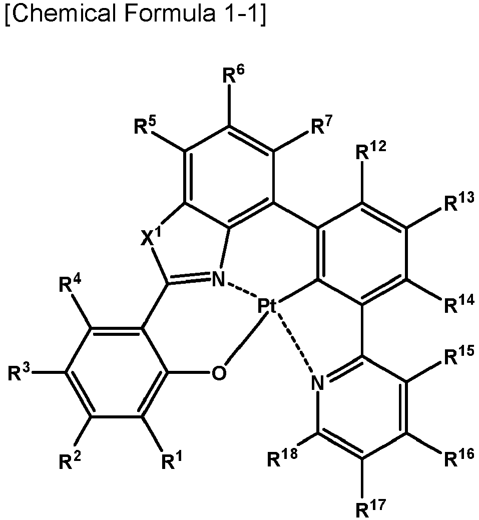 In Chemical Formula 1-1,
X¹ is N-[(L¹)_{b1}-(R¹⁰)_{c1}],
definitions of L¹, b1, c1, R¹⁰, and R¹ to R⁷ are the same as defined in claim 1,
R¹² to R¹⁸ are the same as the definitions of R¹ to R⁷ described above,
at least one of R¹ to R⁷, R¹⁰, and R¹² to R¹⁸ is an iso-propyl group, and
at least one of R¹ to R⁷, R¹⁰, and R¹² to R¹⁸ is a deuterium-substituted C1 to C5 alkyl group.

According to an embodiment, the Pt dopant may be a known Pt dopant, and for example, may be selected from Pt dopants described in Korean Patent Publication No. 10-2020-0026093.

As a specific example, it may be selected from the compounds listed in Group 1.

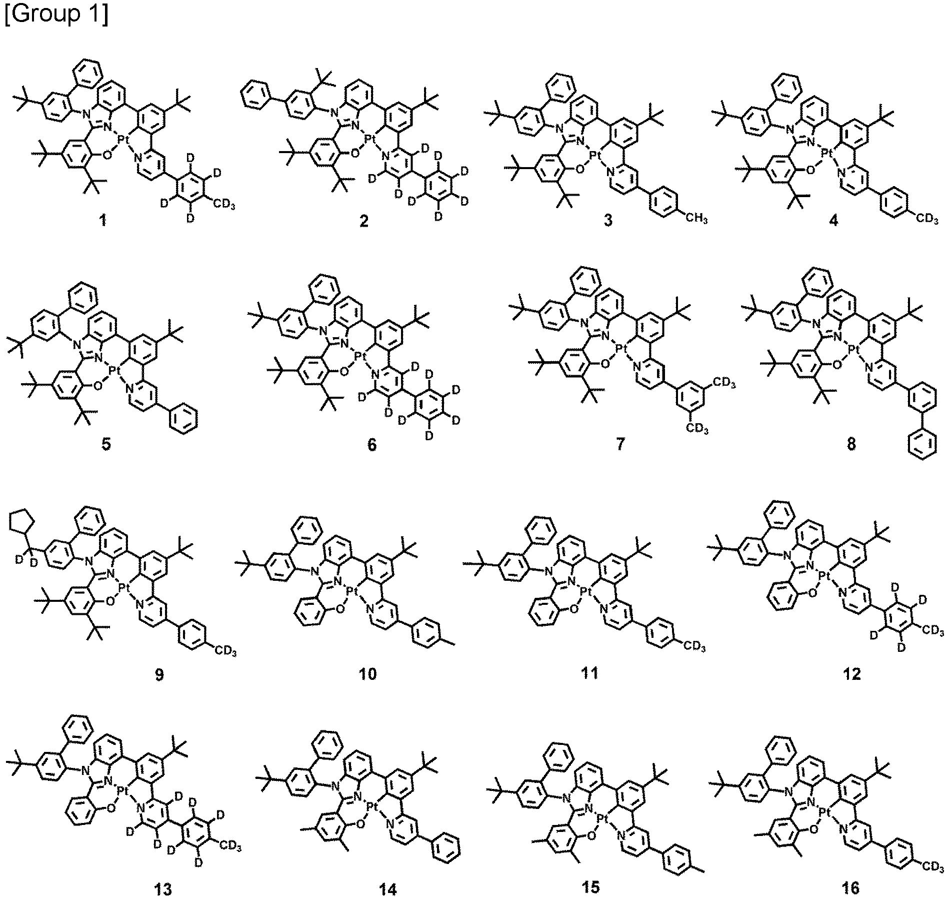

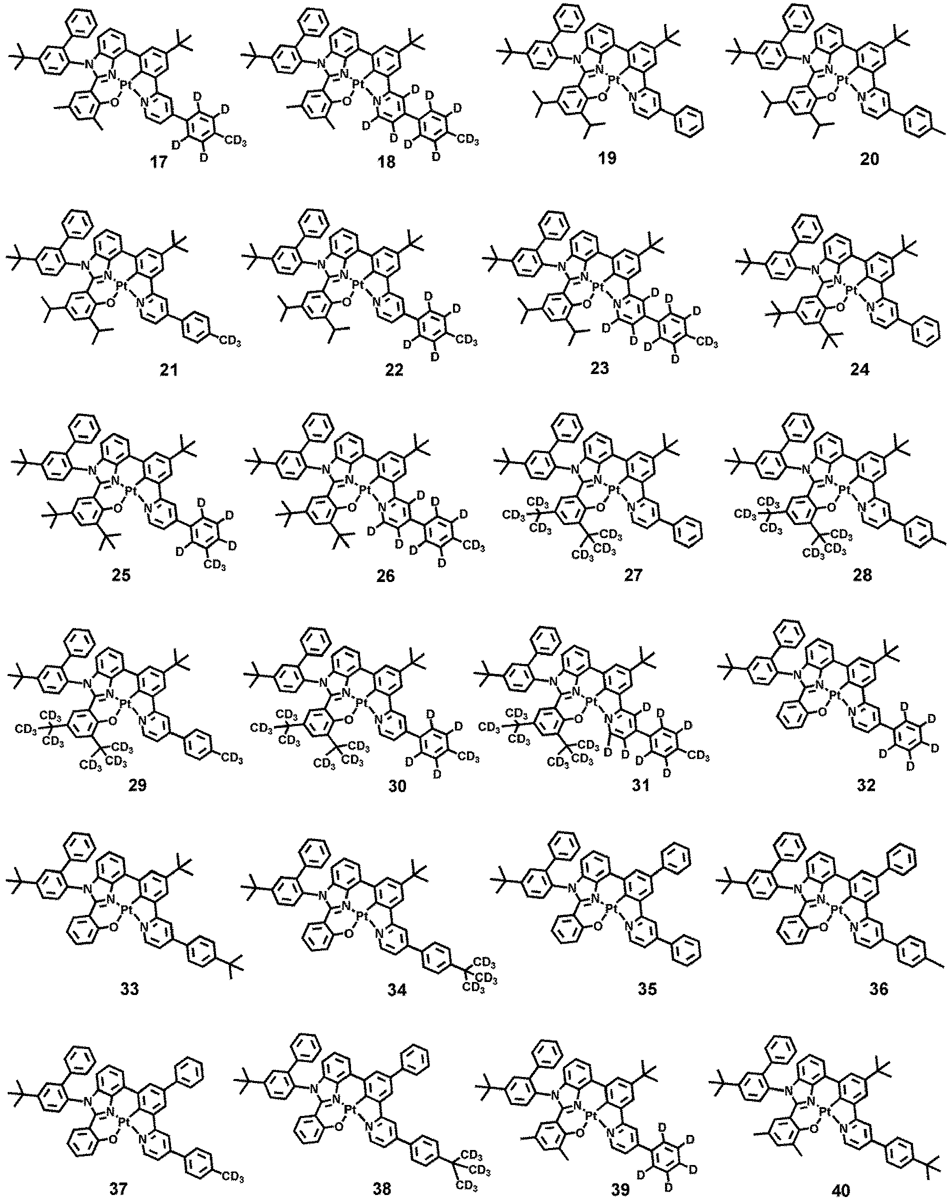

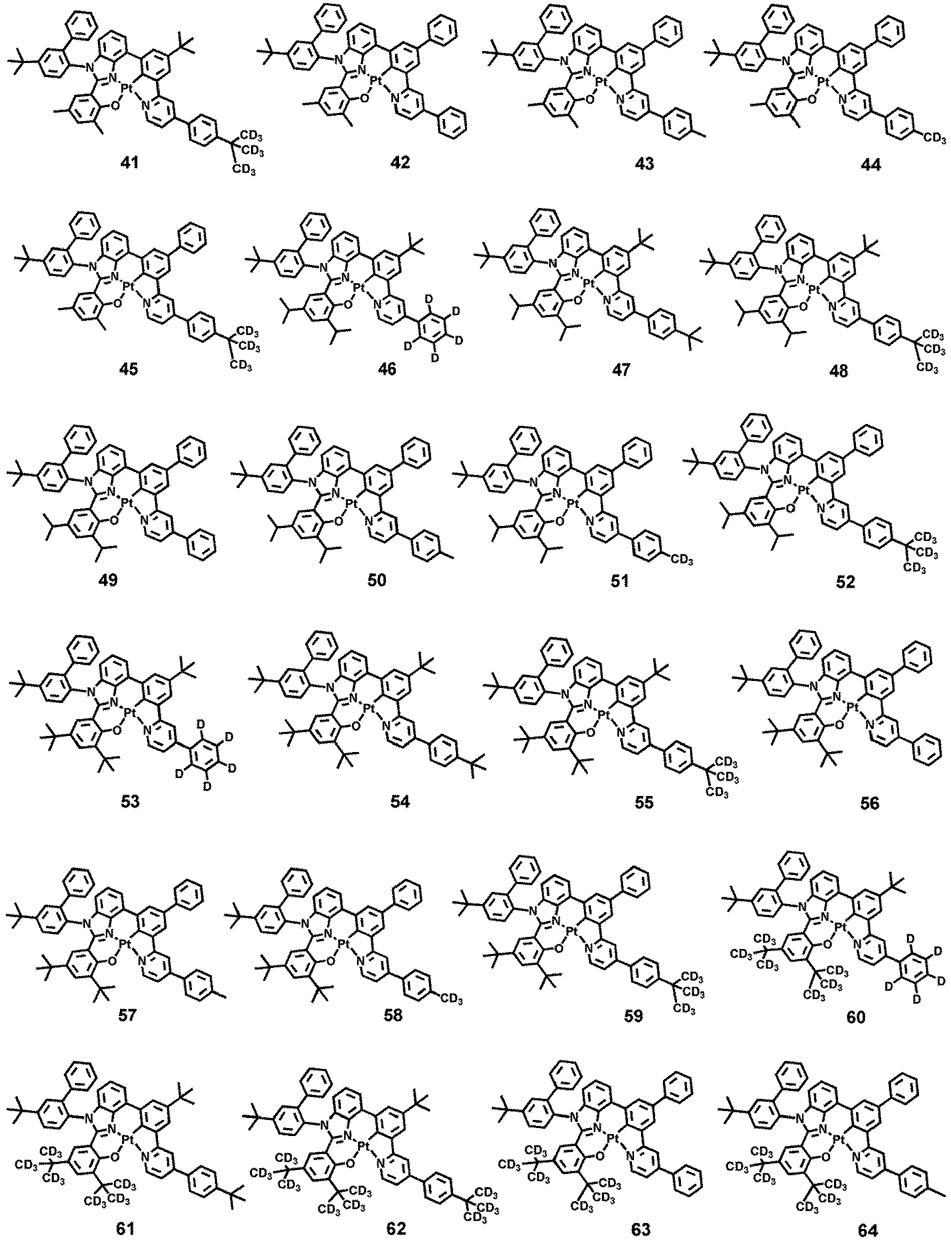

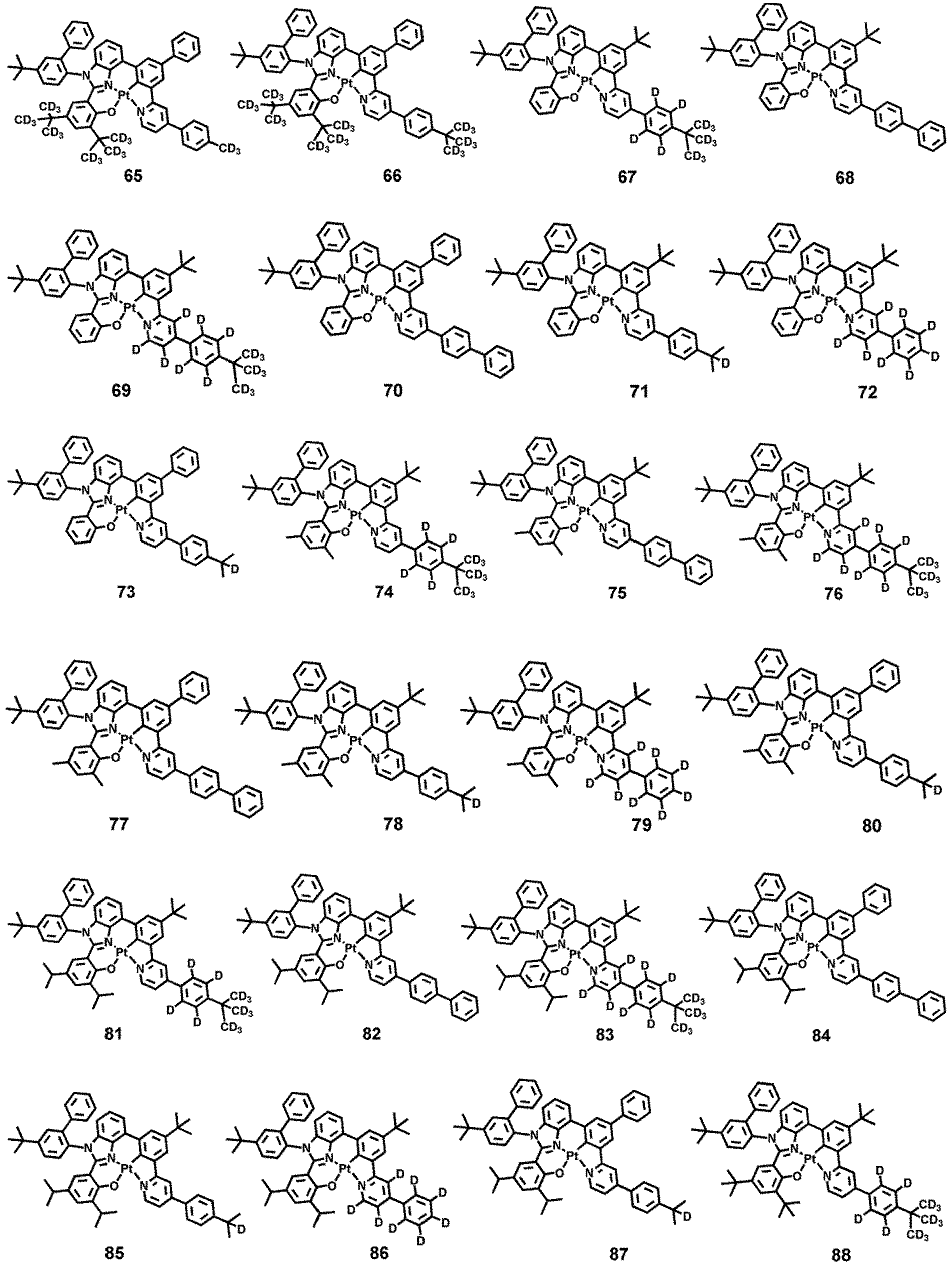

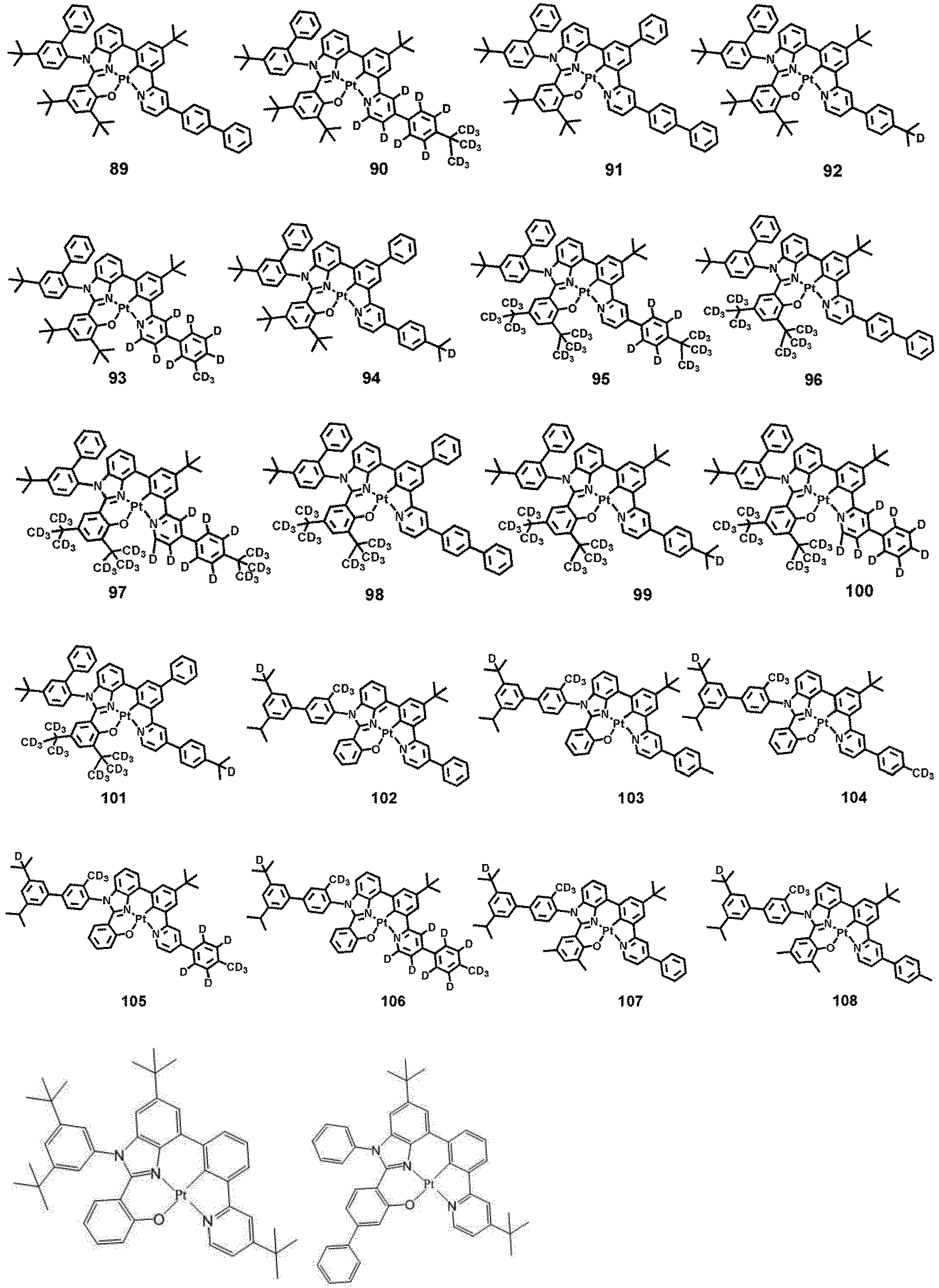

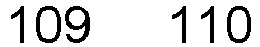

The light emitting layer may include a host composition together with the aforementioned Pt dopant, wherein the host composition includes a first host including an electron transport group represented by Chemical Formula 2, and a second host including at least one hole transport group.

In particular, the host composition is a combination of materials in which each host, that is, the first host and the second host have an energy level of a specific value, and may be specified as an advantageous combination for exciton formation.

For example, a HOMO energy level of the second host may be higher than a HOMO energy level of the first host, and a difference between a LUMO energy level of the first host and the HOMO energy level of the second host may be greater than 2.505 eV.

Specifically, the difference between the LUMO energy level of the first host and the HOMO energy level of the second host may be greater than or equal to 2.530 eV.

When the difference between the LUMO energy level of the first host and the HOMO energy level of the second host exceeds at least 2.505 eV, energy can be effectively transferred to the dopant, and thus the efficiency life-span may be further improved.

The electron transport group included in the first host may be represented by Chemical Formula 2.

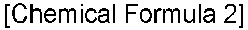

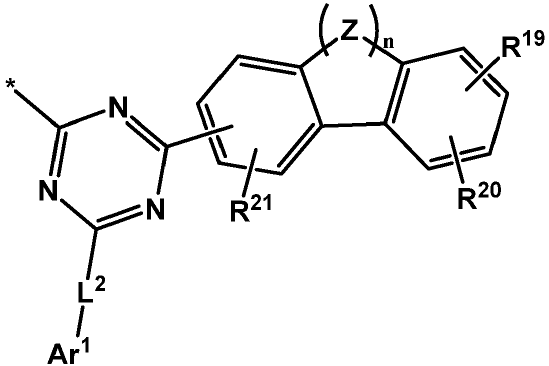

In Chemical Formula 2,
n is an integer of 0 or 1,
when n is 1, Z is O, S, CR^{a}R^{b}, or NR^{c},
R^{a}, R^{b}, R^{c}, and R¹⁹ to R²¹ are each independently hydrogen, deuterium, a cyano group, a halogen, a substituted or unsubstituted C1 to C30 alkyl group, or a substituted or unsubstituted C6 to C30 aryl group,
L² is a single bond, a substituted or unsubstituted C6 to C30 arylene group, or a substituted or unsubstituted C2 to C30 heteroarylene group,
Ar¹ is a substituted or unsubstituted C6 to C30 aryl group or a substituted or unsubstituted C2 to C30 heteroaryl group, and
* is a linking point.

That is, a triazine and a substituted or unsubstituted biphenyl group, a substituted or unsubstituted carbazolyl group, a substituted or unsubstituted dibenzofuranyl group, or a substituted or unsubstituted dibenzothiophenyl group linked thereto may be included as an electron transport group.

The first host may be selected without limitation within a range that satisfies the aforementioned energy level, but may be represented by any one of the chemical formulas listed in Group I .

### [Group I]

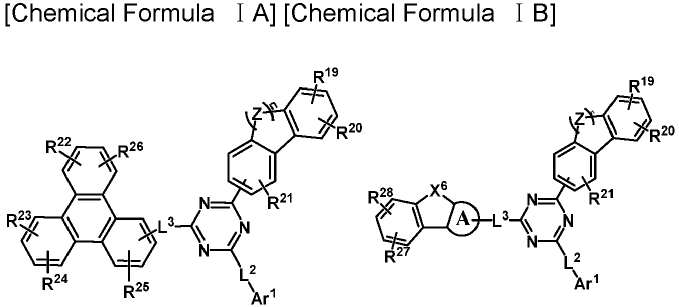

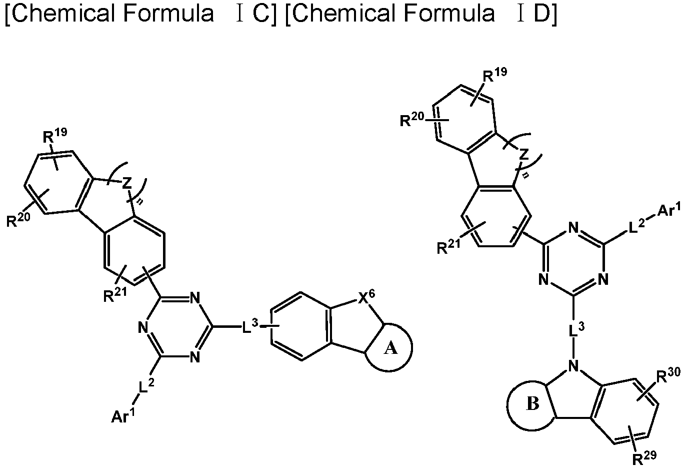

In Chemical Formula I A to Chemical Formula I D,
Z, n, Ar¹, L², L³, and R¹⁹ to R²¹ are each as described above,
X⁶ is O, S, CR^{d}R^{e}, or NR^{f},
R^{d}, R^{e}, R^{f}, and R²² to R³⁰ are each independently hydrogen, deuterium, a cyano group, a halogen, a substituted or unsubstituted C1 to C30 alkyl group, or a substituted or unsubstituted C6 to C30 aryl group,
ring A is any one selected from Group A, and
ring B is any one selected from Group B, 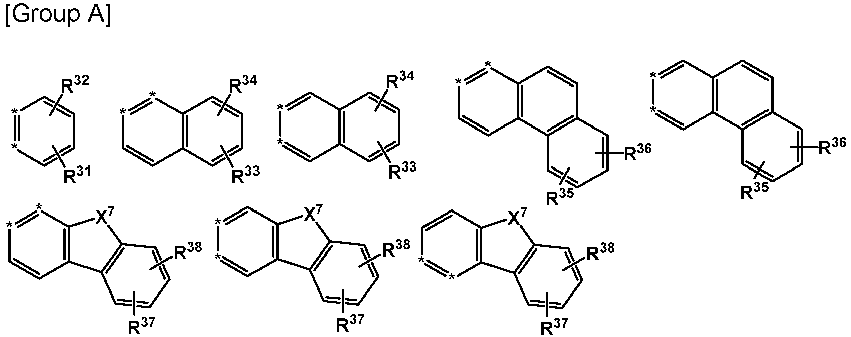 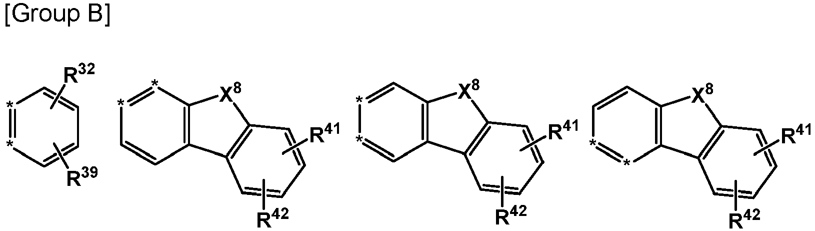
wherein, in Group A and Group B,
X⁷ and X⁸ are each independently O, S, CR^{g}R^{h}, or NRⁱ,
R^{g}, R^{h}, Rⁱ, and R³¹ to R⁴² are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
* is a linking point.

Specifically, L² and L³ may each independently be a single bond or a substituted or unsubstituted C6 to C12 arylene group.

More specifically, L² and L³ may each independently be a single bond, a substituted or unsubstituted phenylene group, or a substituted or unsubstituted biphenylene group.

Specifically, Ar¹ may be a substituted or unsubstituted C6 to C12 aryl group.

More specifically, Ar¹ may be a substituted or unsubstituted phenyl group, or a substituted or unsubstituted biphenyl group.

Specifically, the n may be 0.

Specifically, the n may be 1, wherein Z may be O, S, or NR^{c}, and R^{c} may be a substituted or unsubstituted phenyl group, or a substituted or unsubstituted biphenyl group.

Specifically, X⁶ may be O or S.

Specifically, R¹⁹ to R²¹ may each independently be hydrogen, deuterium, a cyano group, halogen, or a substituted or unsubstituted C6 to C12 aryl group.

More specifically, R¹⁹ to R²¹ may each independently be hydrogen, deuterium, or a substituted or unsubstituted phenyl group.

Specifically, R²² to R⁴² may each independently be hydrogen, deuterium, a cyano group, halogen, a substituted or unsubstituted C6 to C12 aryl group, or a substituted or unsubstituted C2 to C20 heterocyclic group.

More specifically, R²² to R⁴² may each independently be hydrogen, deuterium, a substituted or unsubstituted phenyl group, a substituted or unsubstituted biphenyl group, a substituted or unsubstituted carbazolyl group, a substituted or unsubstituted dibenzofuranyl group, or a substituted or unsubstituted dibenzothiophenyl group.

Specifically, X⁷ and X⁸ may each independently be O, S, or NRⁱ, wherein Rⁱ may be a substituted or unsubstituted phenyl group, a substituted or unsubstituted biphenyl group, or a substituted or unsubstituted terphenyl group.

For example, the first host may be represented by any one of above Chemical Formula I B to Chemical Formula I D.

As a specific example, the first host may be represented by Chemical Formula I D.

Meanwhile, according to an example of the present invention, the hole transport group may be selected from a substituted or unsubstituted carbazolyl group and a substituted or unsubstituted fused carbazolyl group.

The second host may be selected without limitation within a range that satisfies the aforementioned energy level, but may be represented by any one of the chemical formulas listed in Group II.

### [Group II]

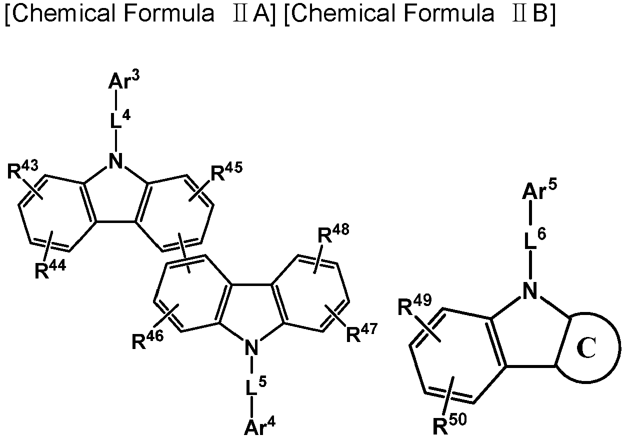

In Chemical Formula IIA and Chemical Formula IIB,
R⁴³ to R⁵⁰ are each independently hydrogen, deuterium, a cyano group, a halogen, a substituted or unsubstituted C1 to C30 alkyl group, or a substituted or unsubstituted C6 to C30 aryl group,
L⁴ to L⁶ are each independently a single bond, a substituted or unsubstituted C6 to C30 arylene group or a substituted or unsubstituted C2 to C30 heteroarylene group,
Ar³ to Ar⁵ are each independently a substituted or unsubstituted C6 to C30 aryl group or a substituted or unsubstituted C2 to C30 heteroaryl group, and
ring C is any one selected from Group C 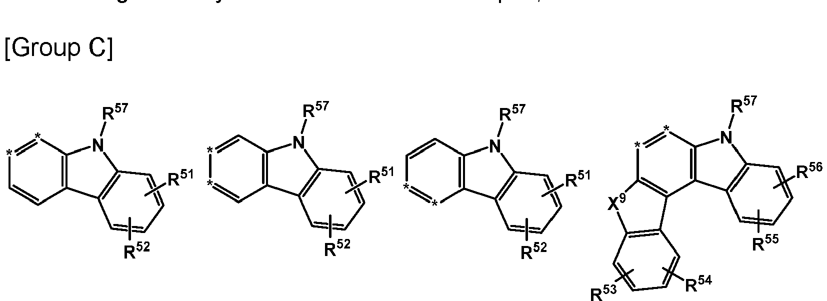
wherein, in Group C,
X⁹ is O, S, or NRⁱ,
R^{j} and R⁵¹ to R⁵⁶ are each independently hydrogen, deuterium, a cyano group, a halogen, a substituted or unsubstituted C1 to C30 alkyl group, or a substituted or unsubstituted C6 to C30 aryl group,
R⁵⁷ is a substituted or unsubstituted C6 to C30 aryl group or a substituted or unsubstituted C2 to C30 heteroaryl group, and
* is a linking point.

For example, Chemical Formula IIB may be represented by any one of Chemical Formula II B-a, Chemical Formula II B-b, Chemical Formula II B-c, Chemical Formula IIB-d, Chemical Formula IIB-e and Chemical Formula IIB-f.

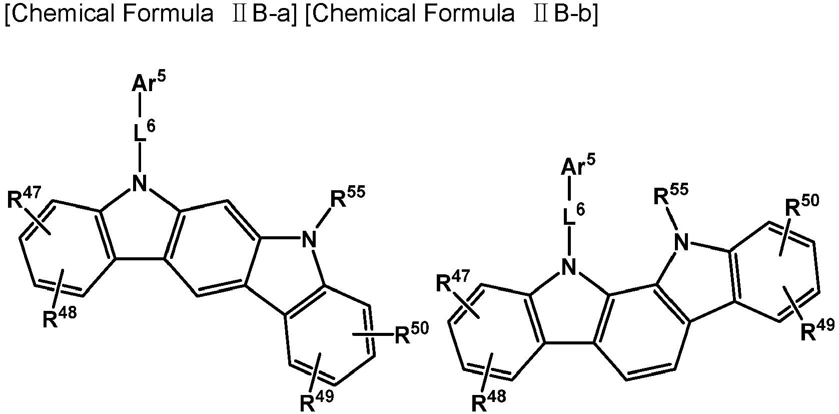

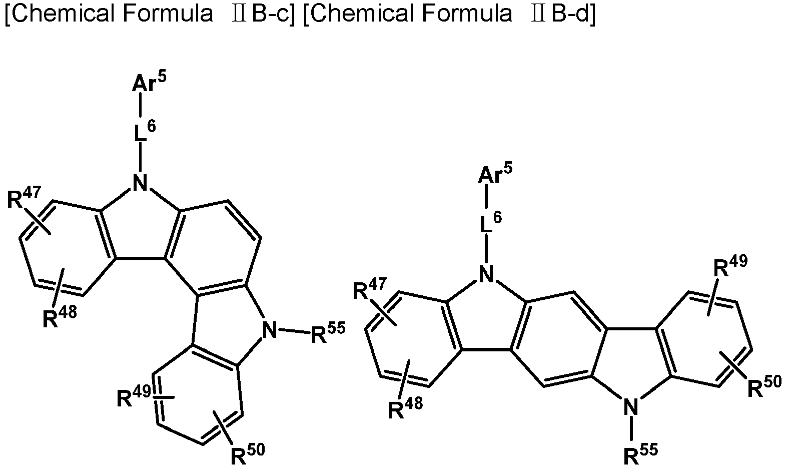

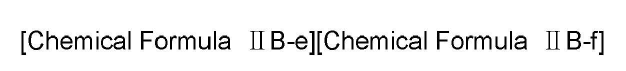

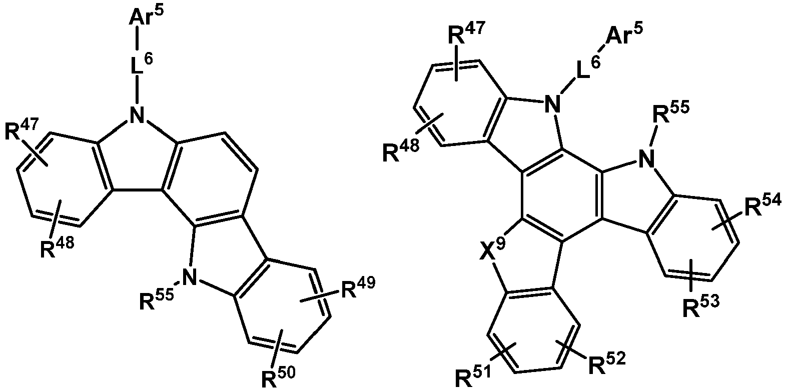

In Chemical Formula II B-a, Chemical Formula II B-b, Chemical Formula II B-c, Chemical Formula II B-d, Chemical Formula II B-e, and Chemical Formula II B-f,
definitions of Ar⁵, L⁶, X⁹, and R⁴⁷ to R⁵⁵ are the same as described above.

Specifically, Ar³ to Ar⁵ may each independently be a substituted or unsubstituted C6 to C12 aryl group.

More specifically, Ar³ to Ar⁵ may each independently be a substituted or unsubstituted phenyl group or a substituted or unsubstituted biphenyl group.

Specifically, L⁴ to L⁶ may each independently be a single bond, a substituted or unsubstituted C6 to C12 arylene group.

More specifically, L⁴ to L⁶ may each independently be a single bond, a substituted or unsubstituted phenylene group or a substituted or unsubstituted biphenylene group.

Specifically, R⁴³ to R⁵⁶ may each independently be hydrogen, deuterium, a cyano group, halogen, a substituted or unsubstituted C1 to C10 alkyl group, or a substituted or unsubstituted C6 to C12 aryl group.

More specifically, R⁴³ to R⁵⁶ may each independently be hydrogen, deuterium, a substituted or unsubstituted phenyl group, or a substituted or unsubstituted biphenyl group.

Specifically, R⁵⁷ may be a substituted or unsubstituted C6 to C20 aryl group.

More specifically, R⁵⁷ may be a substituted or unsubstituted phenyl group, a substituted or unsubstituted biphenyl group, or a substituted or unsubstituted terphenyl group.

As a specific example, the second host may be represented by Chemical Formula IIA or above Chemical Formula II B-c.

The first host and the second host may be for example included in a weight ratio of 1:99 to 99:1. Within the range, a desirable weight ratio may be adjusted using an electron transport capability of the first compound and a hole transport capability of the second compound to realize bipolar characteristics and thus to improve efficiency and life-span. Within this range, they may be included, for example, in a weight ratio of about 90:10 to 10:90, about 80:20 to 10:90, about 70:30 to 10:90, about 60:40 to 10:90, or about 60:40 to 20:80. For example, they may be included in a weight ratio of 60:40 to 30:70, for example, 40:60.

In an embodiment of the present invention, the first host and the second host may each be included as a host of the light emitting layer, for example, a phosphorescent host.

In the most specific example of the present invention, the first host may be one selected from Group 2, the second host may be one selected from Group 3, a HOMO energy level of the second host selected from Group 3 may be higher than a HOMO energy level of the first host selected from Group 2, and a difference between a LUMO energy level of the first host selected from Group 2 and the HOMO energy level of the second host selected from Group 3 may be greater than 2.505 eV.

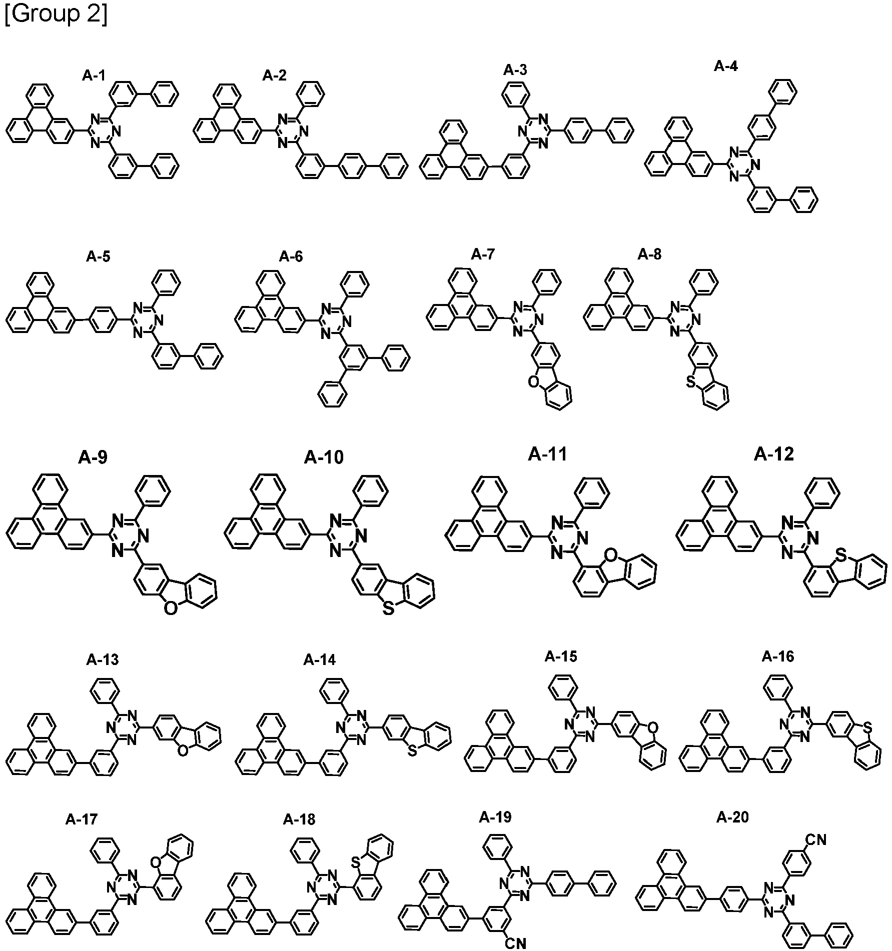

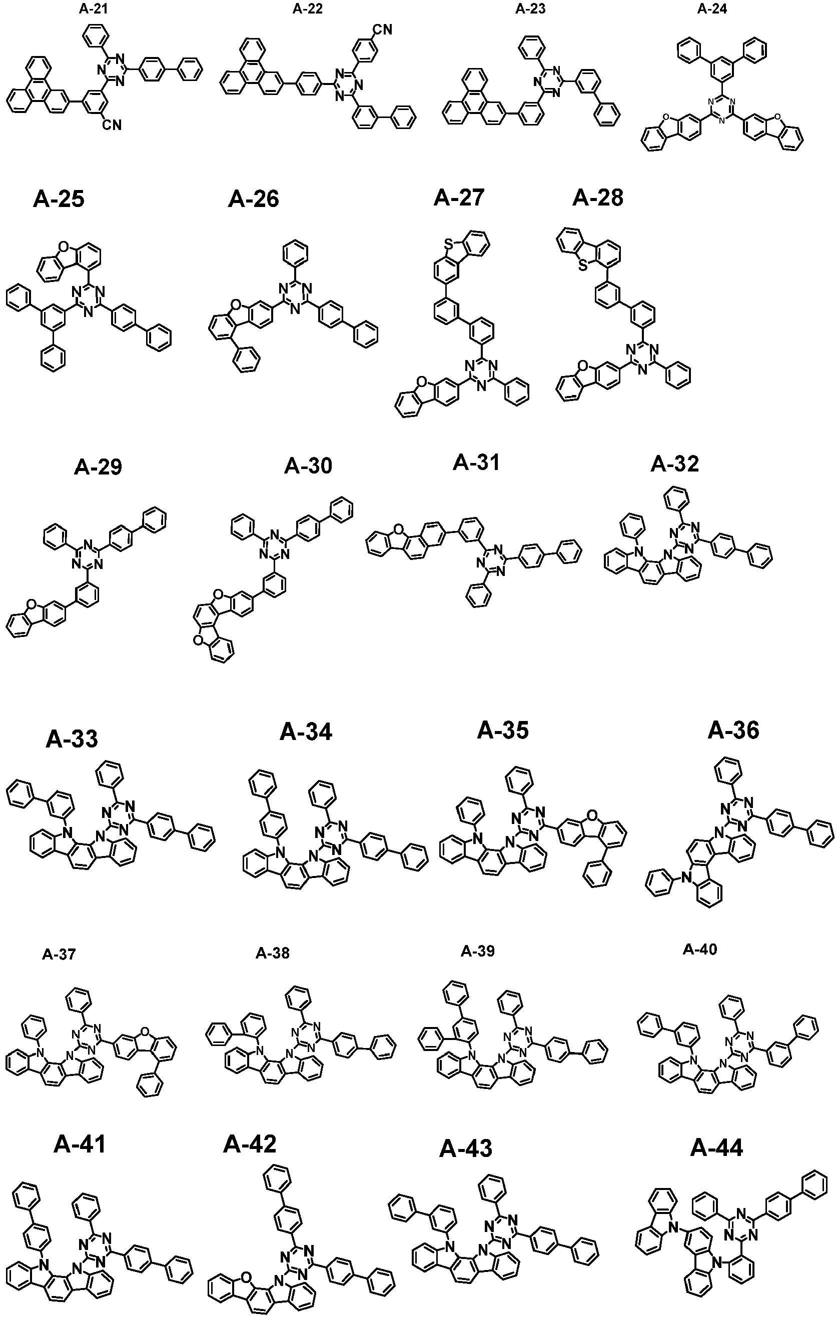

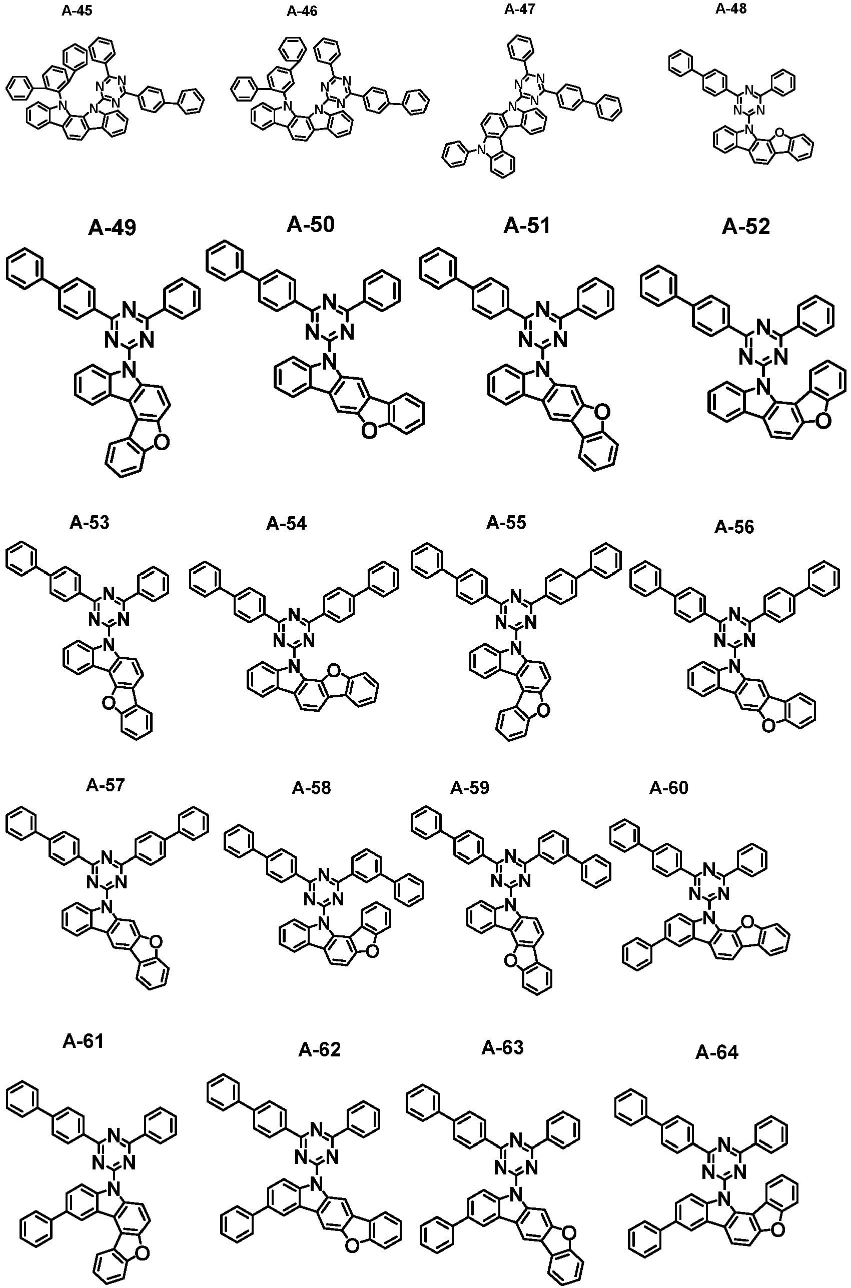

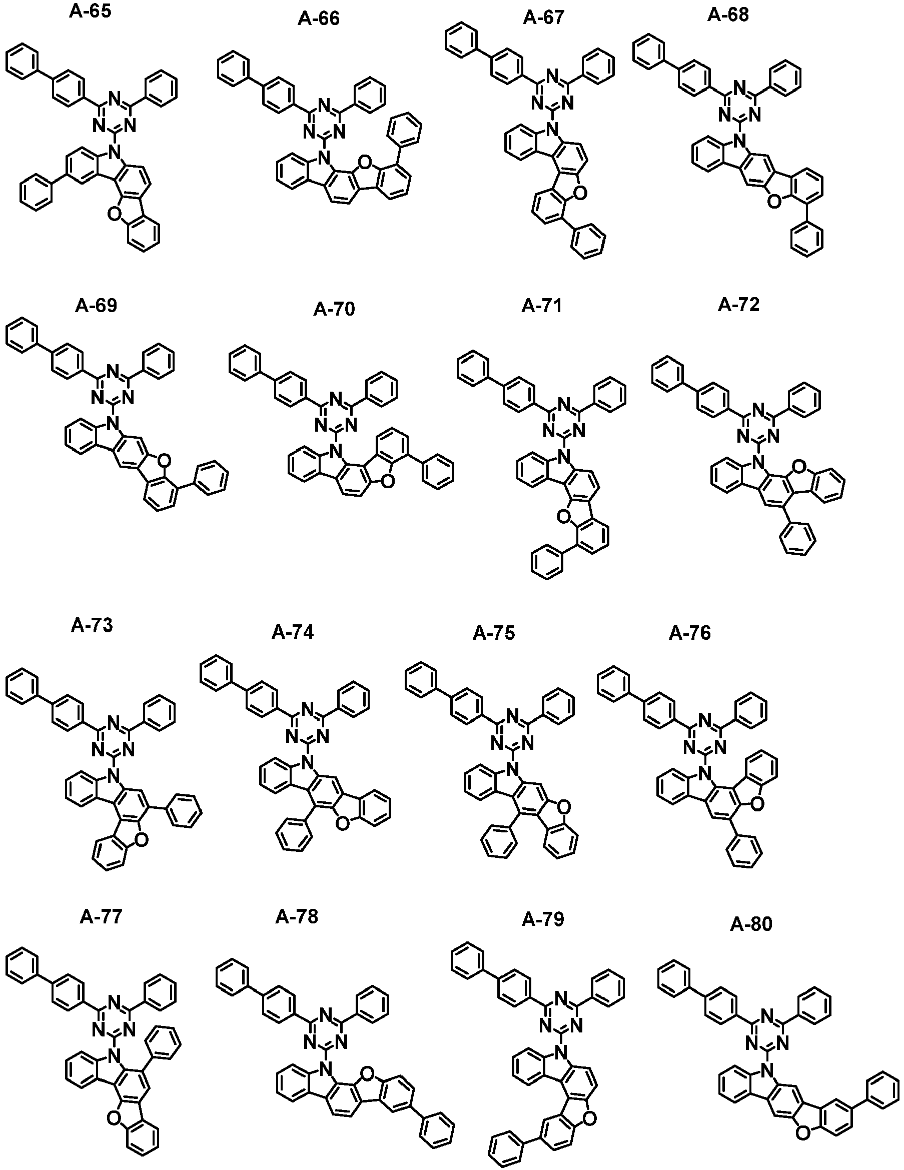

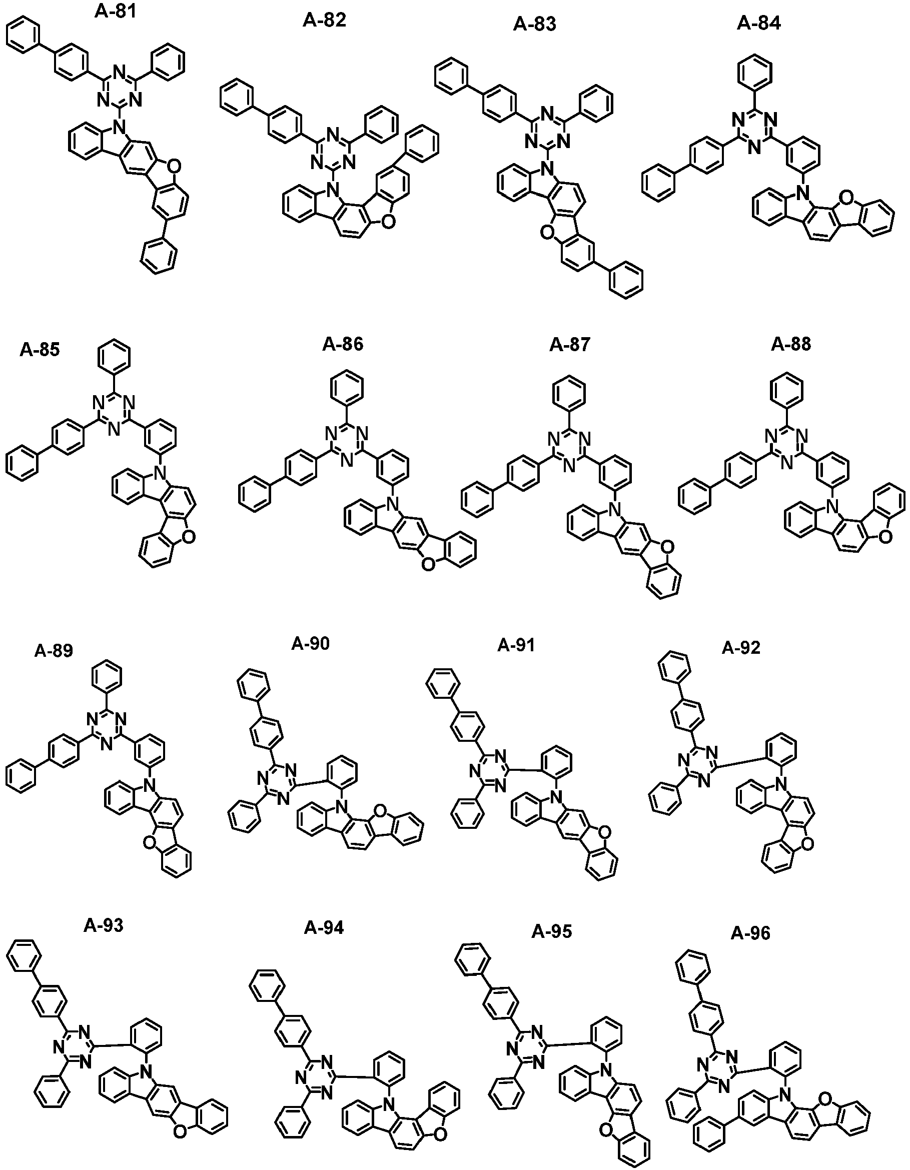

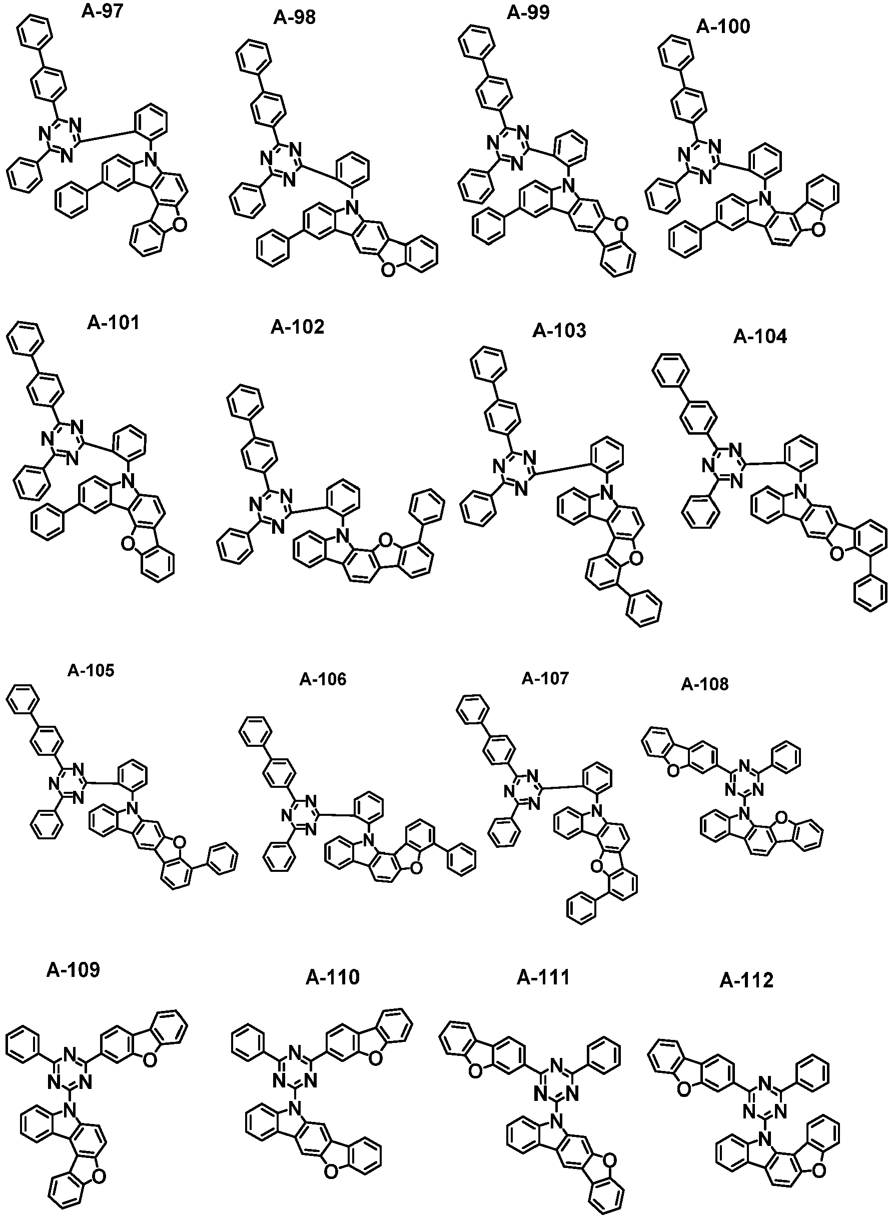

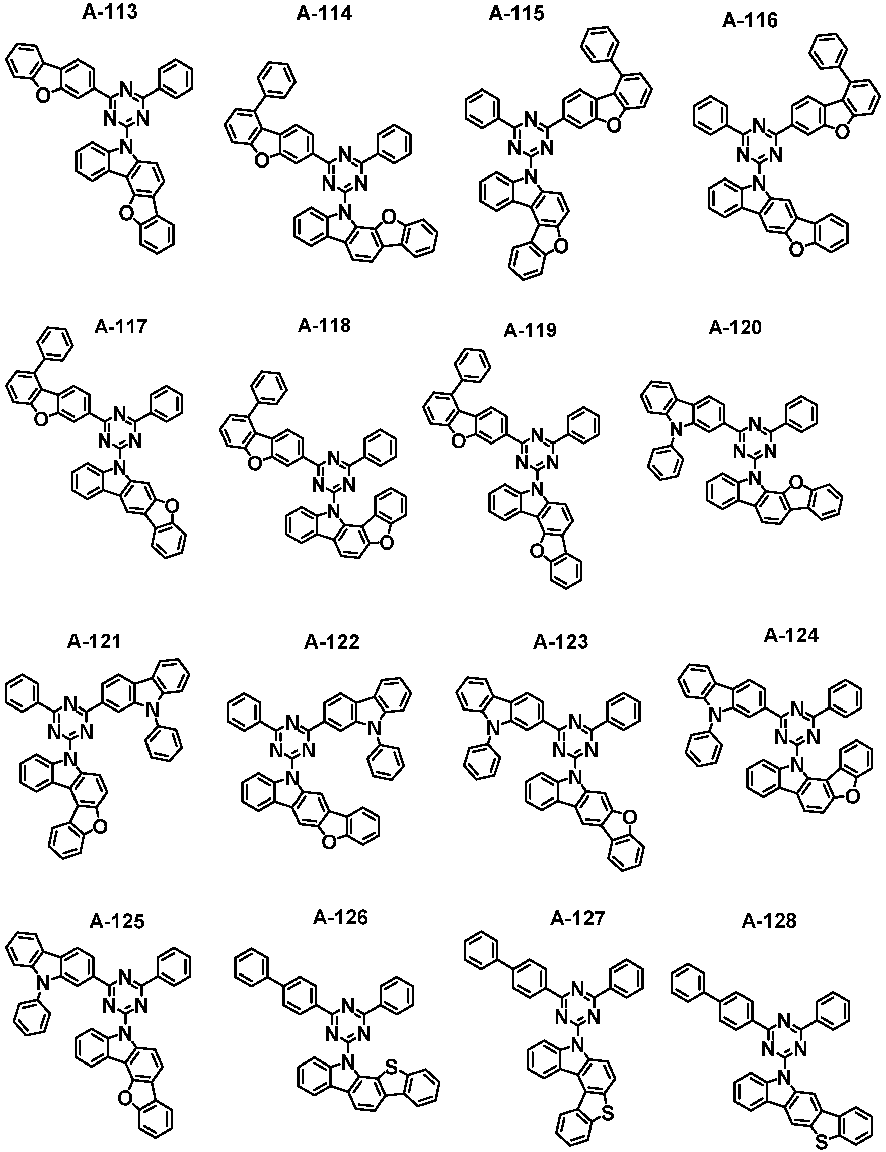

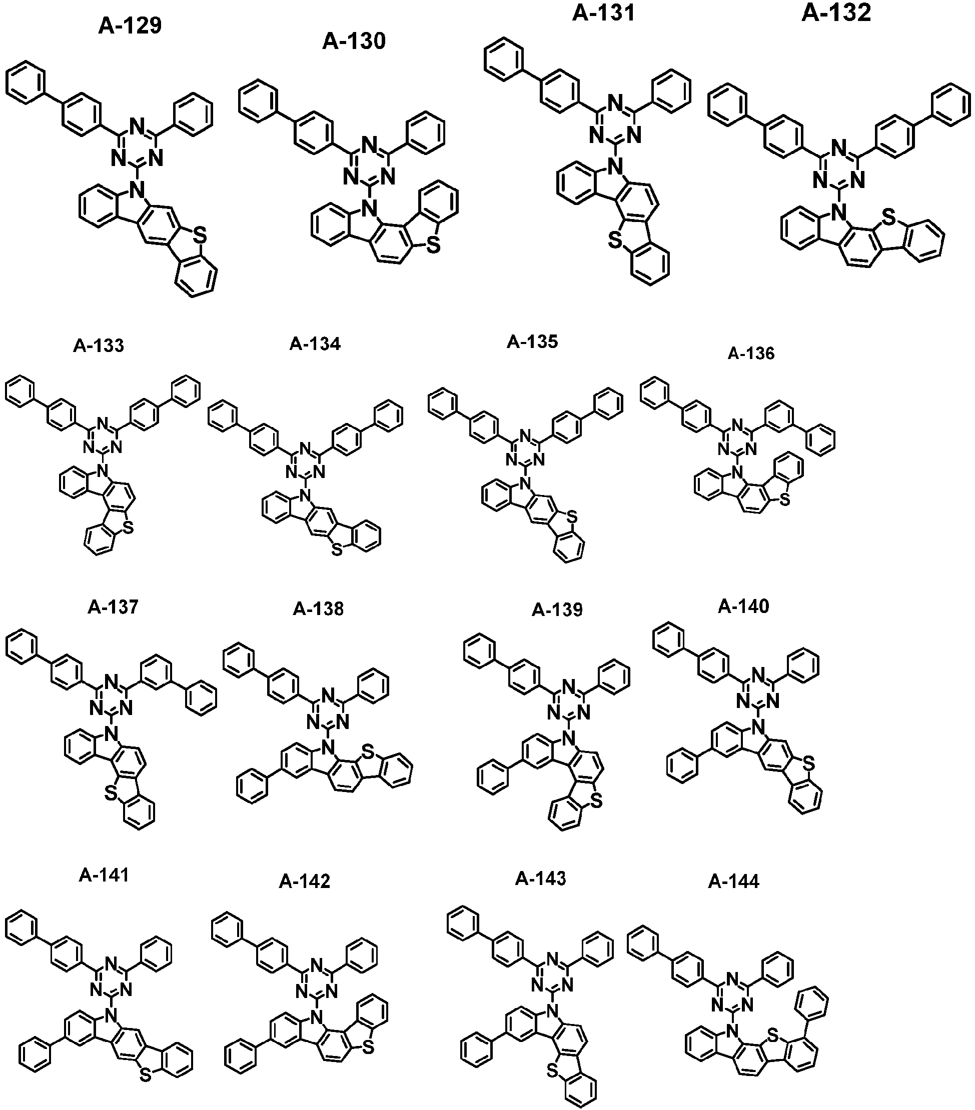

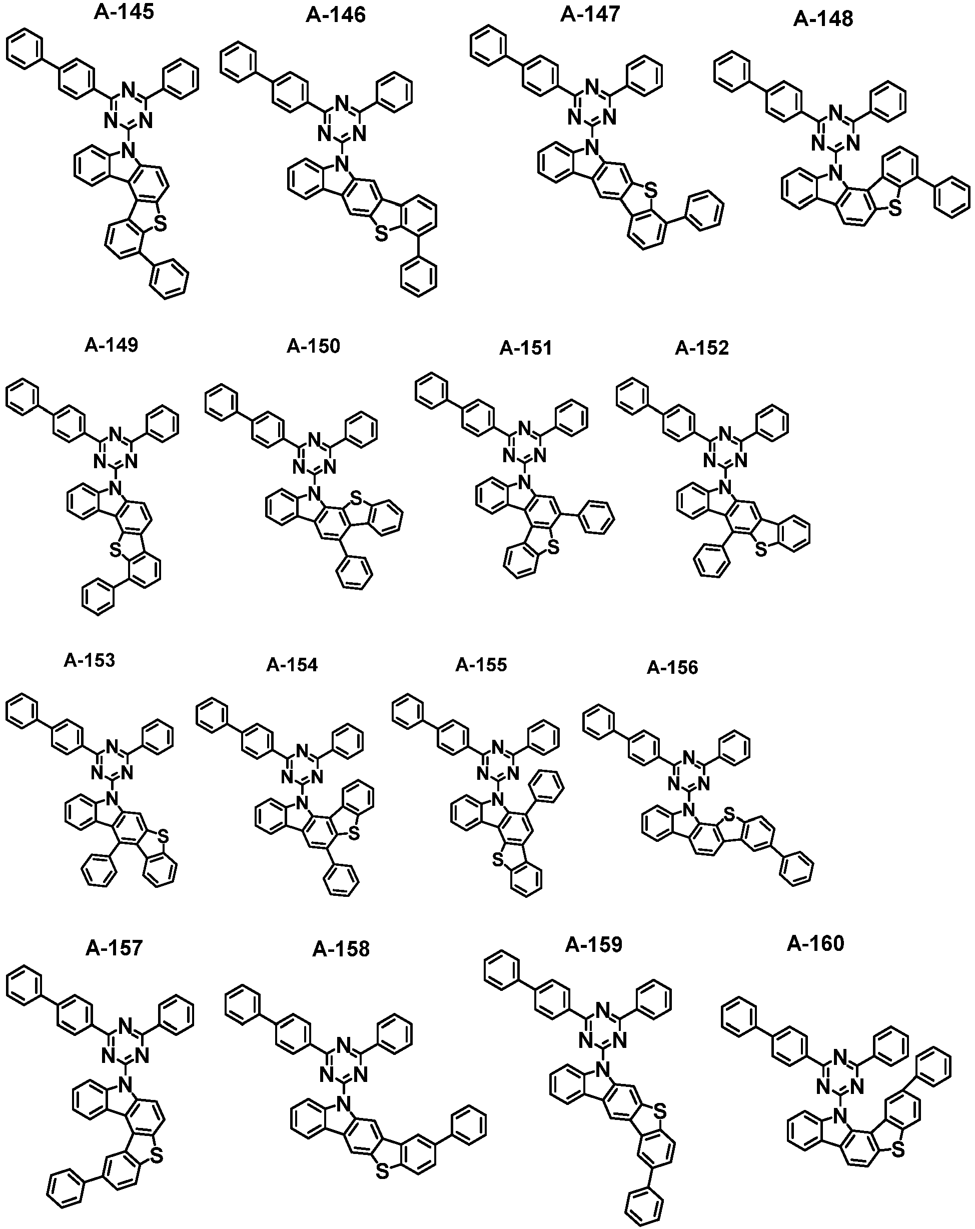

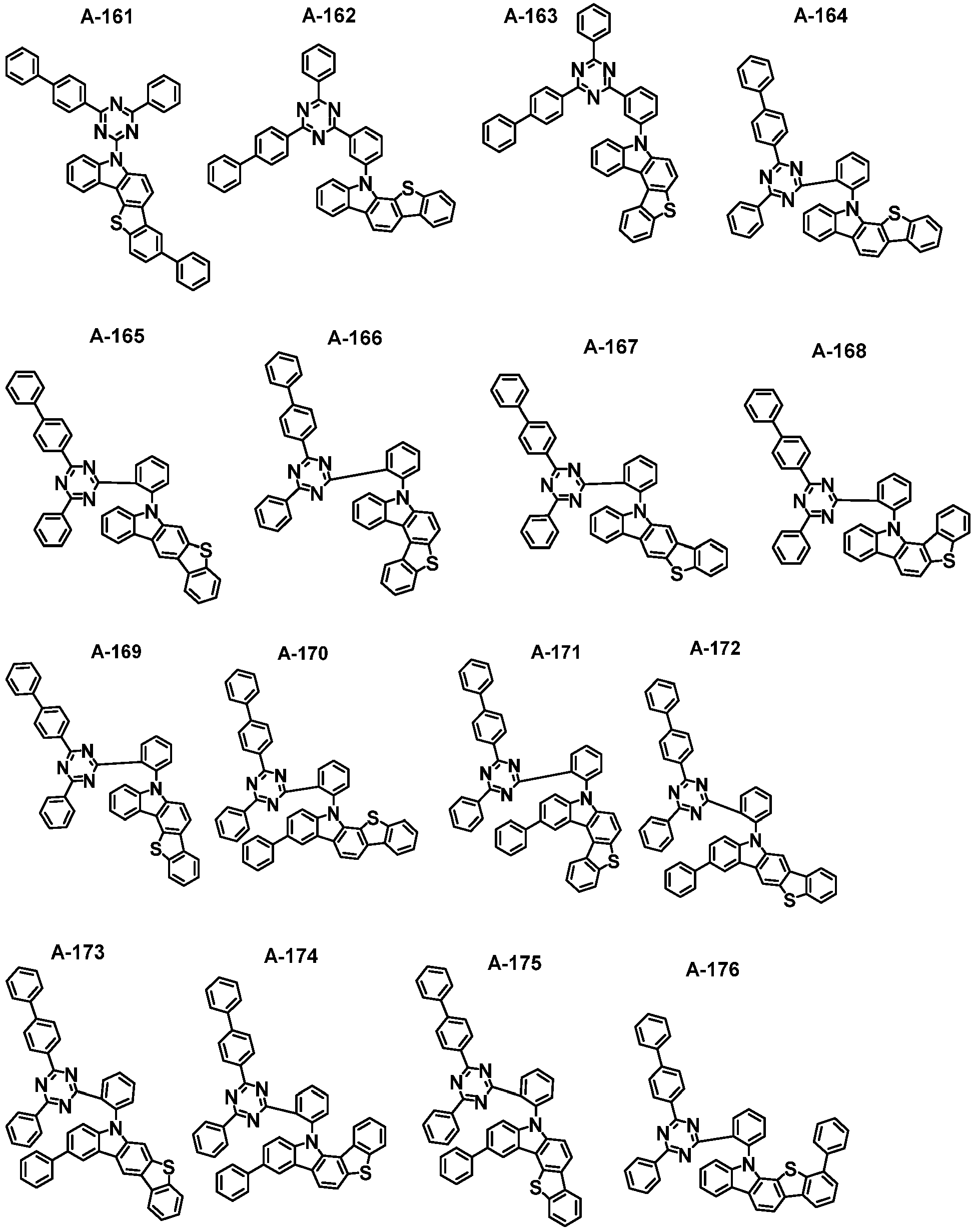

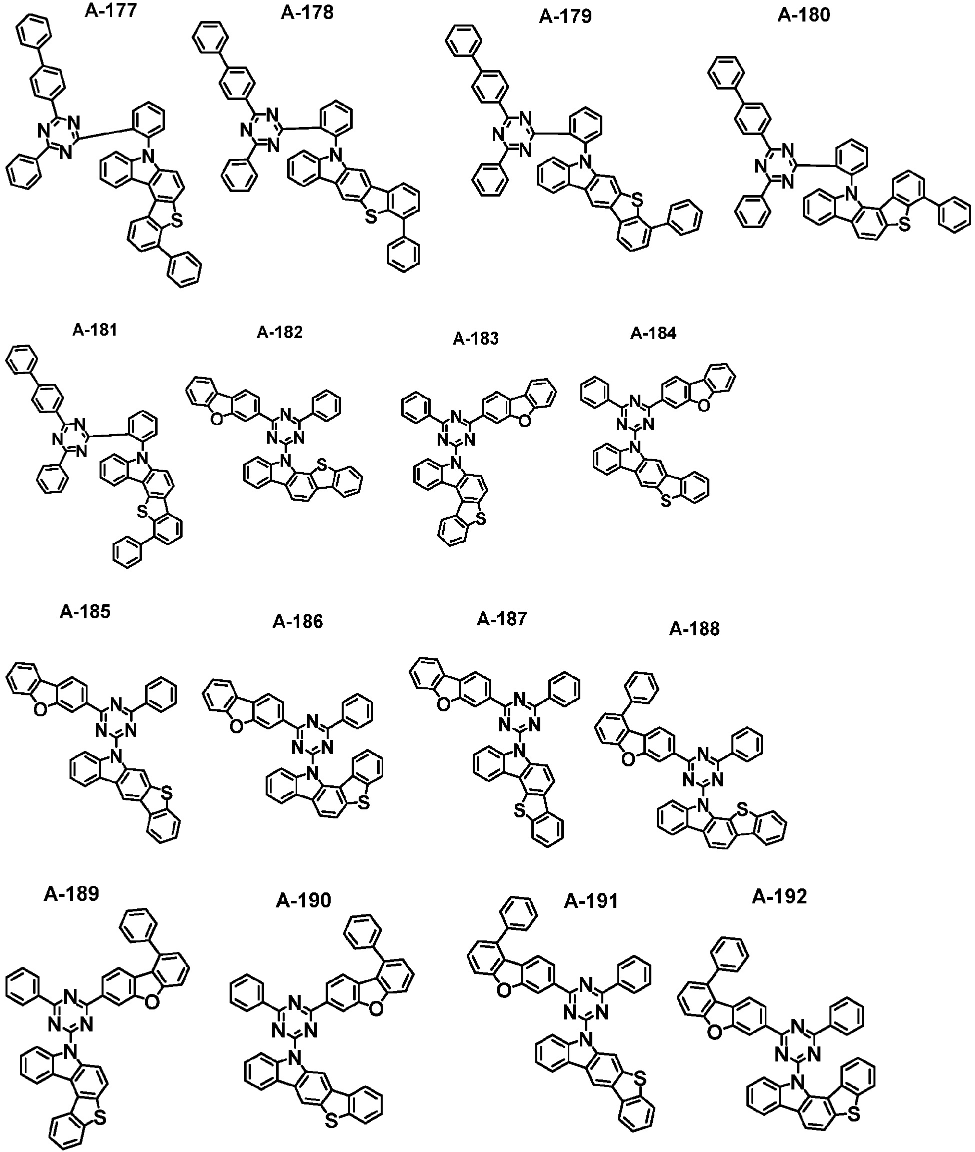

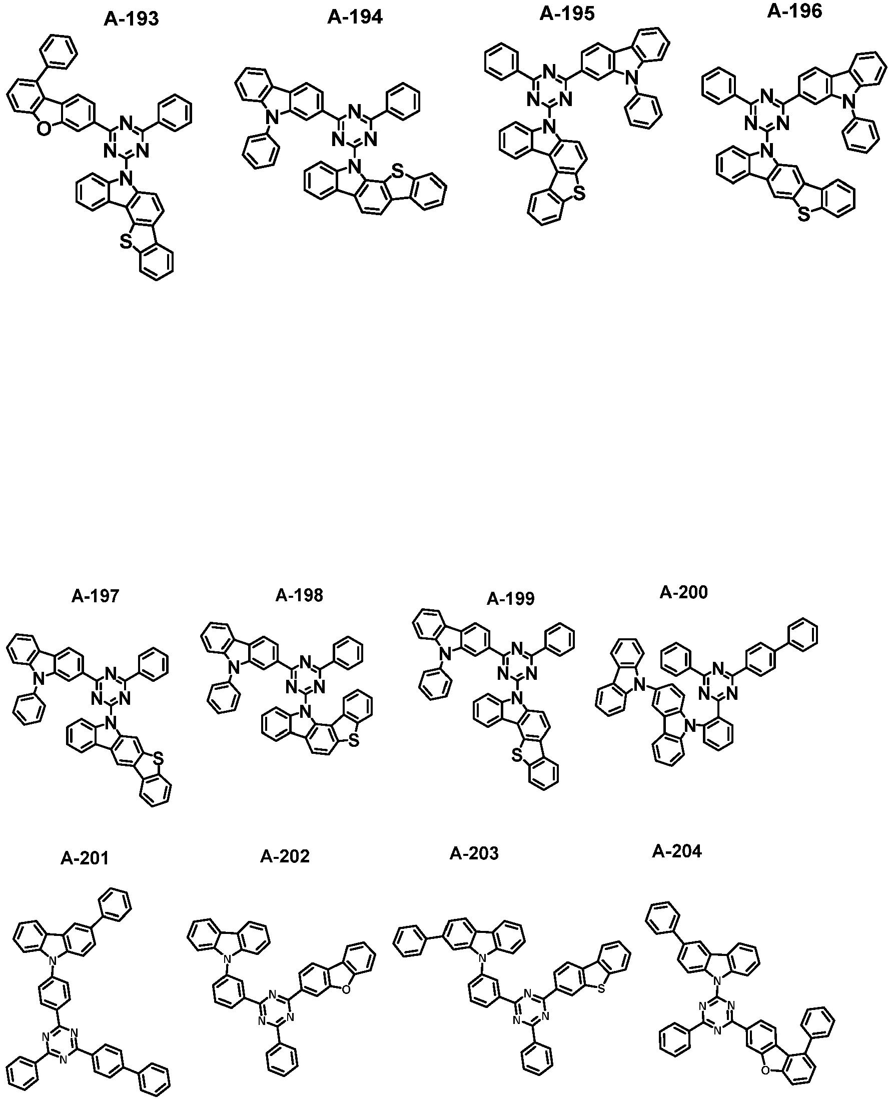

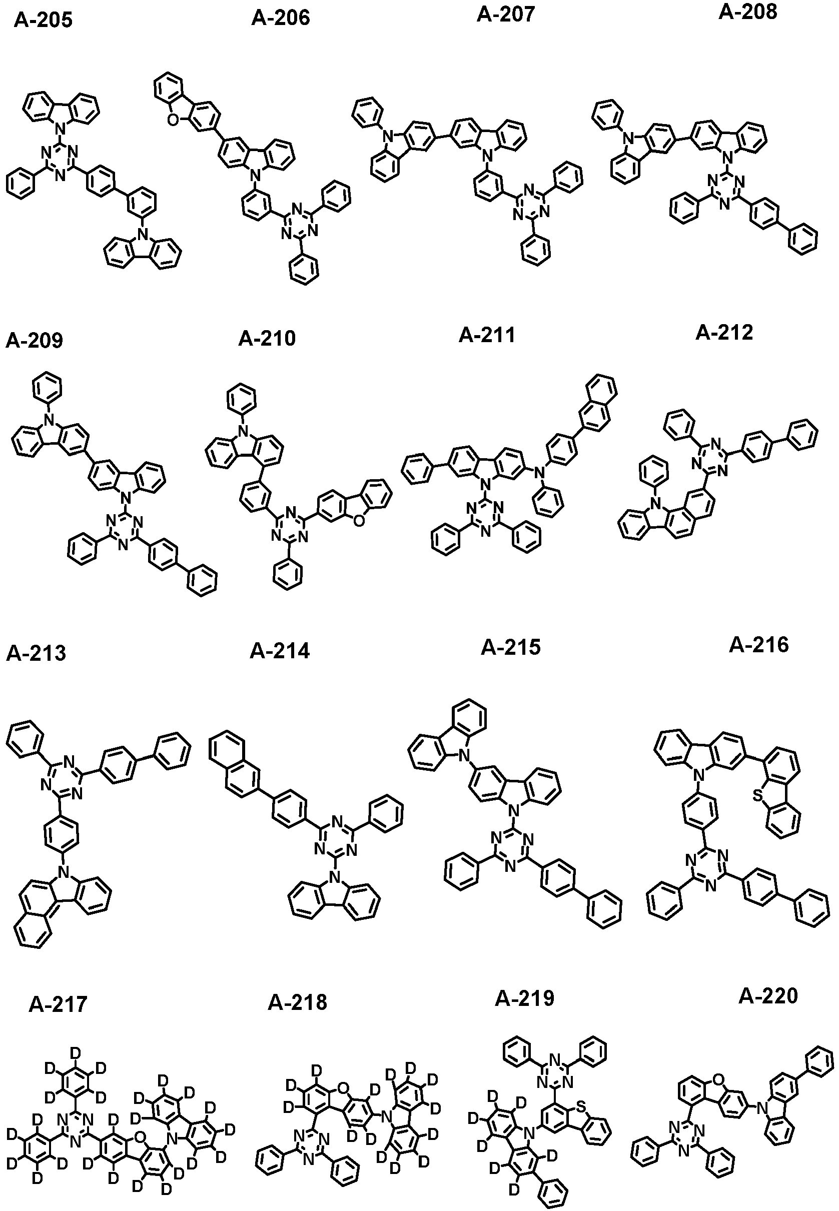

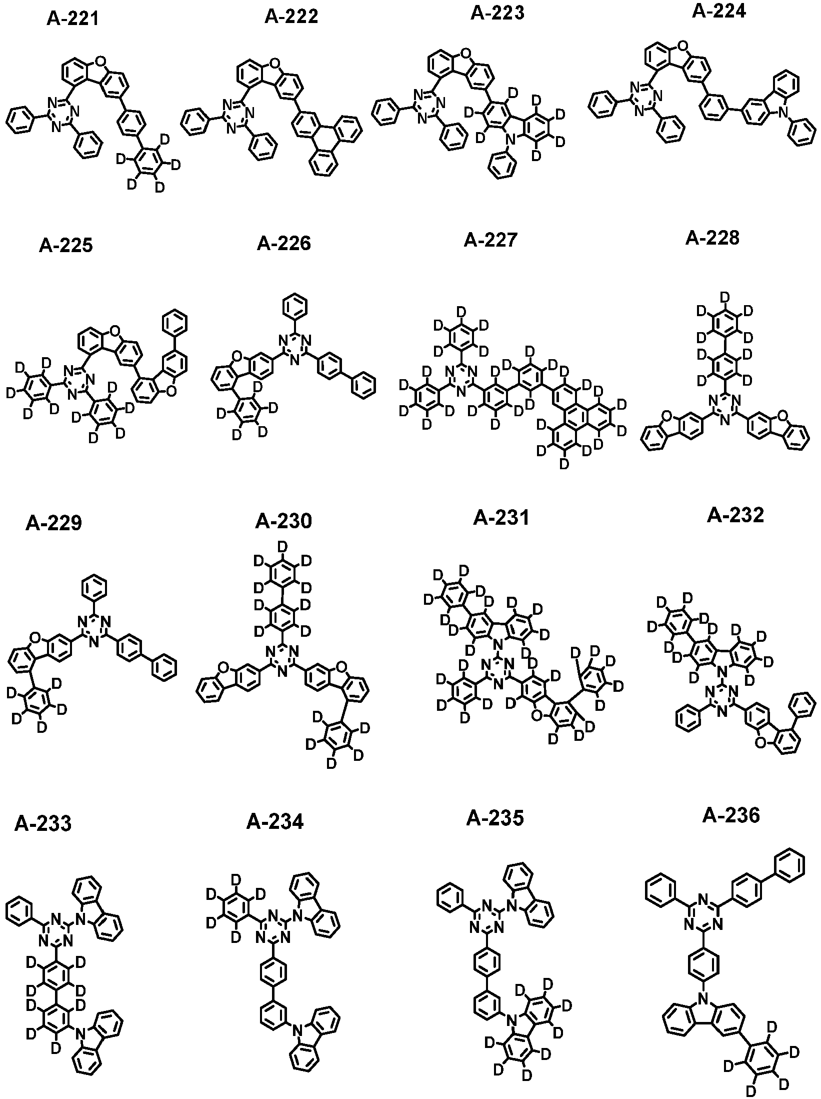

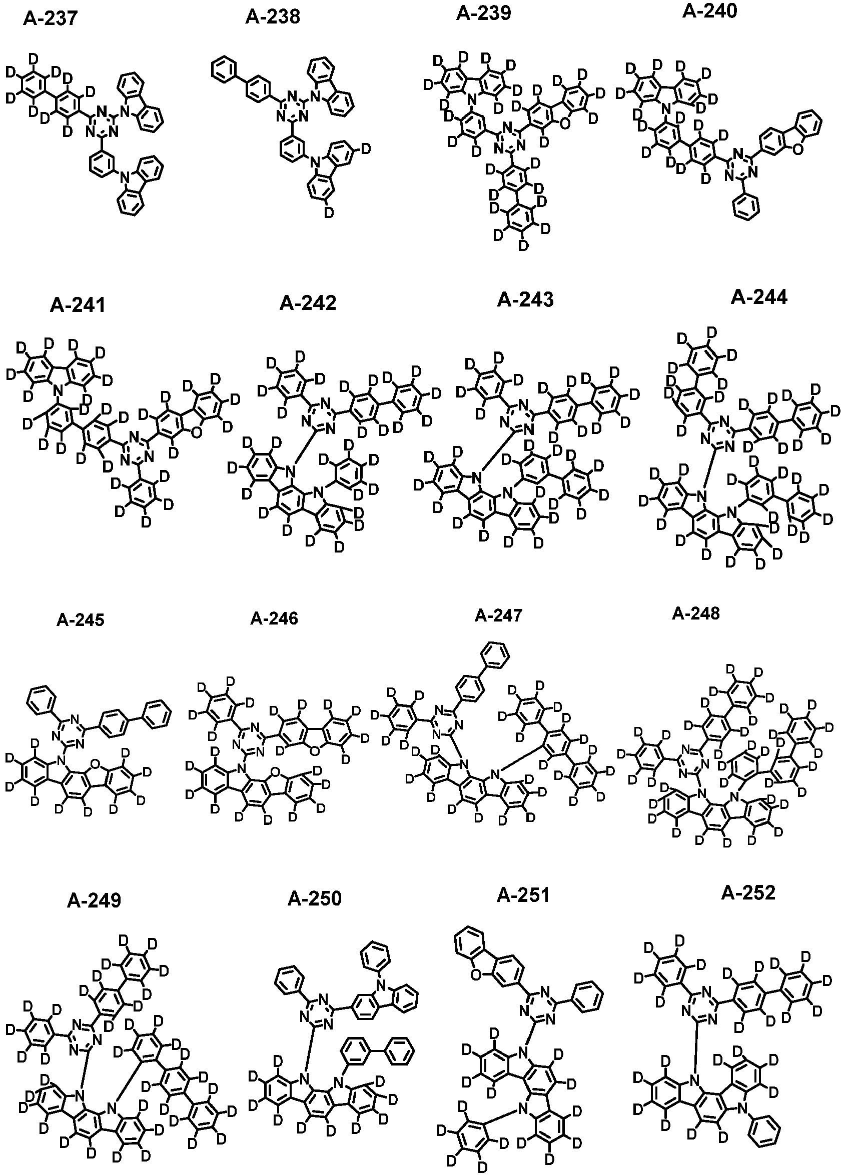

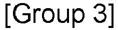

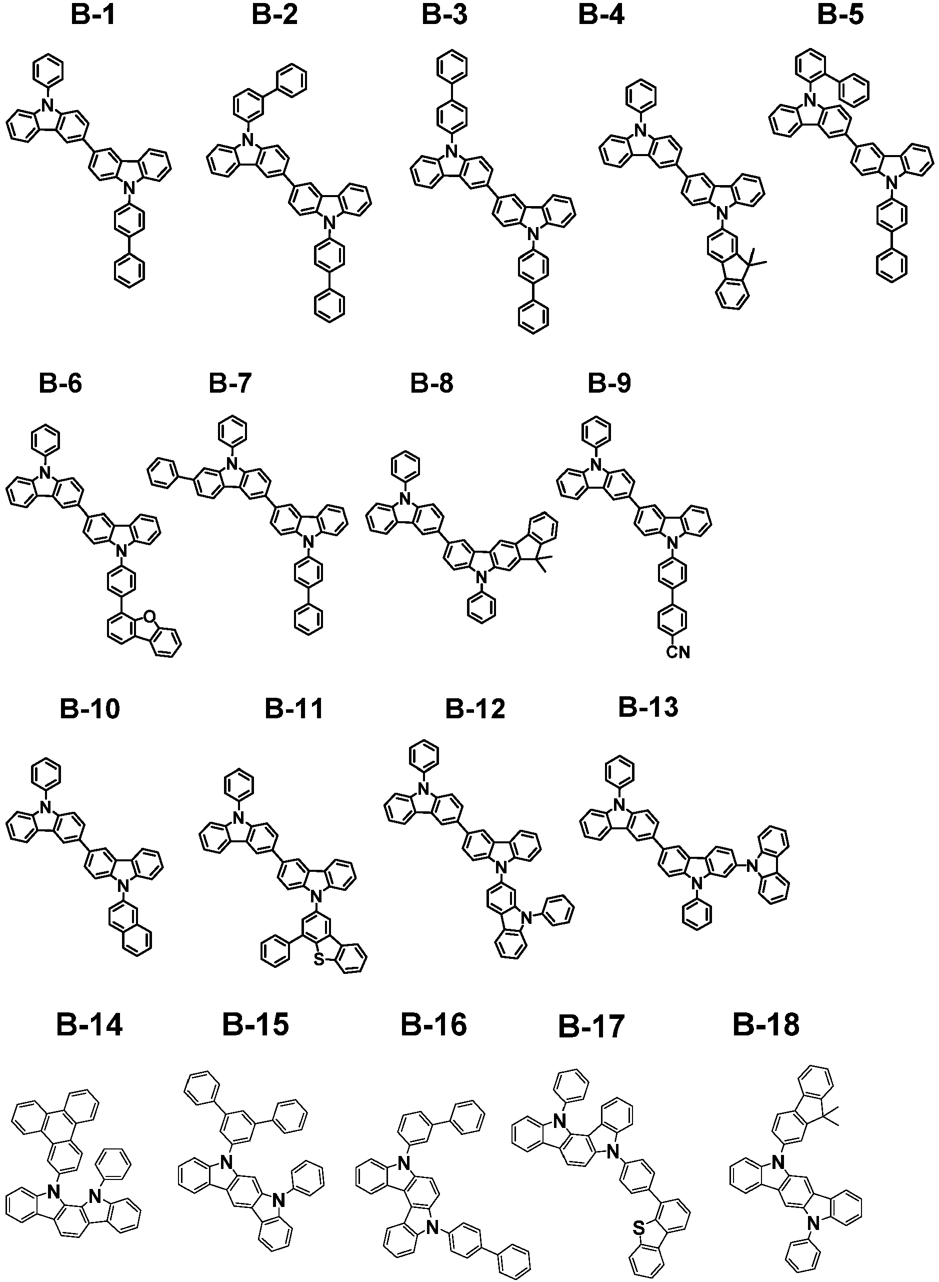

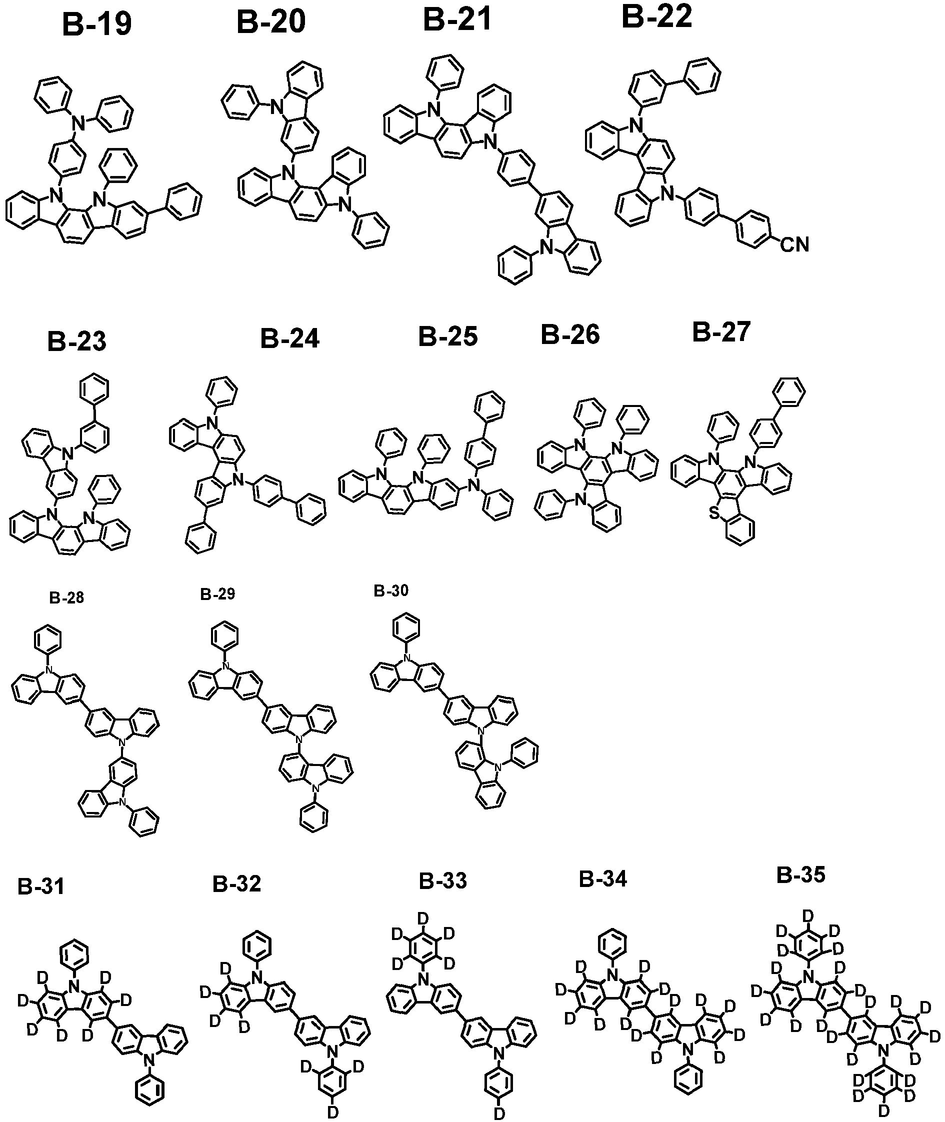

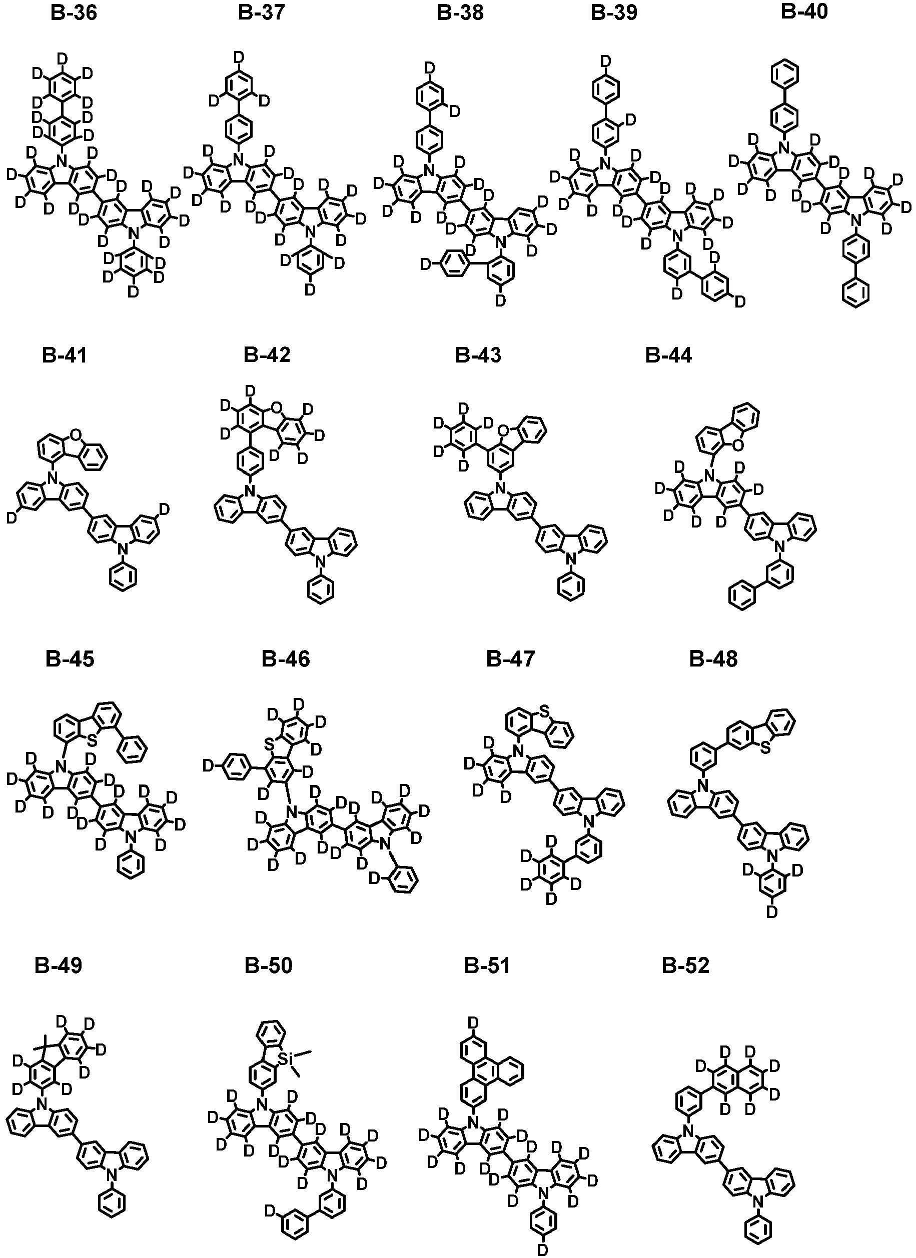

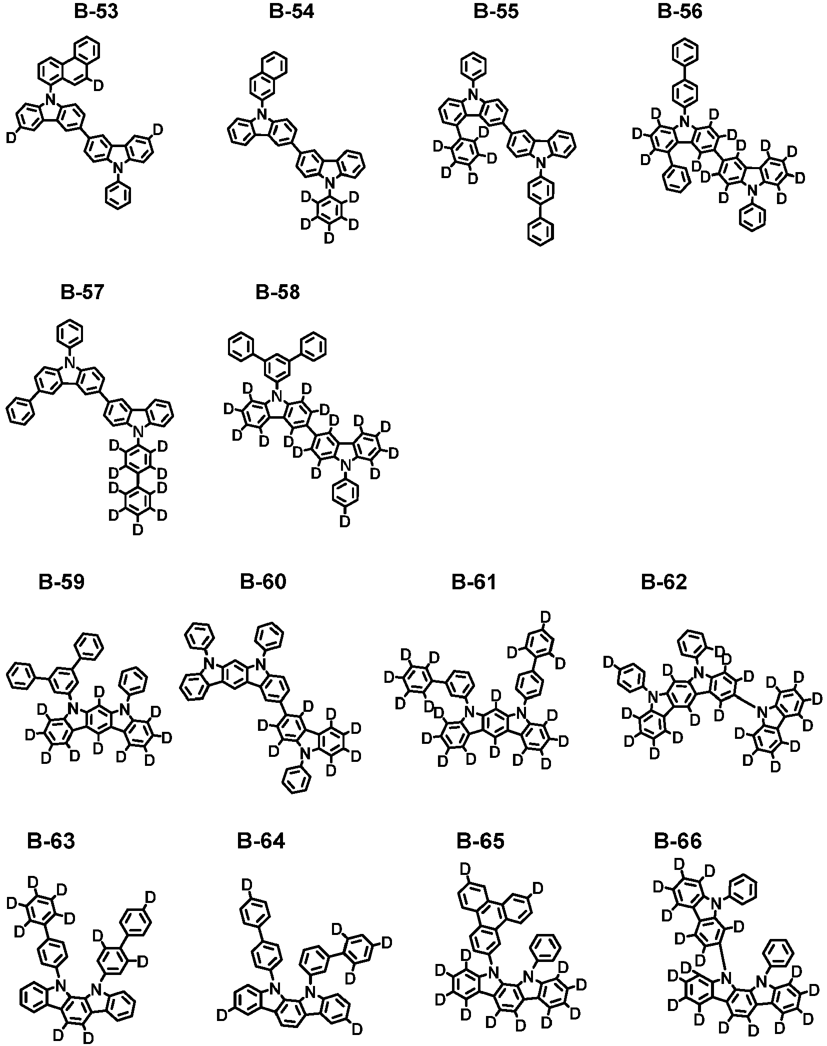

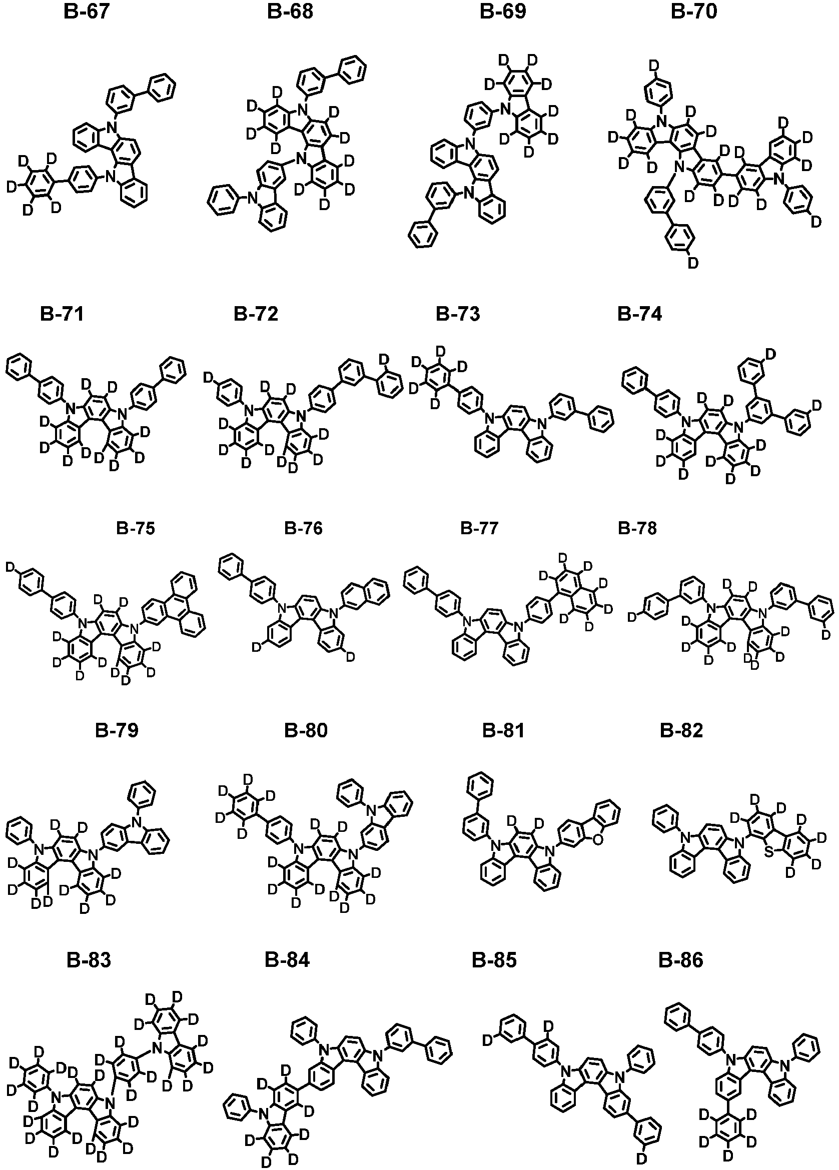

The organic layer may further include a charge transport region in addition to the light emitting layer.

The charge transport region may be, for example, a hole transport region 140.

The hole transport region 140 may further increase hole injection and/or hole mobility and block electrons between the anode 120 and the light emitting layer 130.

Specifically, the hole transport region 140 may include a hole transport layer between the anode 120 and the light emitting layer 130, and a hole transport auxiliary layer between the light emitting layer 130 and the hole transport layer, and at least one of the compounds of Group 4 may be included in at least one of the hole transport layer and the hole transport auxiliary layer.

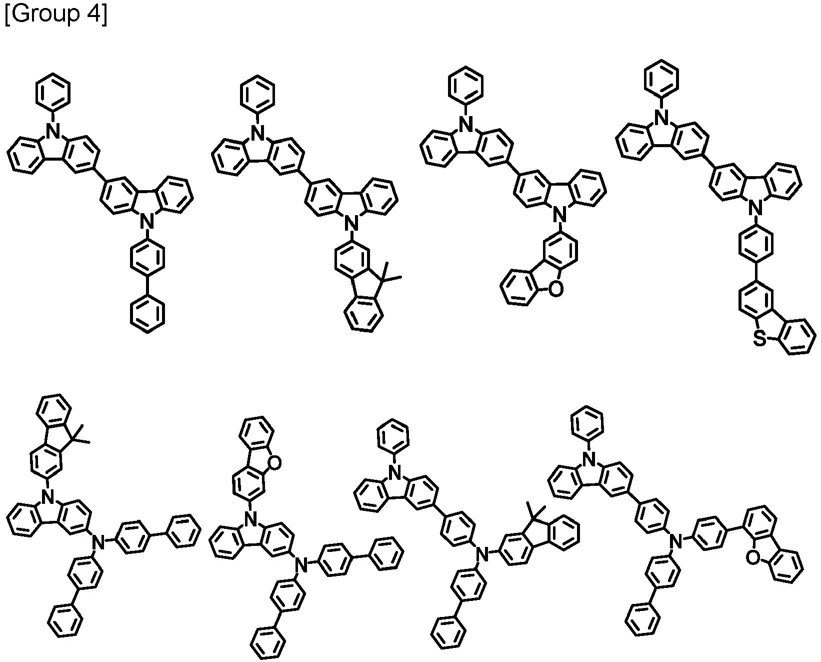

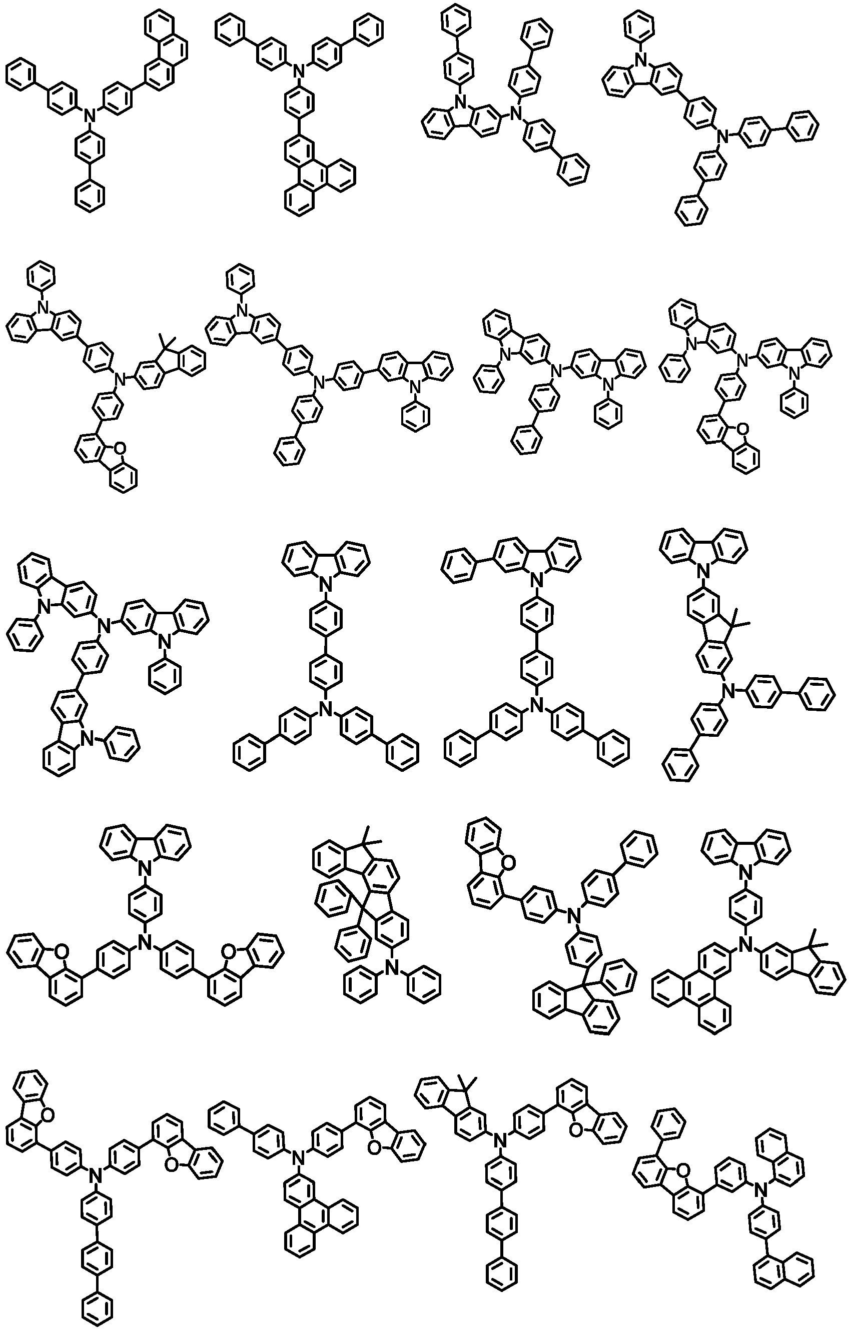

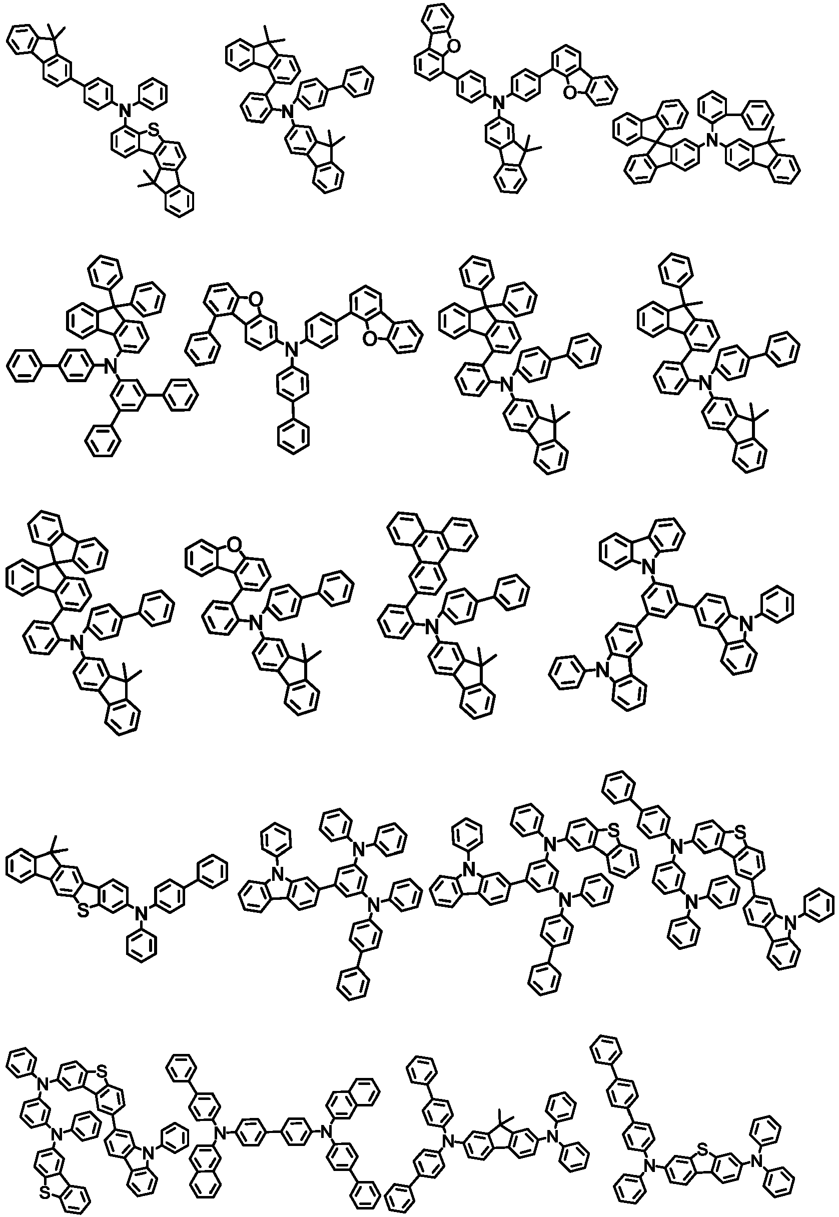

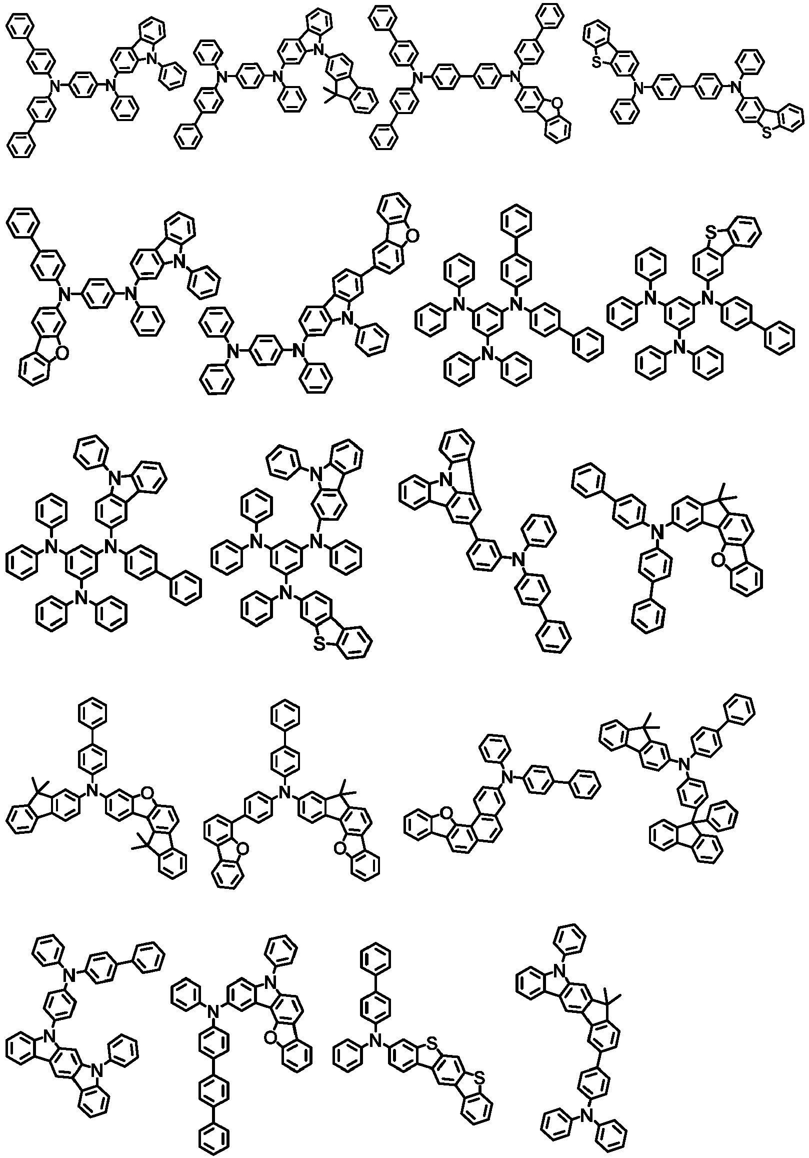

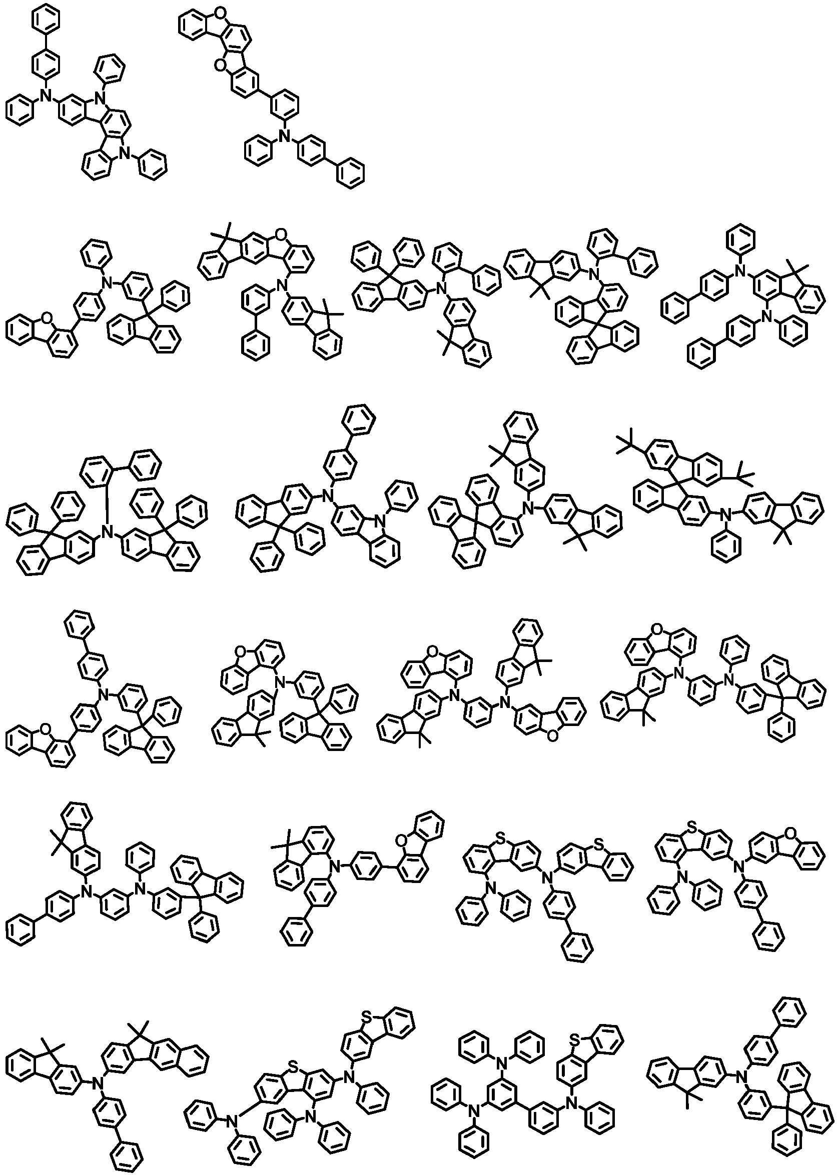

In the hole transport region 140, known compounds disclosed in US5061569A, JP1993-009471A, WO1995-009147A1, JP1995-126615A, JP1998-095973A, and the like and compounds similar thereto may be used in addition to the aforementioned compound.

Also, the charge transport region may be, for example, an electron transport region 150.

The electron transport region 150 may further increase electron injection and/or electron mobility and block holes between the cathode 110 and the light emitting layer 130.

Specifically, the electron transport region 150 may include an electron transport layer between the cathode 110 and the light emitting layer 130, and an electron transport auxiliary layer between the light emitting layer 130 and the electron transport layer, and at least one of the compounds of Group 5 may be included in at least one of the electron transport layer and the electron transport auxiliary layer.

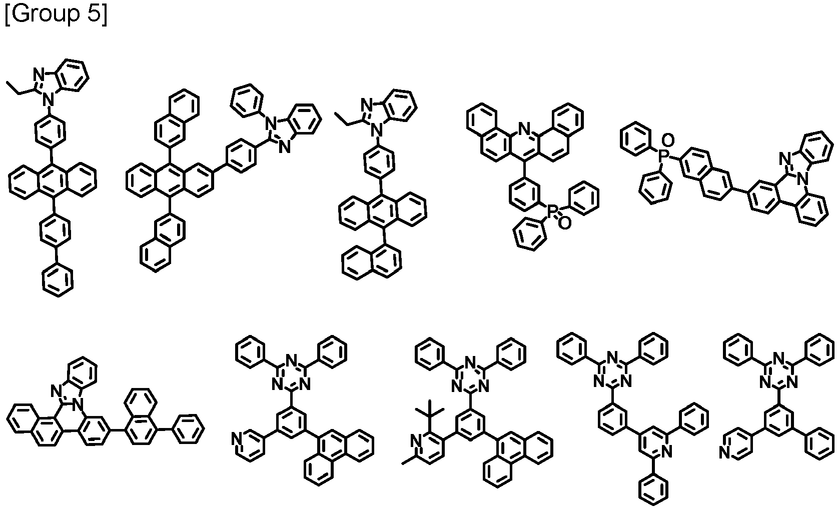

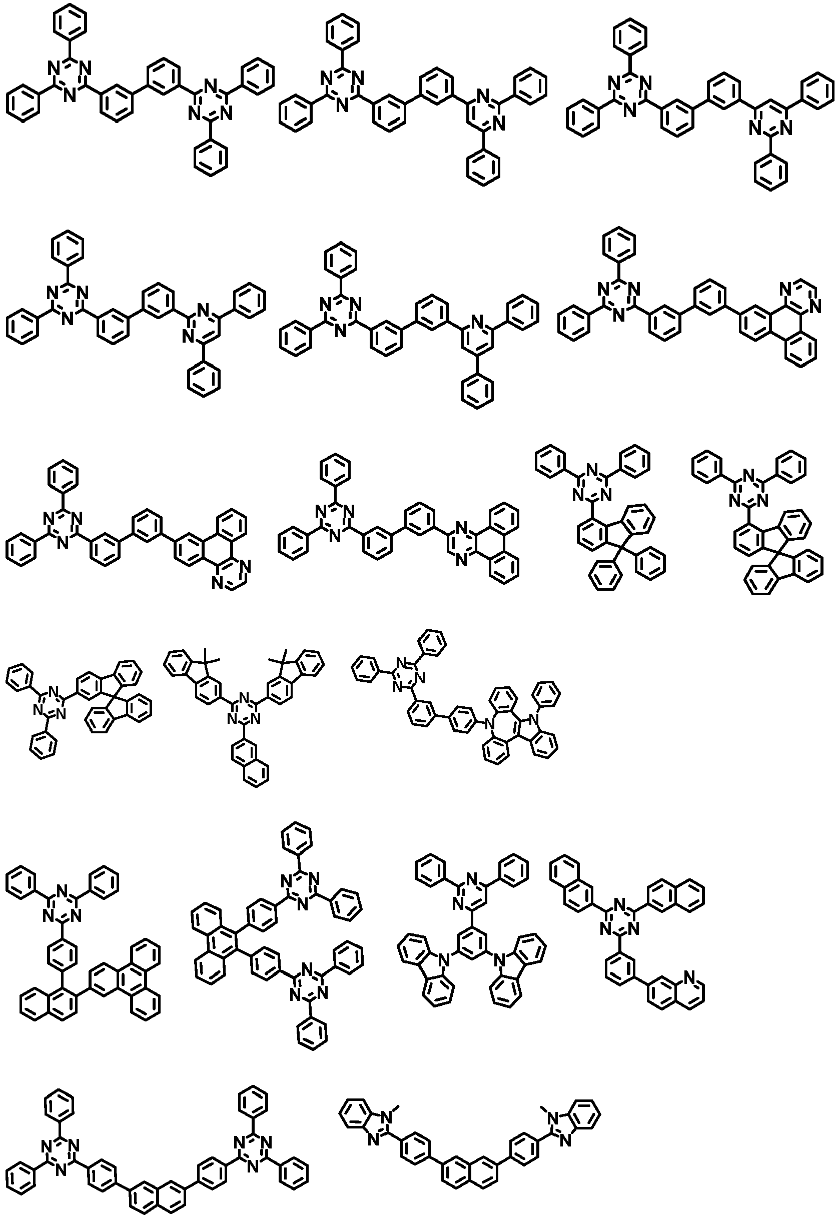

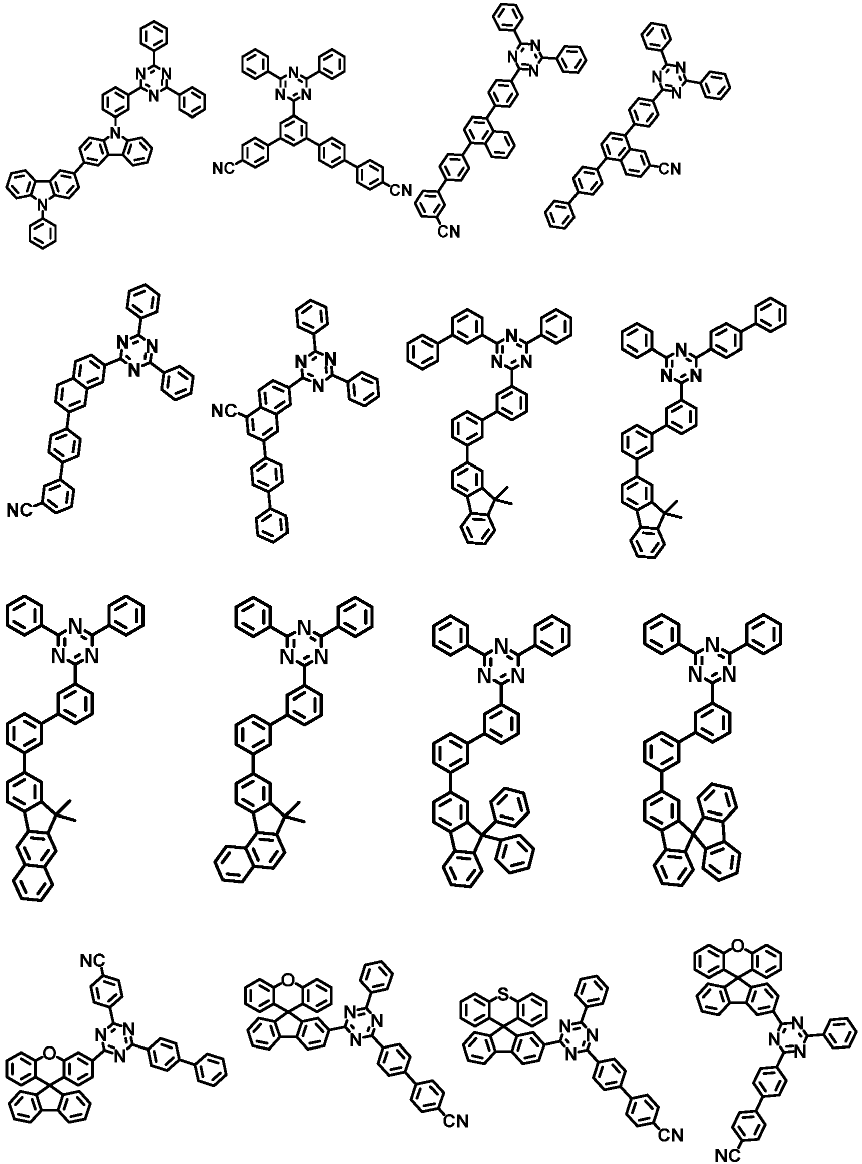

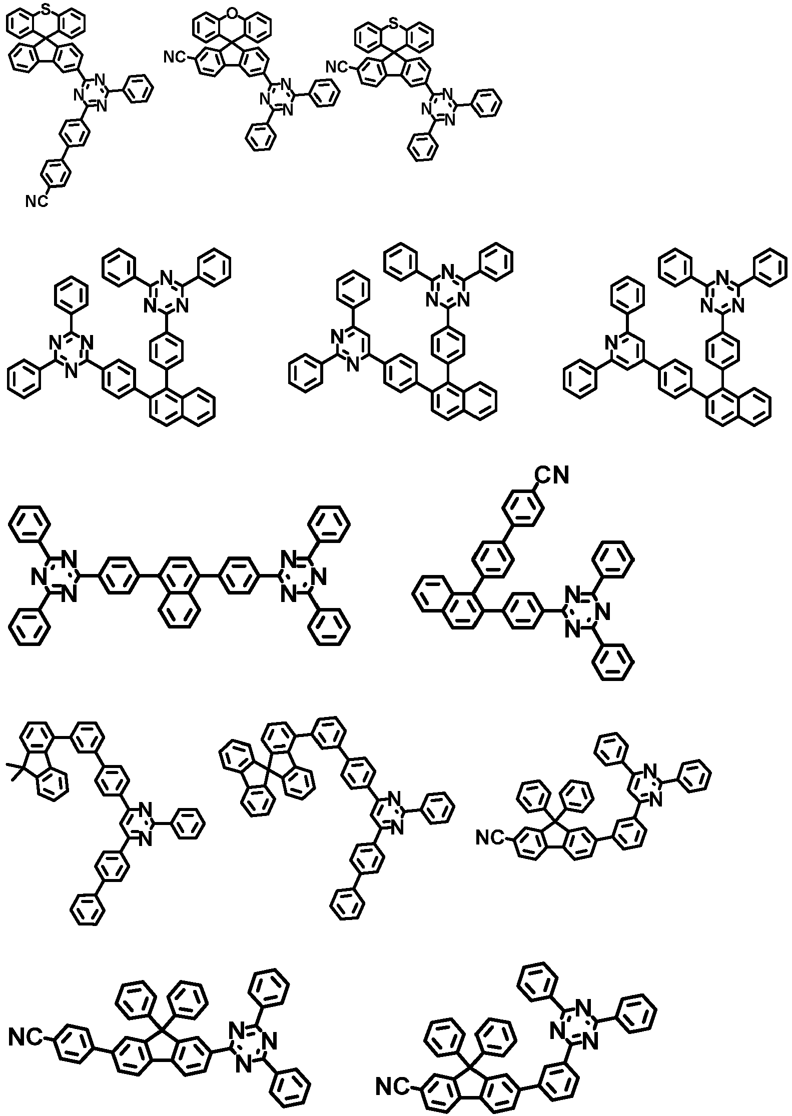

An embodiment may provide an organic light emitting diode including a light emitting layer as an organic layer.

Another embodiment may provide an organic light emitting diode including a light emitting layer and a hole transport region as an organic layer.

Another embodiment may provide an organic light emitting diode including a light emitting layer and an electron transport region as an organic layer.

As shown in FIG. 1, the organic light emitting diode according to an embodiment of the present invention may include a hole transport region 140 and an electron transport region 150 in addition to the light emitting layer 130 as the organic layer 105.

On the other hand, the organic light emitting diode may further include an electron injection layer (not shown), a hole injection layer (not shown), etc. in addition to the light emitting layer as the aforementioned organic layer.

The organic light emitting diode 100 may be produced by forming an anode or a cathode on a substrate, forming an organic layer using a dry film formation method such as a vacuum deposition method (evaporation), sputtering, plasma plating, and ion plating, and forming a cathode or an anode thereon.

The organic light emitting diode may be applied to an organic light emitting display device.

### DETAILED DESCRIPTION OF THE EMBODIMENTS

Hereinafter, the embodiments are illustrated in more detail with reference to examples. However, these examples are exemplary, and the scope of claims is not limited thereto.

Hereinafter, starting materials and reactants used in Examples and Synthesis Examples were purchased from Sigma-Aldrich Co. Ltd., TCI Inc., Tokyo chemical industry, or P&H tech as far as there is no particular comment or were synthesized by known methods.

### (Preparation of Compound for Organic Optoelectronic Device)

The compound presented as a more specific example of the compound of the present invention was synthesized through the following steps.

### Synthesis of First Host

### Synthesis Example 1: Synthesis of Intermediate Core-1

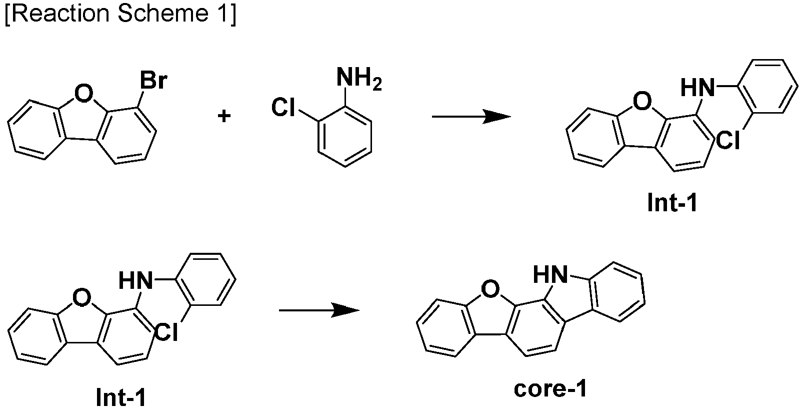

### 1st step: Synthesis of Intermediate Int-1

4-bromo-dibenzofuran (25 g, 101.18 mmol), 2-chloroaniline (19.36 g, 151.77 mmol), Pd₂(dba)₃(4.63 g, 5.06 mmol), P(t-Bu)₃(3.7 ml, 15.18 mmol), and NaO(t-Bu) (11.67 g, 121.41 mmol) were put in a round-bottomed flask and then, stirred under reflux in the presence of 350 ml of a toluene solvent at 130 °C for 12 hours. When a reaction was completed, 15 g (50%) of Intermediate Int-1 was obtained through column chromatography.

### 2nd step: Synthesis of Intermediate Core-1

Int-1 (20 g, 68.09 mmol), Pd₂(dba)₃ (3.12 g, 3.4 mmol), Cs₂CO₃ (44.34 g, 136.17 mmol), PCya·HBF₄ (3.7 ml, 15.18 mmol), and NaO(t-Bu) (11.67 g, 121.41 mmol) were put in a round-bottomed flask and stirred under reflux in the presence of 220 ml of a DMAc solvent at 160 °C for 12 hours. When a reaction was completed, 8.1 g (46%) of Intermediate Core-1 was obtained through column chromatography.

### Synthesis Example 2: Synthesis of Intermediate Int-2

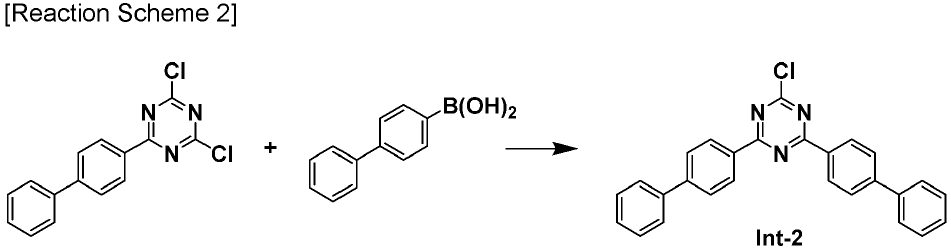

2,4-dichloro-6-(biphenyl-4-yl)-1,3,5-triazine (22.89 g, 75.75 mmol), [1,1'-biphenyl]-4-ylboronic acid (10 g, 50.50 mmol), K₂CO₃ (13.96 g, 138.21 mmol) and Pd(PPh₃)₄ (2.92 g, 2.52 mmol) were put in a round-bottomed flask, and 100 ml of THF and 50 ml of distilled water were added thereto and then, stirred under reflux at 80 °C for 12 hours.

When a reaction was completed, the mixture was added to 300 mL of methanol, a solid crystallized therein was filtered and dissolved in monochlorobenzene and then, filtered with silica gel/Celite, and after removing an appropriate amount of an organic solvent, 20.67 g (65%) of Intermediate Int-2 was obtained through recrystallization with methanol.

### Synthesis Example 3: Synthesis of Compound A-42

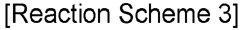

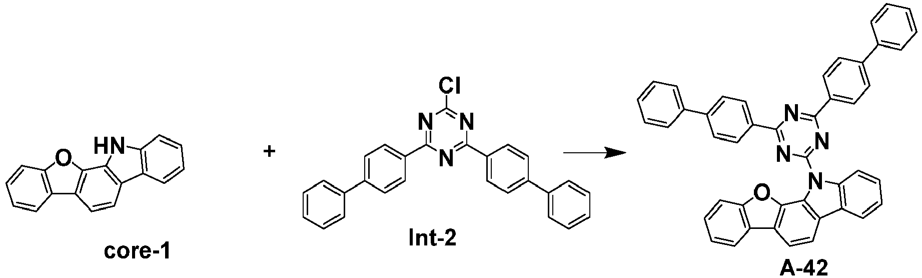

Intermediate Core-1 (7.72 g, 30.0 mmol), Intermediate Int-2 (13.23 g, 31.5 mmol), and NaH (1.58 g, 65.99 mmol) were put in a round-bottomed flask, and 100 ml of DMF was added thereto and then, stirred at room temperature for 12 hours. When a reaction was completed, 300 mL of water was added to the mixture to crystallize a solid, the solid was filtered, dissolved in monochlorobenzene, and filtered with silica gel/Celite, and after removing an appropriate amount of the organic solvent, 16.92 g (88%) of Compound A-42 was obtained through recrystallization with methanol.

### Synthesis Example 4: Synthesis of Compound A-43

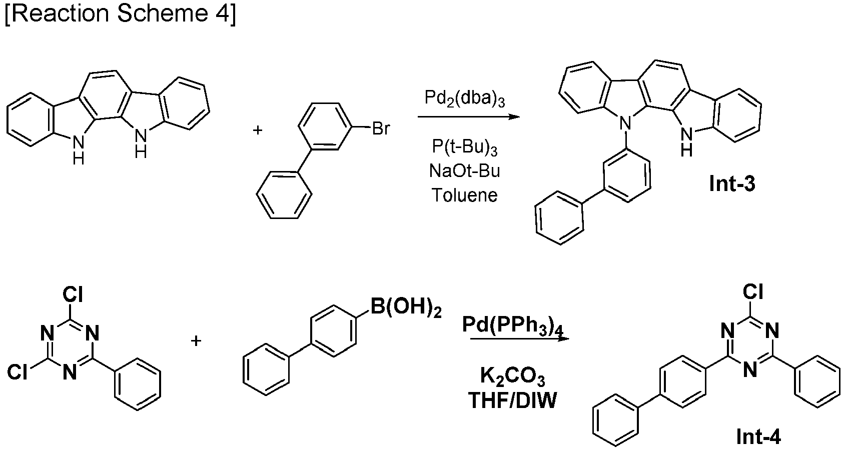

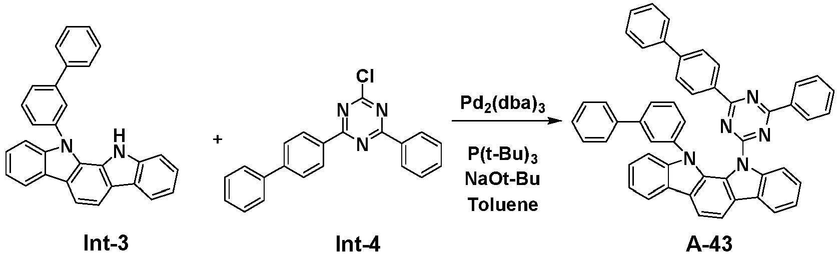

### 1st step: Synthesis of Intermediate Int-3

11,12-dihydroindolo[2,3-a]carbazole (78.35 g, 305.69 mmol, CAS No. 60511-85-5), 3-bromobiphenyl (59.38 g, 254.74 mmol), NaOt-Bu (26.93 g, 280.22 mmol), and Pd₂(dba)₃ (7 g, 7.64 mmol) were suspended in 1,400 ml of toluene, and P(t-Bu)₃ (3.64 ml, 15.28 mmol) was added thereto and then, stirred under reflux for 12 hours. Subsequently, distilled water was added to the reaction solution to separate the mixture. A product obtained therefrom was purified through silica gel column, obtaining Intermediate Int-3 (68.7 g, 57%).

### 2nd step: Synthesis of Intermediate Int-4

2,4-dichloro-6-phenyl-1,3,5-triazine (74.50 g, 329.56 mmol) and 4-biphenylboronic acid (55.47 g, 280.12 mmol) were dissolved in 0.7 L of a mixed solvent of tetrahydrofuran (THF) and distilled water (3:1 v/v), and sodium tertbutoxide (68.32 g, 494.34 mmol) was added thereto and then, stirred under reflux for 12 hours. The reaction solution was cooled, and after separating layers, an organic layer was gathered and concentrated. The concentrated residue was purified through silica gel column, obtaining Intermediate Int-4 (75.9 g, 67%).

### 3rd step: Synthesis of Compound A-43

Compound A-43 was used in the same synthesis method as the synthesis of Intermediate Int-3 except that Intermediate Int-3 and Intermediate Int-4 were used.

### Synthesis Example 5: Synthesis of Compound A-41

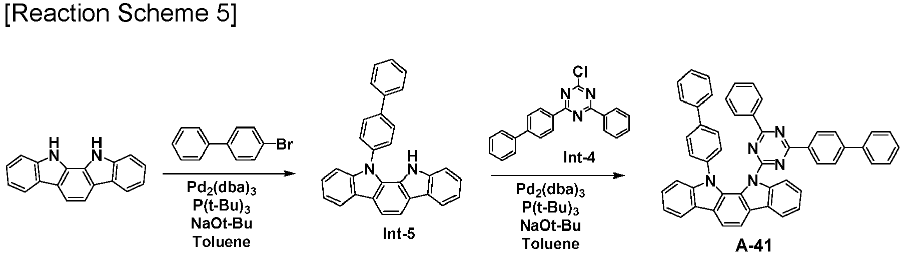

Intermediate Int-5 was synthesized in the same synthesis method as the synthesis of Intermediate Int-3.

Compound A-41 was synthesized in the same synthesis method as the synthesis of Compound A-43.

### Synthesis Example 6: Synthesis of Compound A-200

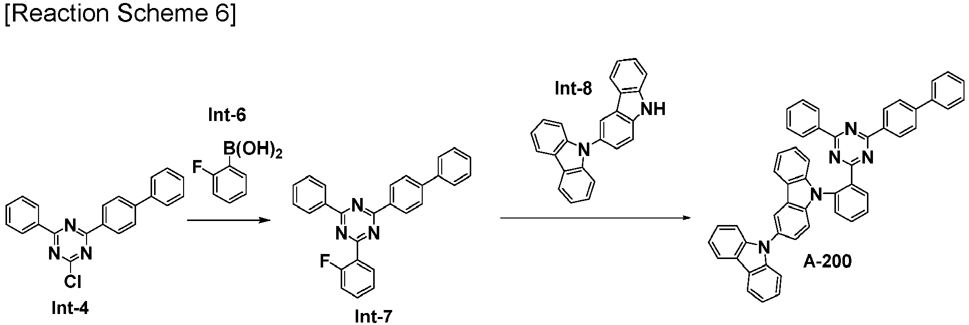

### 1st step: Synthesis of Intermediate Int-7

1 equivalent of Intermediate Int-4, 1.1 equivalent of Intermediate Int-6, 0.05 equivalent of Pd(PPh₃)₄, 3 equivalents of K₂CO₃, 0.33 M THF, and 0.11 M water were all put in a round flask and reacted overnight at 80 °C under reflux. After cooling to room temperature, a product therefrom was three times washed with 0.33 M methyl-chloride and 0.33 M distilled water. After removing the remaining solvent with MgSO₄, the residue was adsorbed onto silica gel and twice columned with a mixed solvent of methyl-chloride and hexane in a volume ratio of 3:7 as an eluent, obtaining Intermediate Int-7 at a yield of about 70%.

### 2nd step: Synthesis of Compound A-200

1 equivalent of Intermediate Int-7, 1.1 equivalent of Intermediate Int-8, 2.5 equivalent of K₃PO₄, and 0.2 M DMF were all put in a round flask and then, reacted overnight at 150 °C under reflux. When a reaction was completed, the DMF solvent was removed therefrom with a rotary evaporator. After removing the solvent, 0.5 M MeOH was injected into the reaction vessel and then, stirred for 10 minutes at room temperature and filtered with a filter. The filtered solid was three times washed with 0.4 M MC and 0.4 M water and then, treated with MgSO₄ to remove the remaining solvent. Subsequently, the residue was adsorbed onto silica gel and columned with a mixed solvent of methyl-chloride and hexane in a volume ratio of 3:7 as an eluent, obtaining Compound A-200 at a yield of about 70%.

### Synthesis Example 7: Synthesis of Compound C1

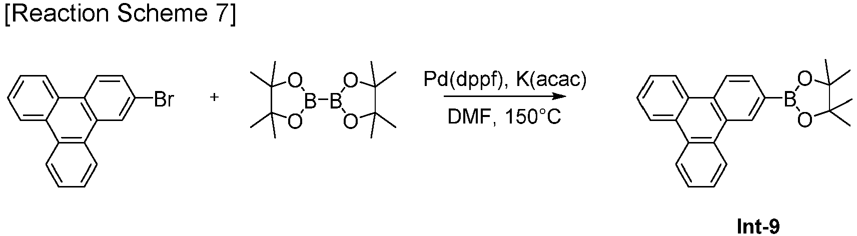

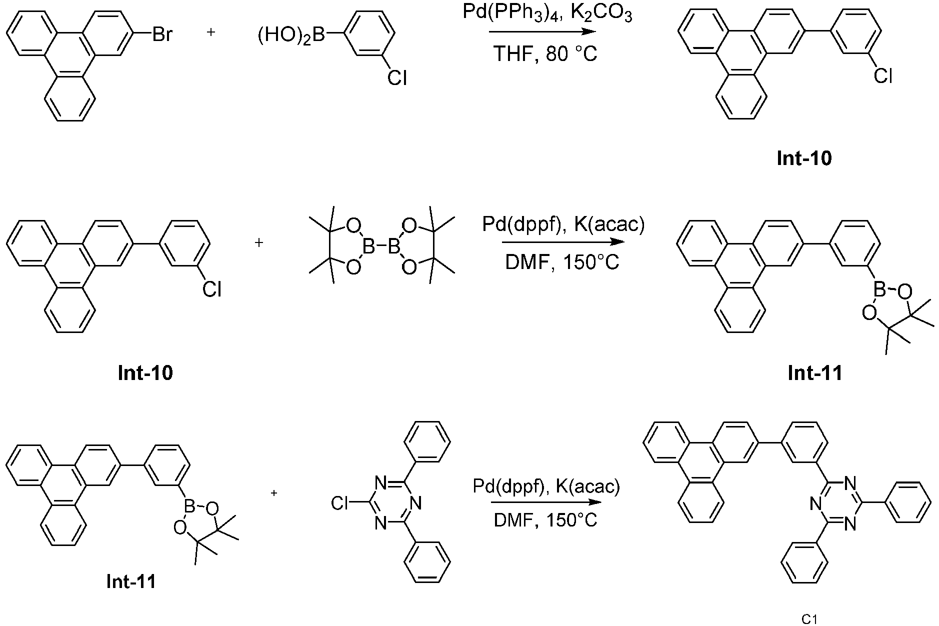

### 1st step: Synthesis of Intermediate Int-9

2-bromotriphenylene (100 g, 326 mmol) was dissolved in 1 L of dimethylforamide (DMF) in a nitrogen environment, and bis(pinacolato)diboron (99.2 g, 391 mmol), (1,1'-bis(diphenylphosphine)ferrocene)dichloropalladium(II) (2.66 g, 3.26 mmol), and potassium acetate (80 g, 815 mmol) were added thereto and then, heated under reflux at 150 °C for 5 hours. When a reaction was completed, water was added to the reaction solution and then, filtered and dried in a vacuum oven. The obtained residue was separated and purified through flash column chromatography, obtaining Intermediate Int-9 (113 g, 98%).
HRMS (70 eV, EI+): m/z calcd for C24H23BO2: 354.1791, found: 354.
Elemental Analysis: C, 81%; H, 7%

### 2nd step: Synthesis of Intermediate Int-10

2-bromotriphenylene (32.7 g, 107 mmol) was dissolved in 0.3 L of tetrahydrofuran (THF) in a nitrogen environment, and 2-bromotriphenylene (20 g, 128 mmol) and tetrakis(triphenylphosphine)palladium (1.23 g, 1.07 mmol) were added thereto and then, stirred. Subsequently, potassium carbonate (36.8 g, 267 mmol) saturated in water was added thereto and then, heated under reflux at 80 °C for 24 hours. When a reaction was completed, water was added to the reaction solution and then, extracted with dichloromethane (DCM), treated with anhydrous MgSO₄ to remove moisture, filtered, and concentrated under a reduced pressure. The obtained residue was separated and purified through flash column chromatography, obtaining Intermediate Int-10 (22.6 g, 63%).
HRMS (70 eV, EI+): m/z calcd for C24H15Cl: 338.0862, found: 338.
Elemental Analysis: C, 85%; H, 5%

### 3rd step: Synthesis of Intermediate Int-11

Intermediate Int-10 (22.6 g, 66.7 mmol) was dissolved in 0.3 L of dimethylforamide (DMF) in a nitrogen environment, and bis(pinacolato)diboron (25.4 g, 100 mmol), 1,1'-bis(diphenylphosphine)ferrocene)dichloropalladium (II) (0.54 g, 0.67 mmol), and potassium acetate (16.4 g, 167 mmol) were added thereto and then, heated under reflux at 150 °C for 48 hours. When a reaction was completed, water was added to the reaction solution and then, filtered and dried in a vacuum oven. The obtained residue was separated and purified through flash column chromatography, obtaining Intermediate Int-11 (18.6 g, 65%).
HRMS (70 eV, EI+): m/z calcd for C30H27BO2: 430.2104, found: 430.
Elemental Analysis: C, 84%; H, 6%

### 4th step: Synthesis of Compound C1

Intermediate Int-11 (20 g, 46.5 mmol) was dissolved in 0.2 L of tetrahydrofuran (THF) in a nitrogen environment, and 2-chloro-4,6-diphenyl-1,3,5-triazine (12.4 g, 46.5 mmol) and tetrakis(triphenylphosphine)palladium (0.54 g, 0.47 mmol) were added thereto and then, stirred. Subsequently, potassium carbonate (16.1 g, 116 mmol) saturated in water was added thereto and then, heated under reflux at 80 °C for 20 hours. When a reaction was completed, water was added to the reaction solution and then, extracted with dichloromethane (DCM) and treated with anhydrous MgSO₄ to remove moisture, filtered, and concentrated under a reduced pressure. The obtained residue was separated and purified through flash column chromatography, obtaining Compound C1 (21.2 g, 85%).
HRMS (70 eV, EI+): m/z calcd for C39H25N3: 535.2048, found: 535.
Elemental Analysis: C, 87%; H, 5%

### Synthesis of Second Host

### Synthesis Example 8: Synthesis of Compound B-1

Compound B-1 was synthesized with reference to a method known in KR10-1773363B1.

### Synthesis Example 9: Synthesis of Compound B-2

Compound B-2 was synthesized with reference to a method known in KR10-1649683B1.

### Synthesis Example 10: Synthesis of Compound B-5

Compound B-5 was synthesized with reference to a method known in KR10-1773363B1.

### Synthesis Example 11: Synthesis of Compound B-16

Compound B-16 was synthesized with reference to a method known in KR10-2018-0099436A.

### Synthesis of Pt Dopant

### Synthesis Example 12: Synthesis of Compound 4

Compound 4 was synthesized with reference to the information disclosed in Korean Patent Laid-Open Publication No. 10-2020-0026093.

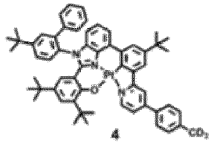

### (Manufacture of Organic Light Emitting Diode)

### Example 1

A glass substrate coated with ITO (Indium tin oxide) was washed with distilled water and ultrasonic waves. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This obtained ITO transparent electrode was used as an anode, Compound A doped with 3% NDP-9 (available from Novaled) was vacuum-deposited on the ITO substrate to form a 100 Å-thick hole injection layer, and Compound A was deposited to on the hole injection layer to form a 1350 Å-thick hole transport layer. On the hole transport layer, 350 Å-thick hole transport auxiliary layer was formed by depositing Compound B. On the hole transport auxiliary layer, 400 Å-thick light emitting layer was formed by simultaneously vacuum-depositing Compound A-41 of Synthesis Example 5 and Compound B-5 of Synthesis Example 10 as a host and doping 10 wt% of Compound 4 of Synthesis Example 12 as a dopant. Herein Compound A-41 and Compound B-5 were used in a weight ratio of 4:6. Subsequently, Compound C was deposited on the light emitting layer to form a 50 Å-thick electron transport auxiliary layer, and Compound D and Liq were simultaneously vacuum-deposited at a weight ratio of 1:1 to form a 300 Å-thick electron transport layer. LiQ (15 Å) and Al (1200 Å) were sequentially vacuum-deposited on the electron transport layer to form a cathode, thereby manufacturing an organic light emitting diode.

ITO / Compound A (3% NDP-9 doping,100 Å) / Compound A (1350 Å) / Compound B (350 Å) / EML [90 wt% of host (Compound A-41: Compound B-5=4:6 (w/w)) and 10 wt% of dopant] (400 Å) / Compound C (50 Å) / Compound D:LiQ (300 Å) / LiQ (15 Å) / Al (1200 Å).
Compound A: N-(biphenyl-4-yl)-9,9-dimethyl-N-(4-(9-phenyl-9H-carbazol-3-yl)phenyl)-9H-fluoren-2-amine
Compound B: N,N-bis(9,9-dimethyl-9H-fluoren-4-yl)-9,9-spirobi(fluorene)-2-amine
Compound C: 2-[3'-(9,9-dimethyl-9H-fluoren-2-yl)[1,1'-biphenyl]-3-yl]-4,6-diphenyl-1,3,5-triazine
Compound D: 2-[4-[4-(4'-cyano-1,1'-biphenyl-4-yl)-1-naphthyl]phenyl]-4,6-diphenyl-1,3,5-triazine

### Examples 2 to 5 and Comparative Examples 1 and 2

Diodes of Examples 2 to 5 and Comparative Examples 1 and 2 were manufactured in the same manner as in Example 1, except that the composition was changed as shown in Tables 1 and 2.

### Evaluations

The luminous efficacy and driving voltages of the organic light emitting diodes according to Examples 1 to 5 and Comparative Examples 1 and 2 were evaluated.

The specific measurement method is as follows, and the results are shown in Tables 1 and 2.

### (1) Calculation of Energy Level

The energy levels of the materials were obtained by measuring the current change according to the voltage using DPV (Differential pulse voltammetry) as follows.

A three-electrode cell consisting of a carbon electrode (working electrode), a Pt wire (counter electrode), and a DMF electrolyte containing Ag/AgCl (3 M NaCl) (reference electrode) and 0.1 M tetrabutyl ammonium hexafluorophosphate (TBAF) was used, wherein ferrocene dissolved in the electrolyte was used as a reference correction value.

After dissolving 10 mg of each sample in 10 mL of the electrolyte and purging it with N₂ gas, a reduction current was measured by applying a voltage of +0.5 V to -2.2 V thereto, and subsequently, an oxidation current was measured by applying a voltage of +0.5 V to +1.8 V thereto.

(Each of the voltages was applied, while a pulse was given with a step potential (V): 0.005 V, a pulse height (V): 0.025 V, a width(s): 0.2s, and a period(s): 0.5s)

Then, a peak voltage at the reduction current and a peak voltage at the oxidation current were corrected by the ferrocene, obtaining LUMO and HOMO.

(The LUMO energy level of a first host - HOMO energy level of a second host) was calculated, and the results are shown in Table 1.

### (2) Measurement of Current Density Change Depending on Voltage Change

The obtained organic light emitting diodes were measured regarding a current value flowing in the unit device, while increasing the voltage from 0 V to 10 V using a current-voltage meter (Keithley 2400), and the measured current value was divided by area to provide the results.

### (3) Measurement of Luminance Change Depending on Voltage Change

Luminance was measured by using a luminance meter (Minolta Cs-1000A), while the voltage of the organic light emitting diodes was increased from 0 V to 10 V.

### (4) Measurement of Current Efficiency

Current efficiency (cd/A) at the same current density (10 mA/cm²) were calculated by using the luminance, current density, and voltages (V) from the items (2) and (3).

Relative values were calculated using the current efficiency of Comparative Example 1 as a reference value and are shown in Table 1.

### (5) Measurement of Life-span

T97 life-spans of the organic light emitting diodes according to Example 5 and Comparative Example 2 were measured as a time when their luminance decreased to 97 % relative to the initial luminance (cd/m²) after emitting light with 6000 cd/m² as the initial luminance (cd/m²) and measuring their luminance decrease depending on a time with a Polanonix life-span measurement system.

Relative values were calculated using the T97 life-span of Comparative Example 2 as a reference value and are shown in Table 2.

**(Table 1)**

| | First host | Secon d host | Pt dopant | HOMO of first host (eV) | HOMO of second host (eV) | LUMO energy level of first host-HOMO energy level of second host (eV) | Current efficiency ratio (%) |
|---|---|---|---|---|---|---|---|
| Ex. 1 | A-41 | B-5 | 4 | -5.575 | -5.420 | 2.625 | 107 |
| Ex. 2 | A-42 | B-2 | 4 | -5.895 | -5.410 | 2.530 | 109 |
| Ex. 3 | A-43 | B-1 | 4 | -5.580 | -5.415 | 2.625 | 109 |
| Ex. 4 | A-200 | B-5 | 4 | -5.560 | -5.420 | 2.620 | 114 |
| Comp. Ex. 1 | A-41 | B-16 | 4 | -5.575 | -5.300 | 2.505 | 100 |

**(Table 2)**

| | First host | Second host | Pt dopant | Life-span ratio (%) |
|---|---|---|---|---|
| Ex. 5 | A-41 | B-5 | 4 | 175 |
| Comp. Ex. 2 | C1 | B-5 | 4 | 100 |

Referring to Table 1, the organic light emitting diodes manufactured by applying the compound according to the present invention exhibited significantly improved current efficiency, compared with the organic light emitting diode manufactured by applying the comparative compound.

In addition, referring to Table 2, the organic light emitting diodes manufactured by applying the compound according to the present invention exhibited significantly improved life-span, compared with the organic light emitting diode manufactured by applying the comparative compound.

Since these results appeared, when an energy level among a first host, a second host and Pt dopant satisfied a specific value, and when the first host included a substituent with a specific structure, the same results might not be expected, when the energy level among the first host, the second host, and the Pt dopant was beyond the specific range, or when the first host included no substituent with the specific structure.

While this invention has been described in connection with what is presently considered to be practical embodiments, it is to be understood that the invention is not limited to the disclosed embodiments, but, on the contrary, is intended to cover various modifications and equivalent arrangements included within the spirit and scope of the appended claims.

## Claims

1. A composition for an organic optoelectronic device, comprising
a Pt dopant represented by Chemical Formula 1,
a first host including an electron transport group represented by Chemical Formula 2, and
a second host including at least one hole transport group,
wherein a HOMO energy level of the second host is higher than a HOMO energy level of the first host, and
a difference between a LUMO energy level of the first host and the HOMO energy level of the second host is greater than 2.505 eV: 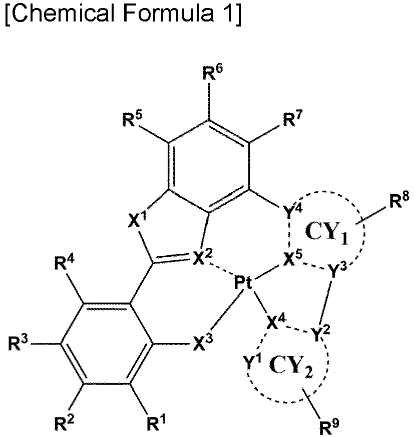
wherein, in Chemical Formula 1,
X¹ is selected from O, S, N-[(L¹)_{b1}-(R¹⁰)_{c1}], C(R¹⁰)(R¹¹), Si(R¹⁰)(R¹¹), and C(=O),
R¹⁰ and R¹¹ are each independently linked to each other via a first linking group to form a substituted or unsubstituted C5 to C30 carbocyclic group or a substituted or unsubstituted C1 to C30 heterocyclic group,
L¹ is selected from a substituted or unsubstituted C5 to C30 carbocyclic group and a substituted or unsubstituted C1 to C30 heterocyclic group,
b1 is selected from integers of 0 to 5,
c1 is selected from integers of 0 to 5,
R¹ to R⁹ are each independently selected from hydrogen, deuterium, -F, - Cl, -Br, -I, -SF₅, a hydroxyl group, a cyano group, a nitro group, an amidino group, a hydrazine group, a hydrazone group, a carboxylic acid group, or a salt thereof, a sulfonic acid group or a salt thereof, a phosphoric acid group or a salt thereof, a substituted or unsubstituted C1 to C60 alkyl group, a substituted or unsubstituted C2 to C60 alkenyl group, a substituted or unsubstituted C2 to C60 alkynyl group, a substituted or unsubstituted C1 to C60 alkoxy group, a substituted or unsubstituted C3 to C10 cycloalkyl group, a substituted or unsubstituted C1 to C10 heterocycloalkyl group, a substituted or unsubstituted C3 to C10 cycloalkenyl group, a substituted or unsubstituted C1 to C10 heterocycloalkenyl group, a substituted or unsubstituted C6 to C60 aryl group, a substituted or unsubstituted C6 to C60 aryloxy group, a substituted or unsubstituted C6 to C60 arylthio group, a substituted or unsubstituted C1 to C60 heteroaryl group, a substituted or unsubstituted monovalent non-aromatic condensed polycyclic group, and a substituted or unsubstituted monovalent non-aromatic heterocondensed polycyclic group,
X³ is O or S and a bond between X³ and Pt is a covalent bond,
X², X⁴, and X⁵ are each independently N or C, one of a bond between X² and Pt, a bond between X⁴ and Pt, and a bond between X⁵ and Pt is a covalent bond, and the other two bonds are is a coordinative bond,
Y¹ to Y⁴ are each independently C or N,
CY₁ is a benzene group or a naphthalene group, and
CY₂ is a pyridine group or an isoquinoline group; 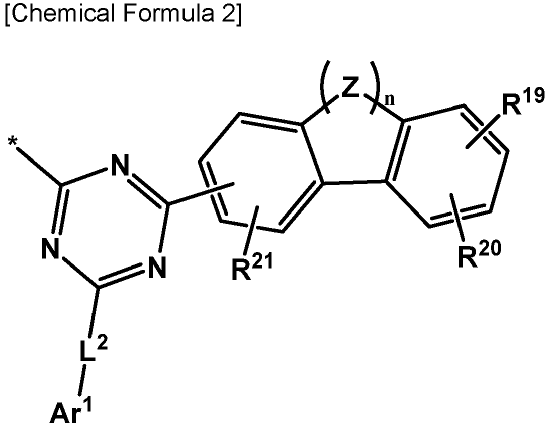
wherein, in Chemical Formula 2,
n is an integer of 0 or 1,
when n is 1, Z is O, S, CR^{a}R^{b}, or NR^{c},
R^{a}, R^{b}, R^{c}, and R¹⁹ to R²¹ are each independently hydrogen, deuterium, a cyano group, a halogen, a substituted or unsubstituted C1 to C30 alkyl group, or a substituted or unsubstituted C6 to C30 aryl group,
L² is a single bond, a substituted or unsubstituted C6 to C30 arylene group, or a substituted or unsubstituted C2 to C30 heteroarylene group,
Ar¹ is a substituted or unsubstituted C6 to C30 aryl group or a substituted or unsubstituted C2 to C30 heteroaryl group, and
* is a linking point.

2. The composition for an organic optoelectronic device of claim 1, wherein
the difference between the LUMO energy level of the first host and the HOMO energy level of the second host is greater than or equal to 2.530 eV.

3. The composition for an organic optoelectronic device of claim 1, wherein
the difference between the LUMO energy level of the first host and the HOMO energy level of the second host is 2.53 eV to 2.70 eV.

4. The composition for an organic optoelectronic device of claim 1, wherein
the Pt dopant is represented by Chemical Formula 1-1: 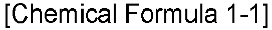 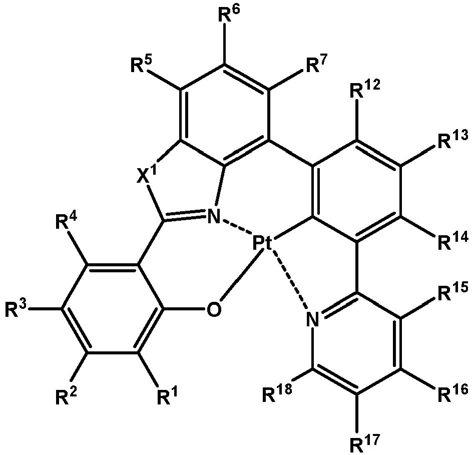 wherein, in Chemical Formula 1-1,
X¹ is N-[(L¹)_{b1}-(R¹⁰)_{c1}],
definitions of L¹, b1, c1, R¹⁰, and R¹ to R⁷ are the same as defined in claim 1,
R¹² to R¹⁸ are the same as the definitions of R¹ to R⁷ described above,
at least one of R¹ to R⁷, R¹⁰, and R¹² to R¹⁸ is an iso-propyl group, and
at least one of R¹ to R⁷, R¹⁰, R¹² to R¹⁸ is a deuterium-substituted C1 to C5 alkyl group.

5. The composition for an organic optoelectronic device of claim 1, wherein
he first host is represented by any one of the chemical formulas listed in Group I :
[Group I] 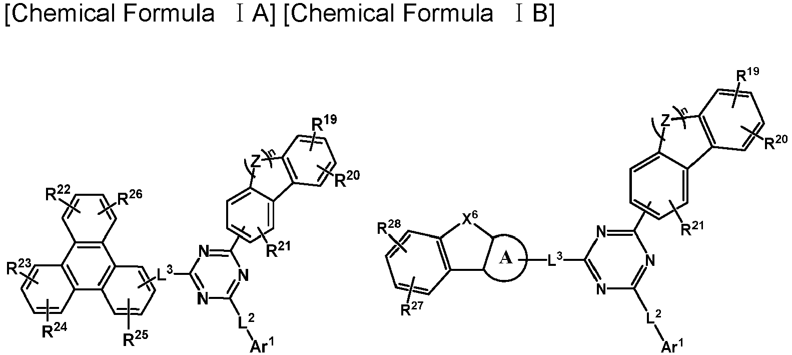 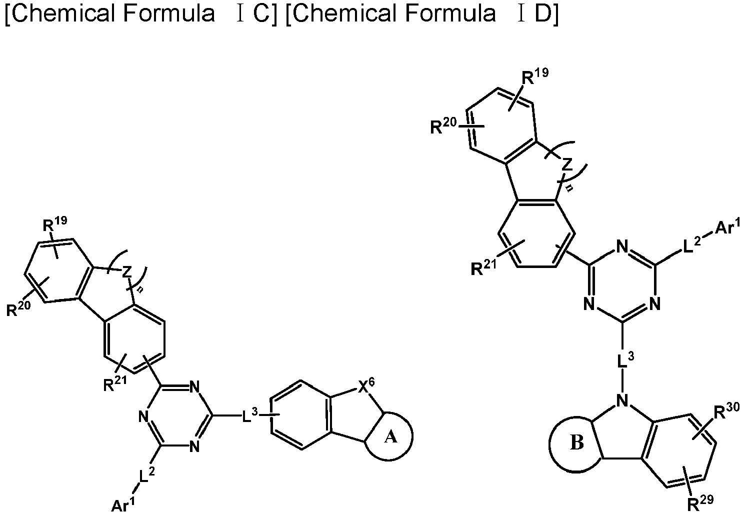 wherein, in Chemical Formula I A to Chemical Formula I D,
Z, n, Ar¹, L², L³, and R¹⁹ to R²¹ are each the same as defined in claim 1,
X⁶ is O, S, CR^{d}R^{e}, or NR^{f},
R^{d}, R^{e}, R^{f}, and R²² to R³⁰ are each independently hydrogen, deuterium, a cyano group, a halogen, a substituted or unsubstituted C1 to C30 alkyl group, or a substituted or unsubstituted C6 to C30 aryl group,
ring A is any one selected from Group A, and
ring B is any one selected from Group B, 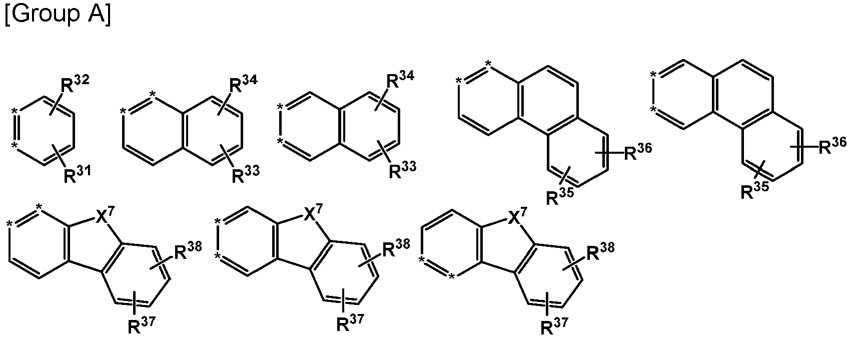 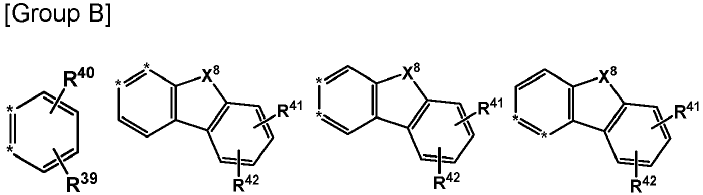
wherein, in Group A and Group B,
X⁷ and X⁸ are each independently O, S, CR^{g}R^{h}, or NRⁱ,
R^{g}, R^{h}, Rⁱ, and R³¹ to R⁴² are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group, and
* is a linking point.

6. The composition for an organic optoelectronic device of claim 1, wherein
the hole transport group is selected from a substituted or unsubstituted carbazolyl group and a substituted or unsubstituted fused carbazolyl group.

7. The composition for an organic optoelectronic device of claim 1, wherein
the second host is represented by any one of the chemical formulas listed in Group II:
[Group II] 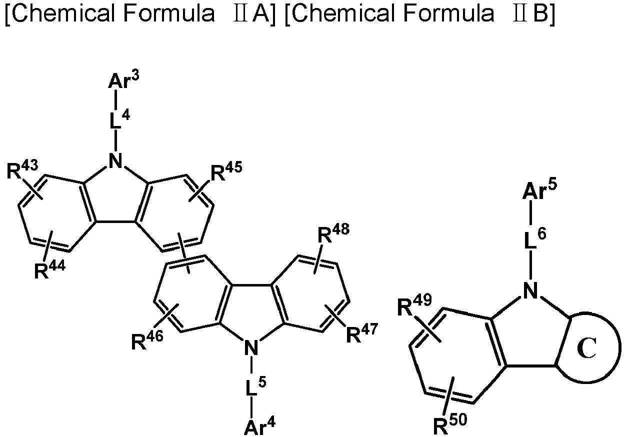 wherein, in Chemical Formula IIA and Chemical Formula IIB,
R⁴³ to R⁵⁰ are each independently hydrogen, deuterium, a cyano group, a halogen, a substituted or unsubstituted C1 to C30 alkyl group, or a substituted or unsubstituted C6 to C30 aryl group,
L⁴ to L⁶ are each independently a single bond, a substituted or unsubstituted C6 to C30 arylene group or a substituted or unsubstituted C2 to C30 heteroarylene group,
Ar³ to Ar⁵ are each independently a substituted or unsubstituted C6 to C30 aryl group or a substituted or unsubstituted C2 to C30 heteroaryl group, and
ring C is any one selected from Group C, 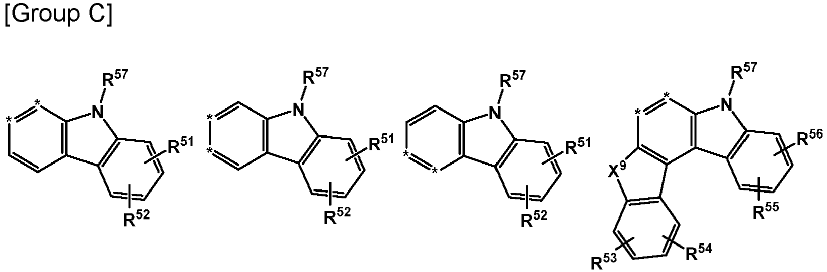
wherein, in Group C,
X⁹ is O, S, or NR^{j},
R^{j} and R⁵¹ to R⁵⁶ are each independently hydrogen, deuterium, a cyano group, a halogen, a substituted or unsubstituted C1 to C30 alkyl group, or a substituted or unsubstituted C6 to C30 aryl group,
R⁵⁷ is a substituted or unsubstituted C6 to C30 aryl group or a substituted or unsubstituted C2 to C30 heteroaryl group, and
* is a linking point.

8. The composition for an organic optoelectronic device of claim 1, wherein
the first host is one selected from Group 2,
the second host is one selected from Group 3,
a HOMO energy level of the second host selected from Group 3 is higher than a HOMO energy level of the first host selected from Group 2, and
a difference between a LUMO energy level of the first host selected from Group 2 and the HOMO energy level of the second host selected from Group 3 may be greater than 2.505 eV:

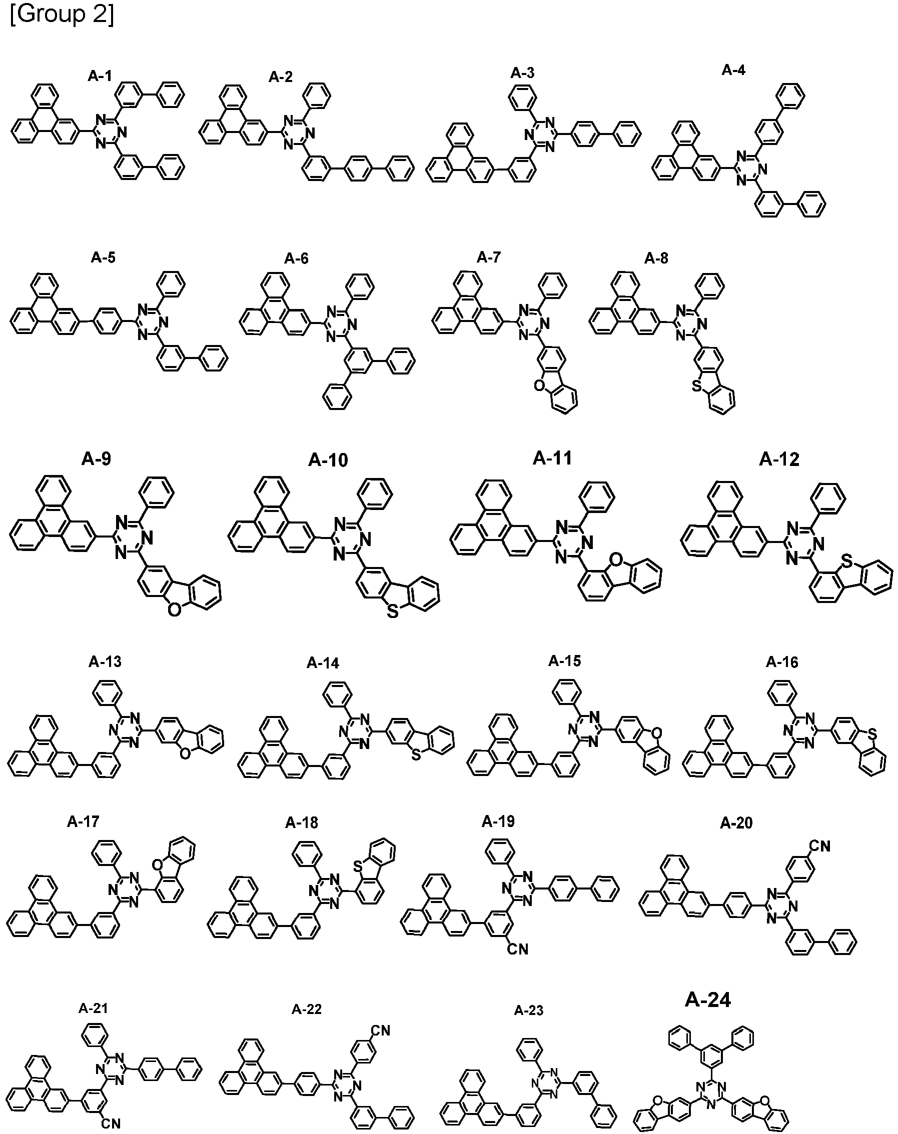

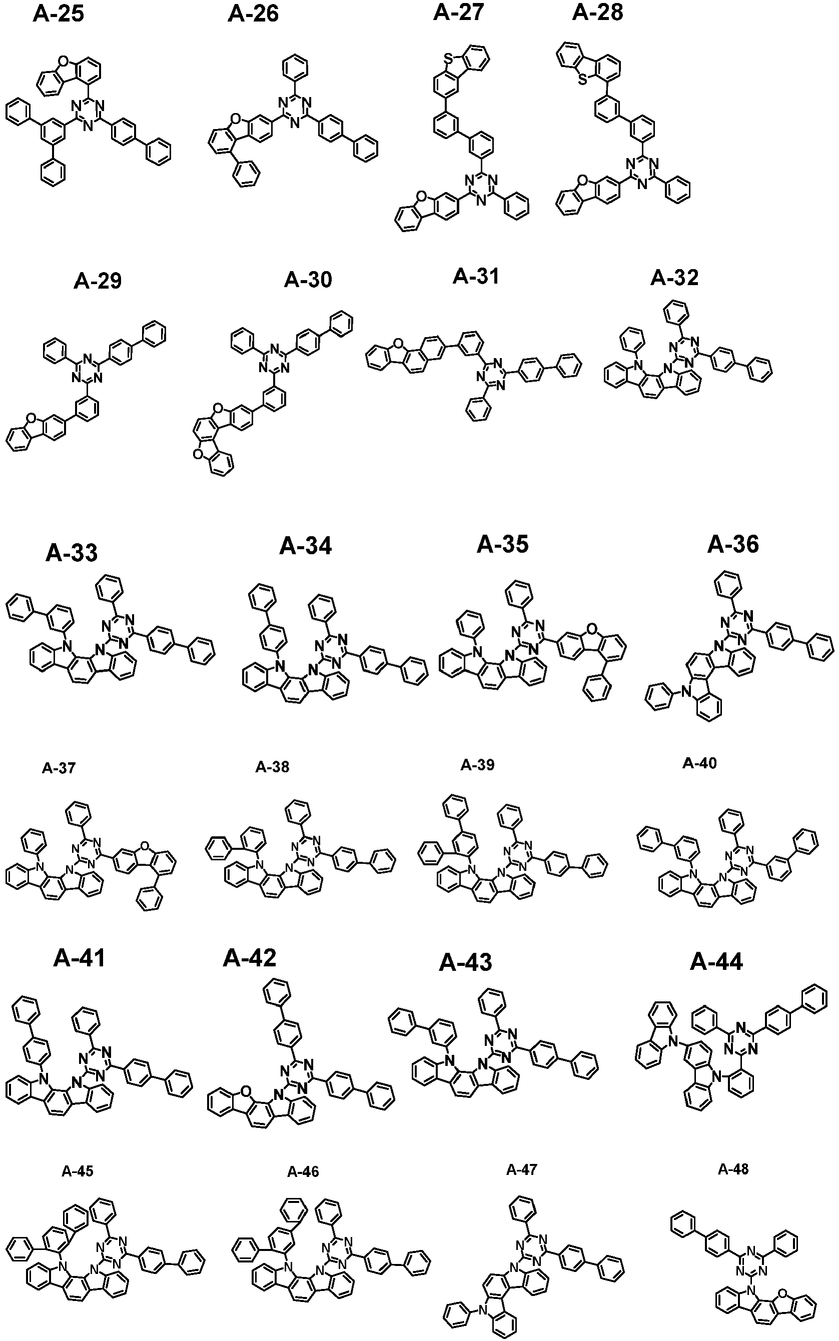

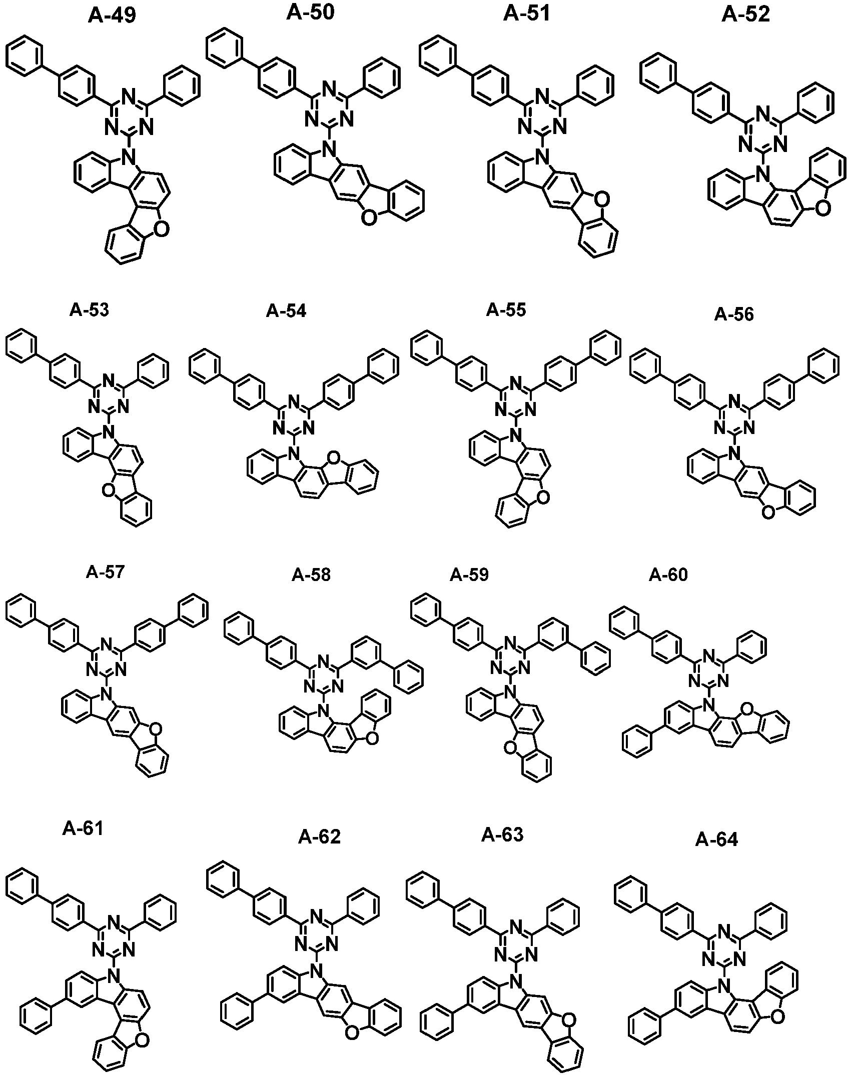

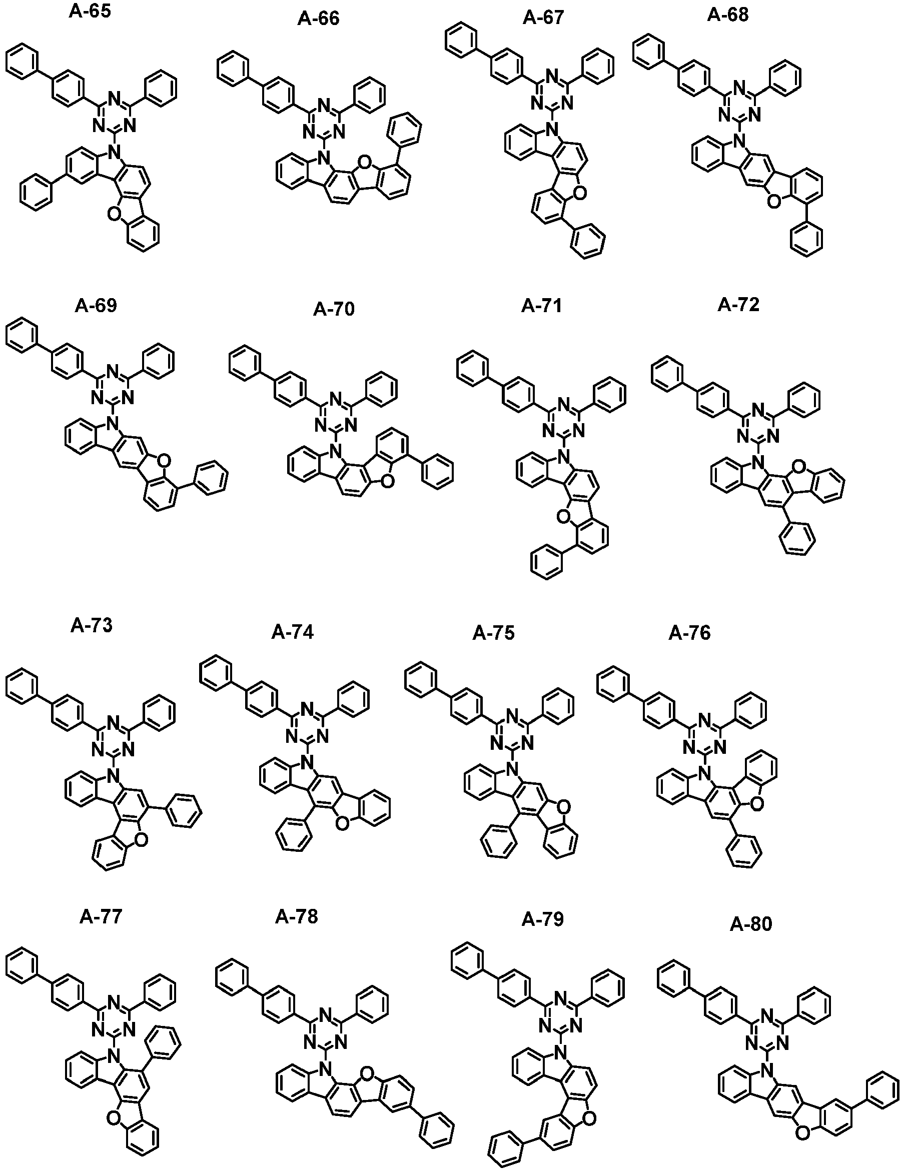

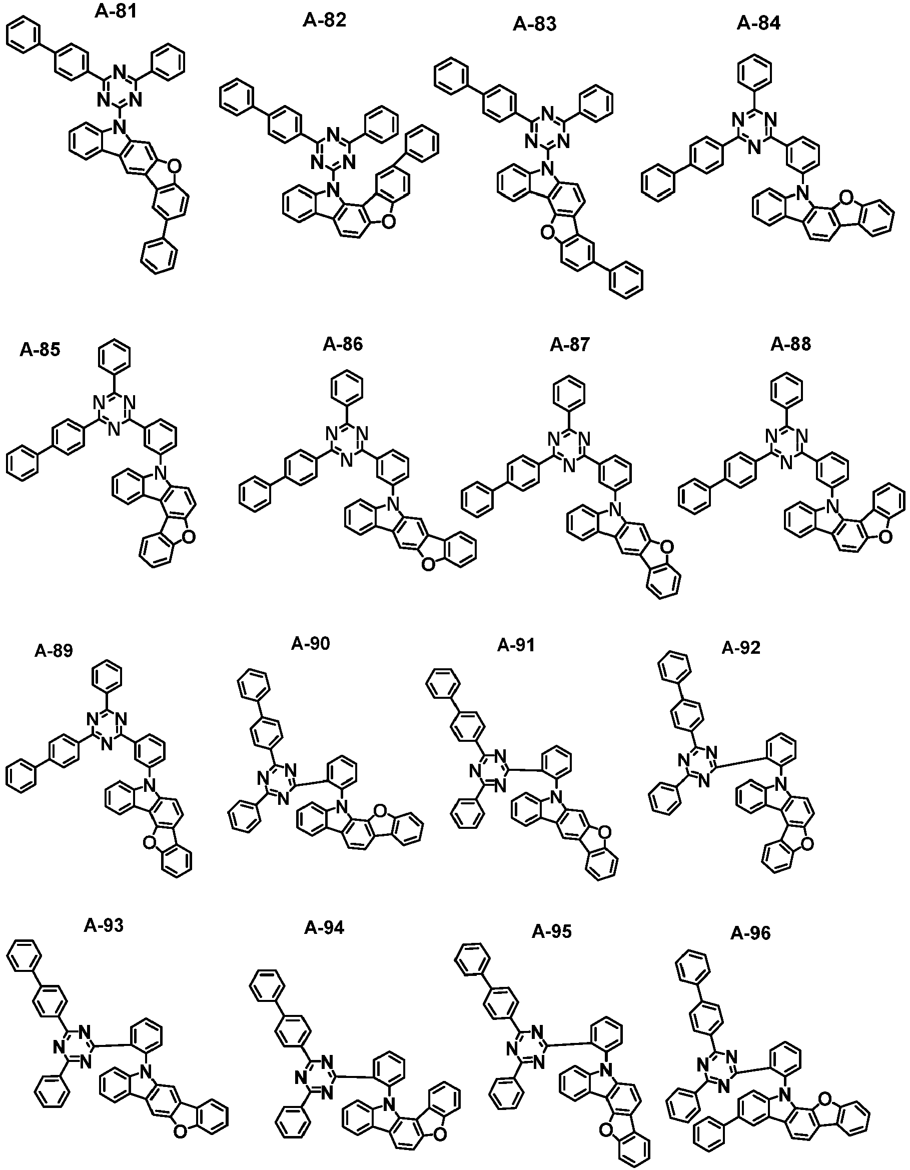

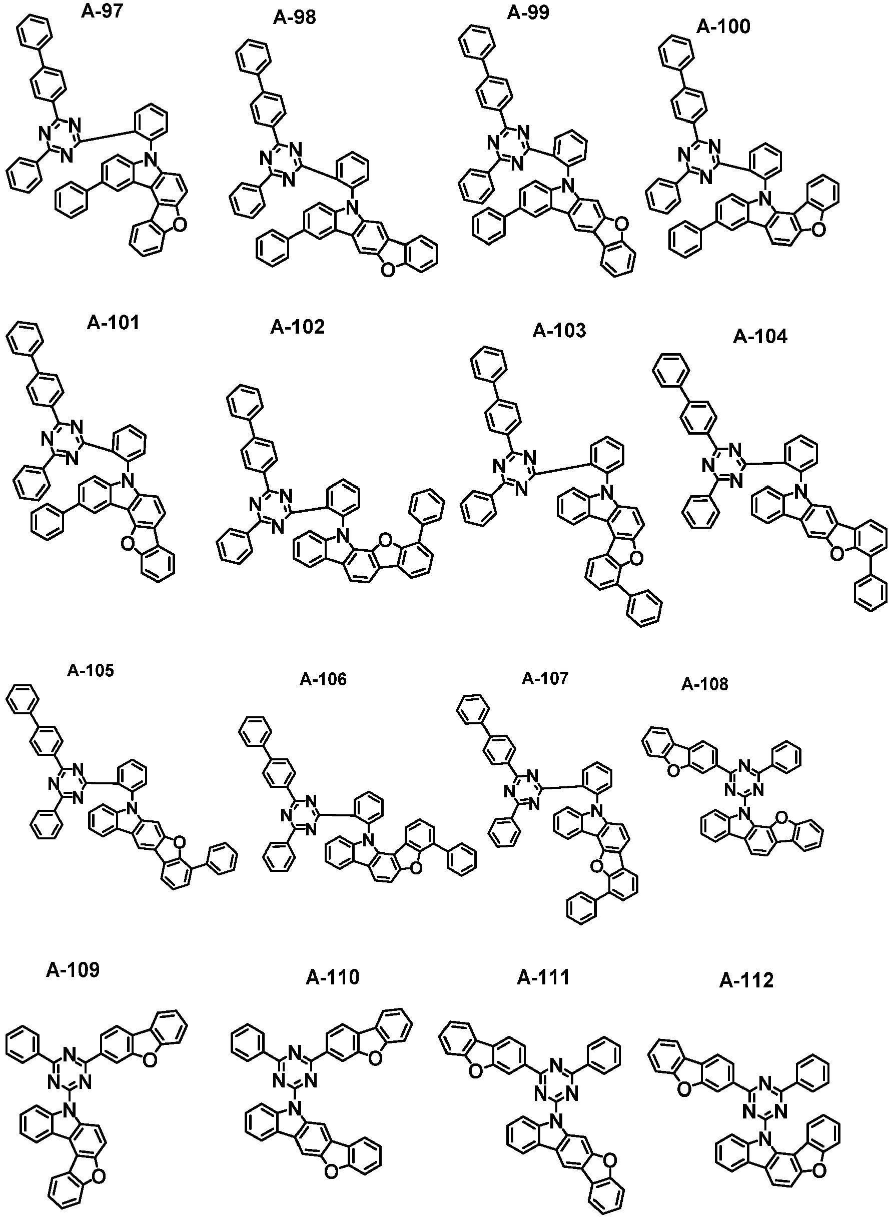

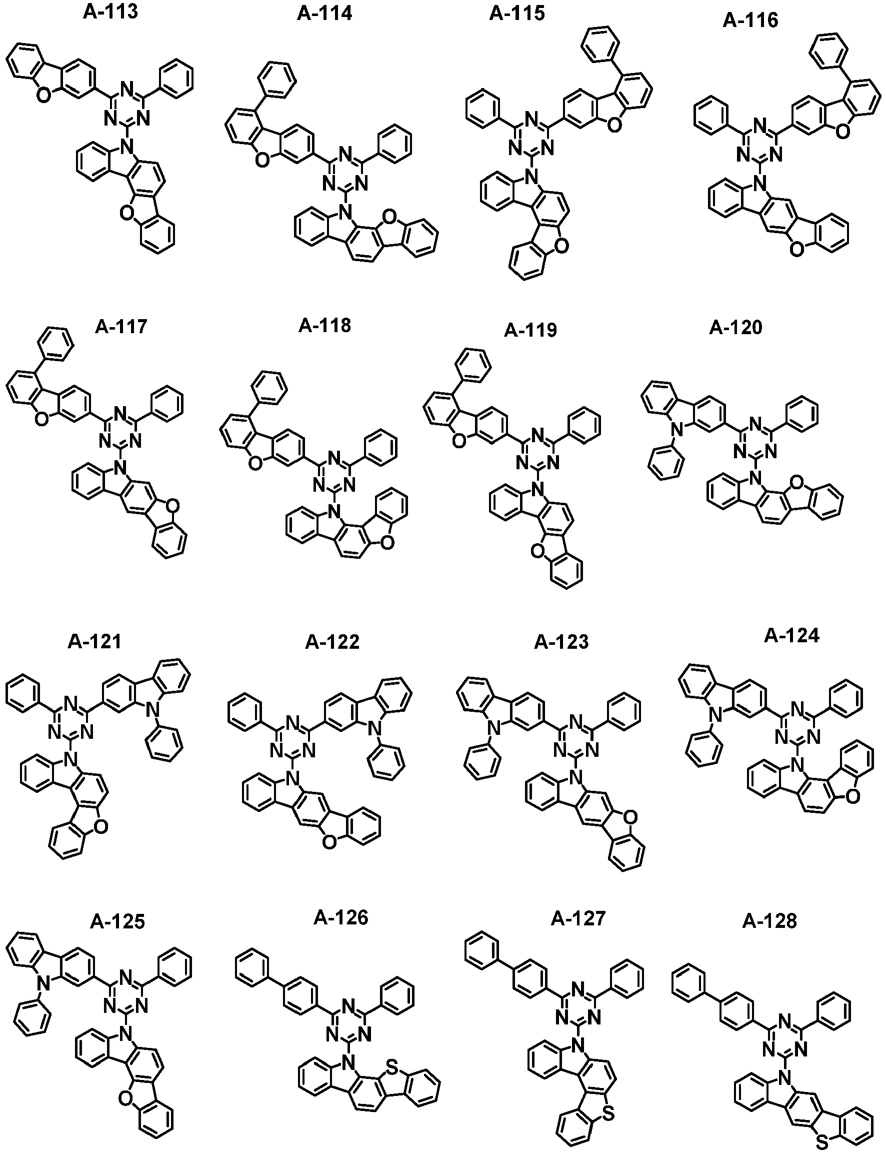

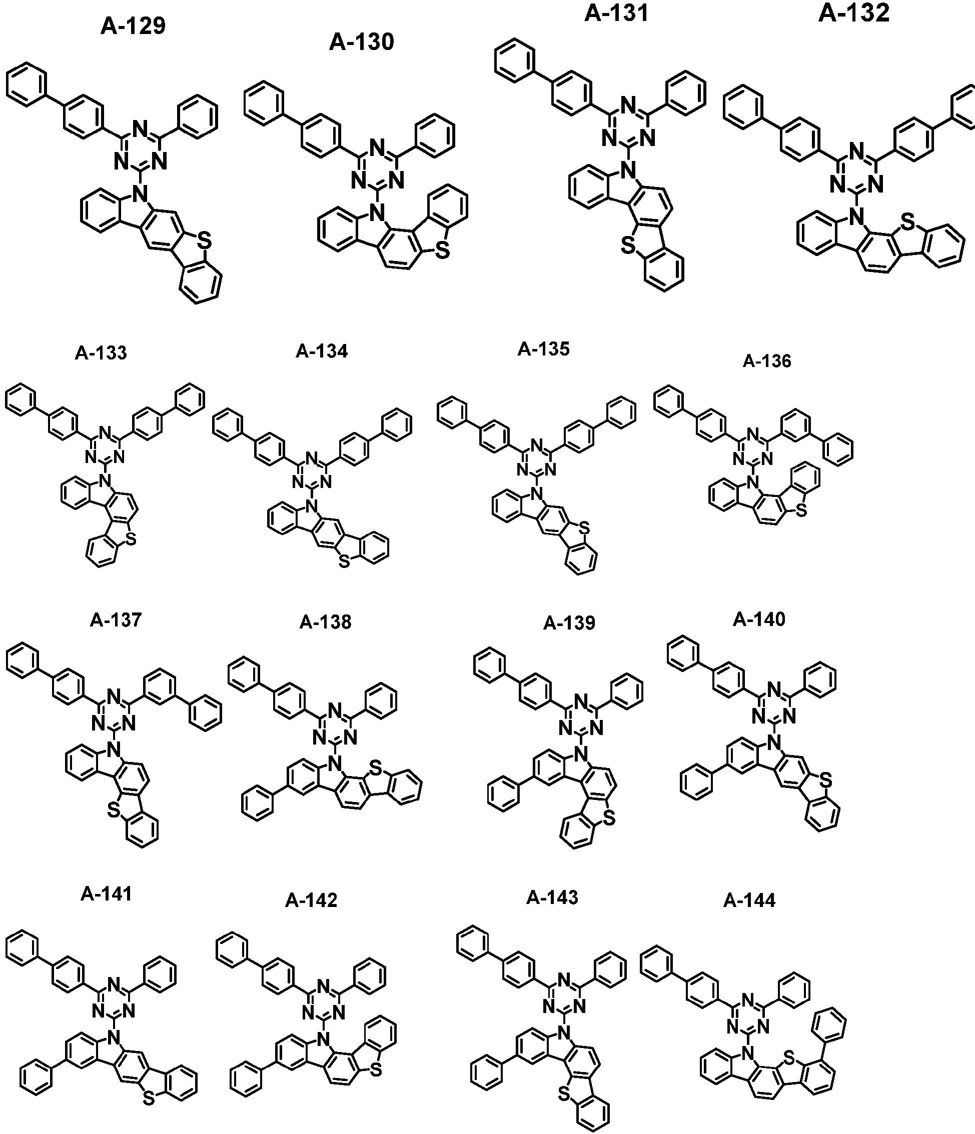

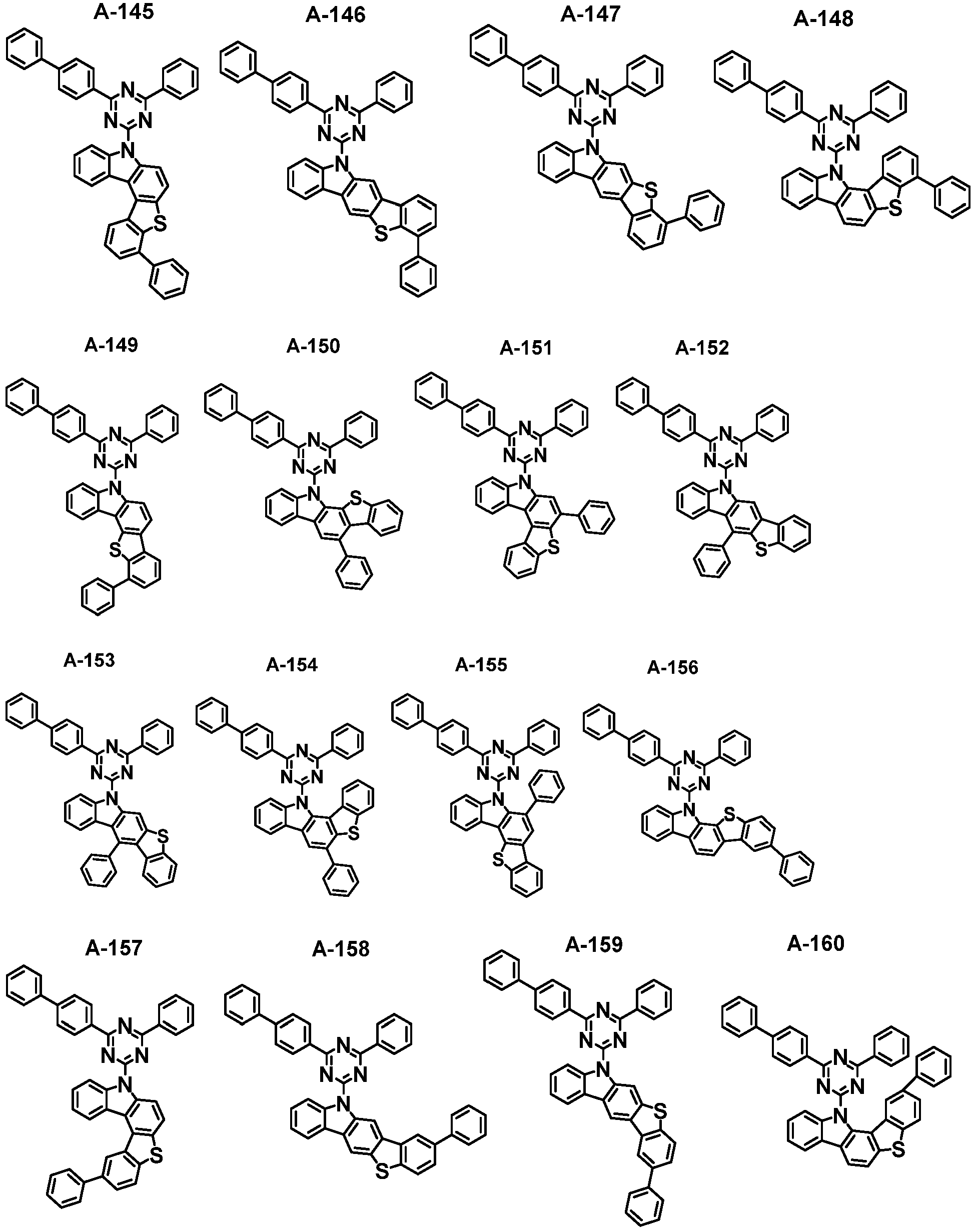

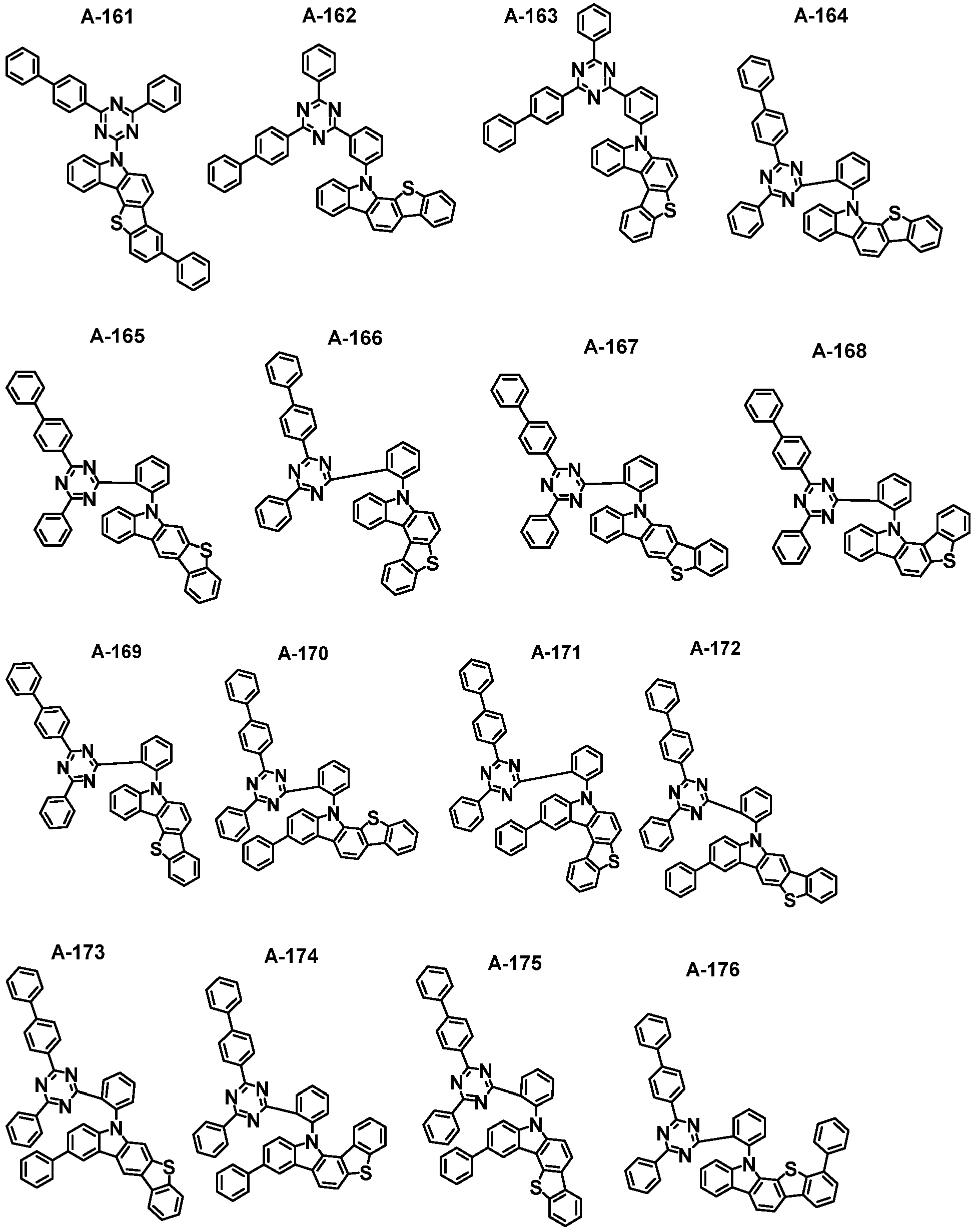

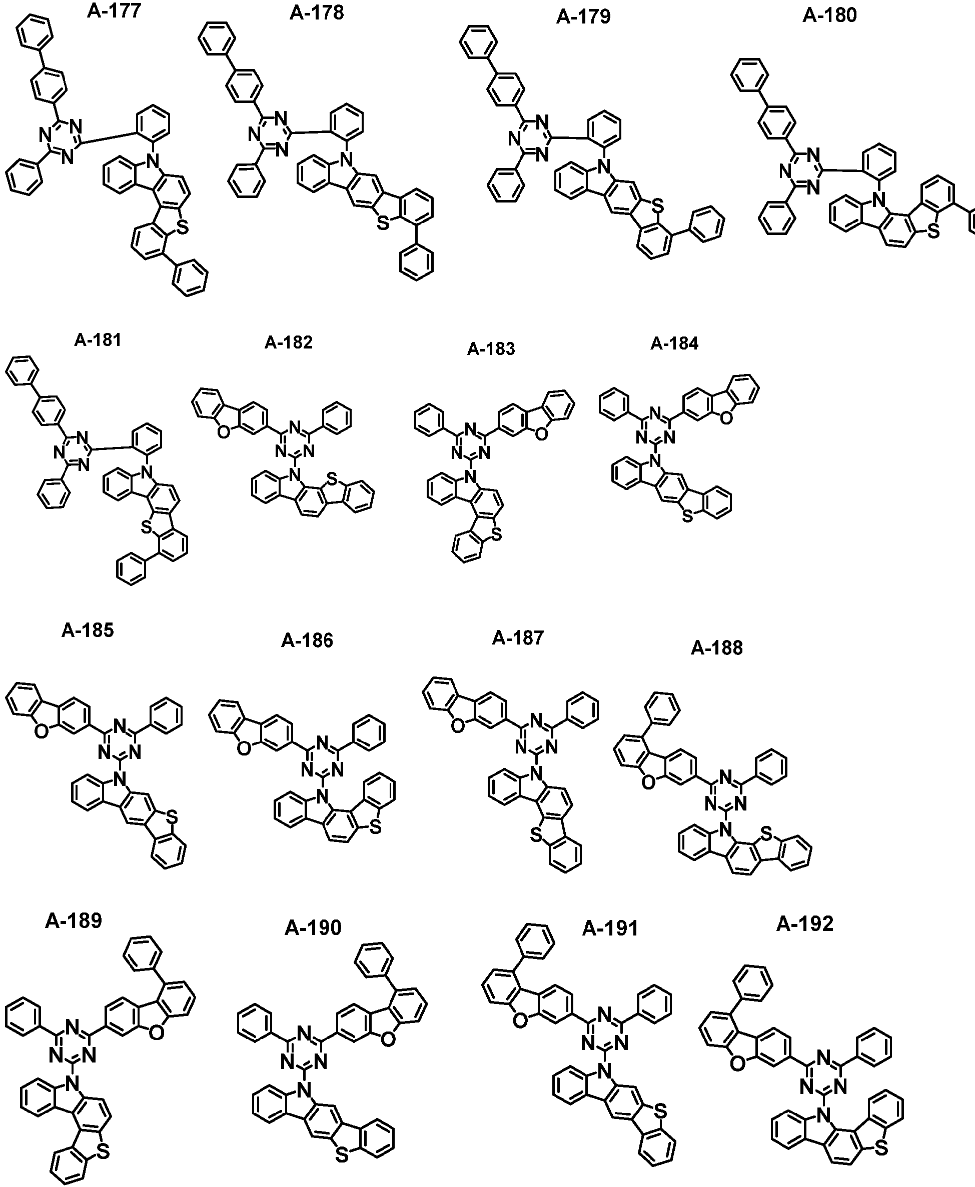

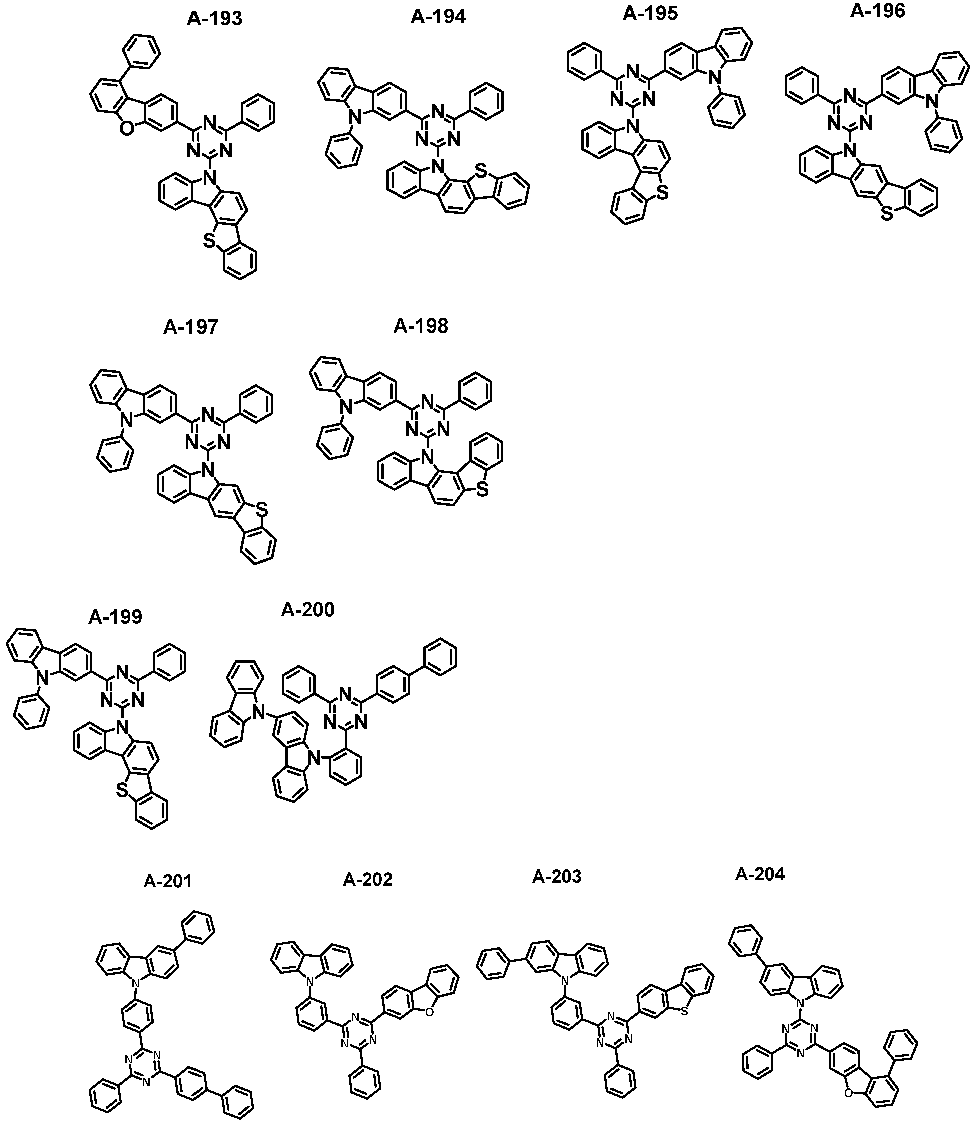

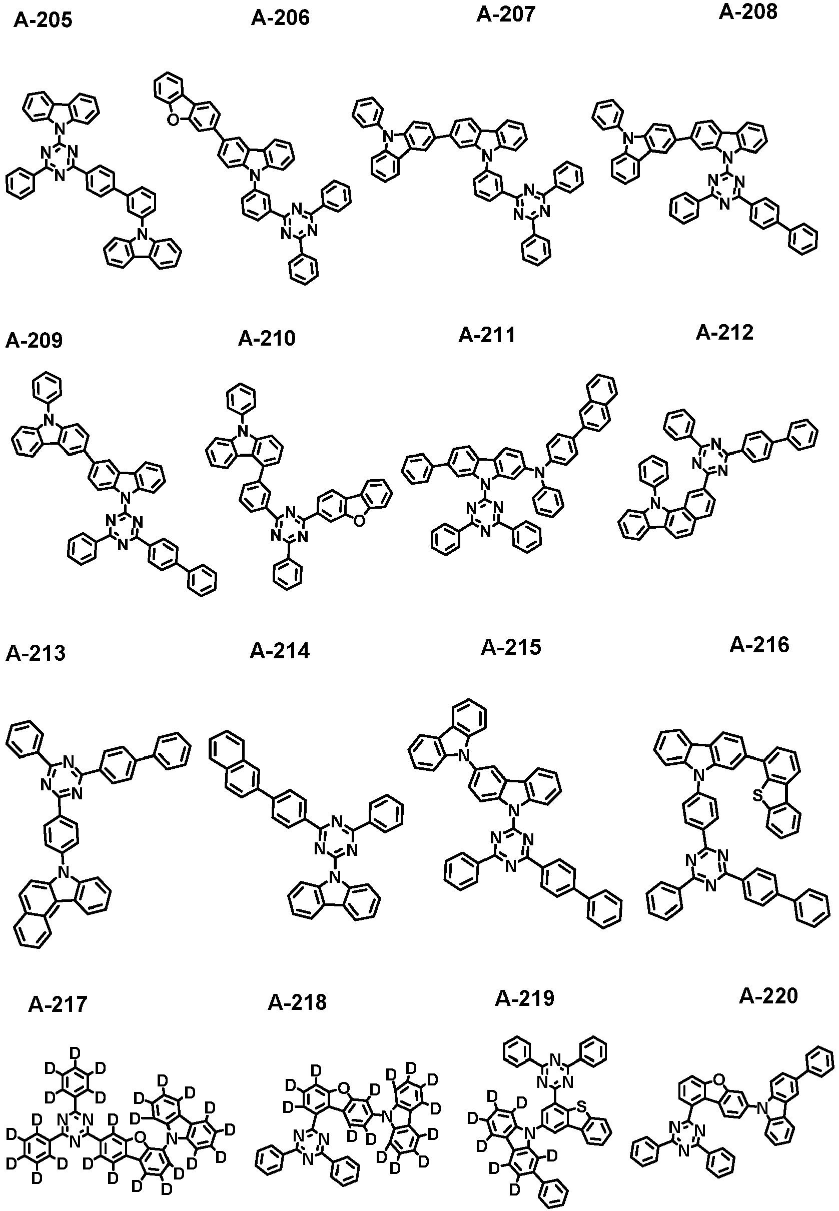

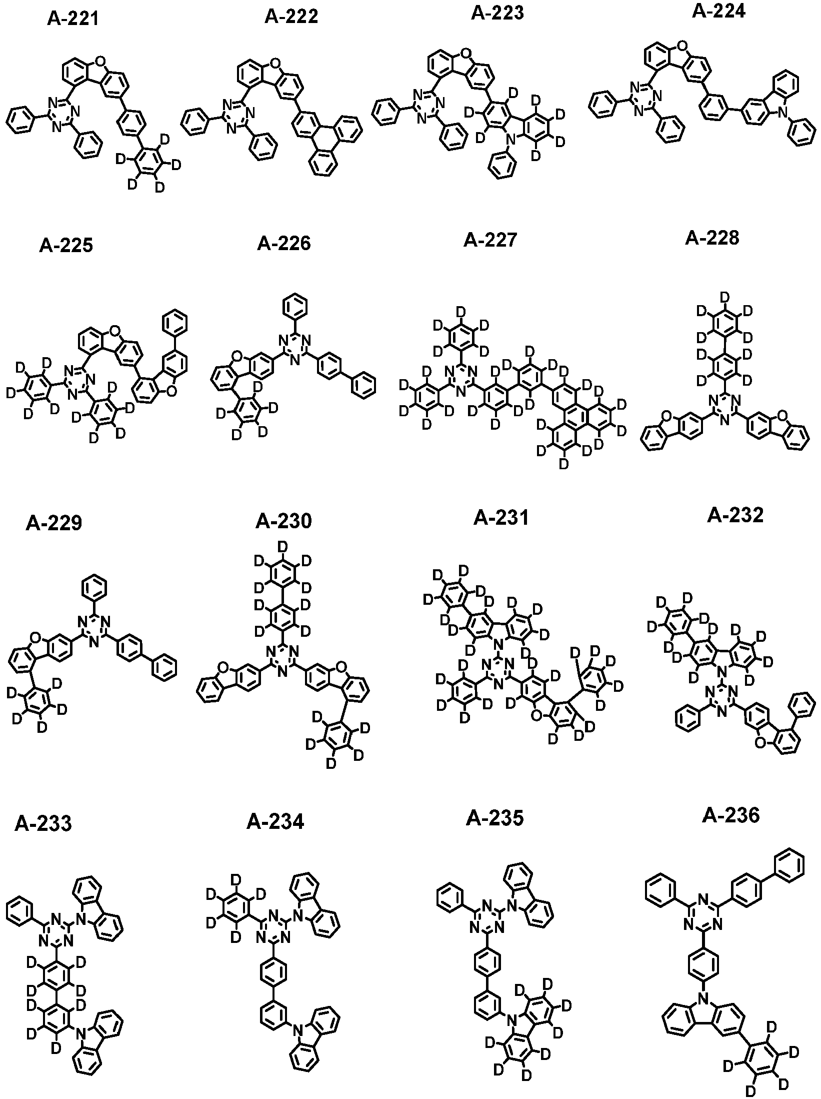

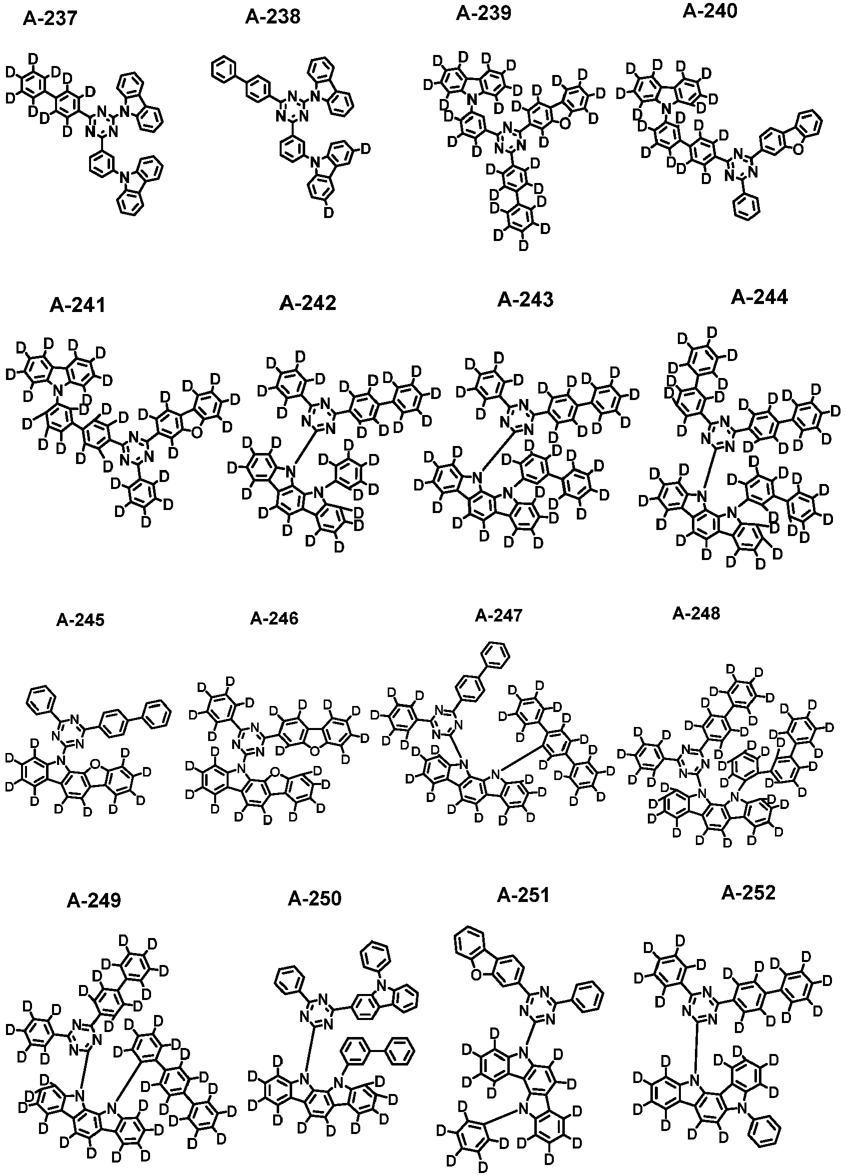

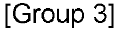

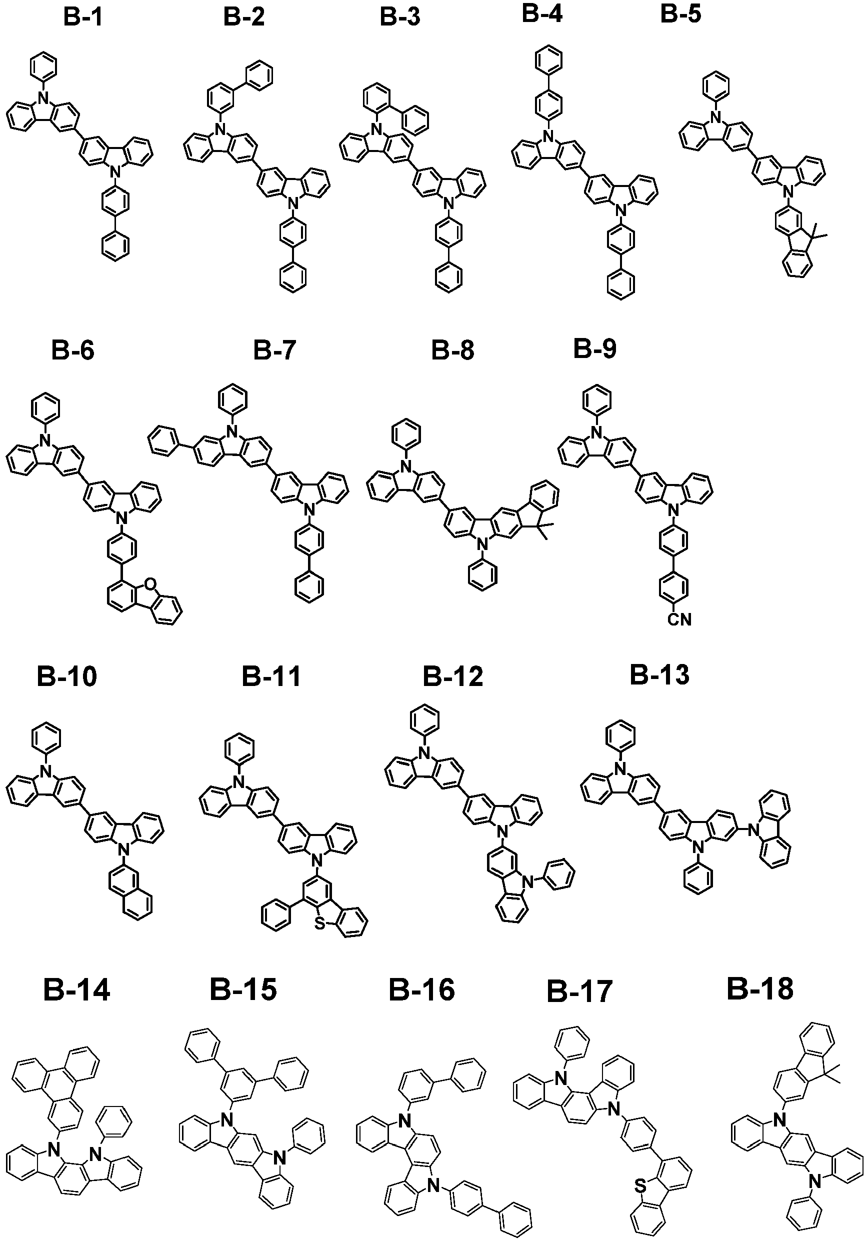

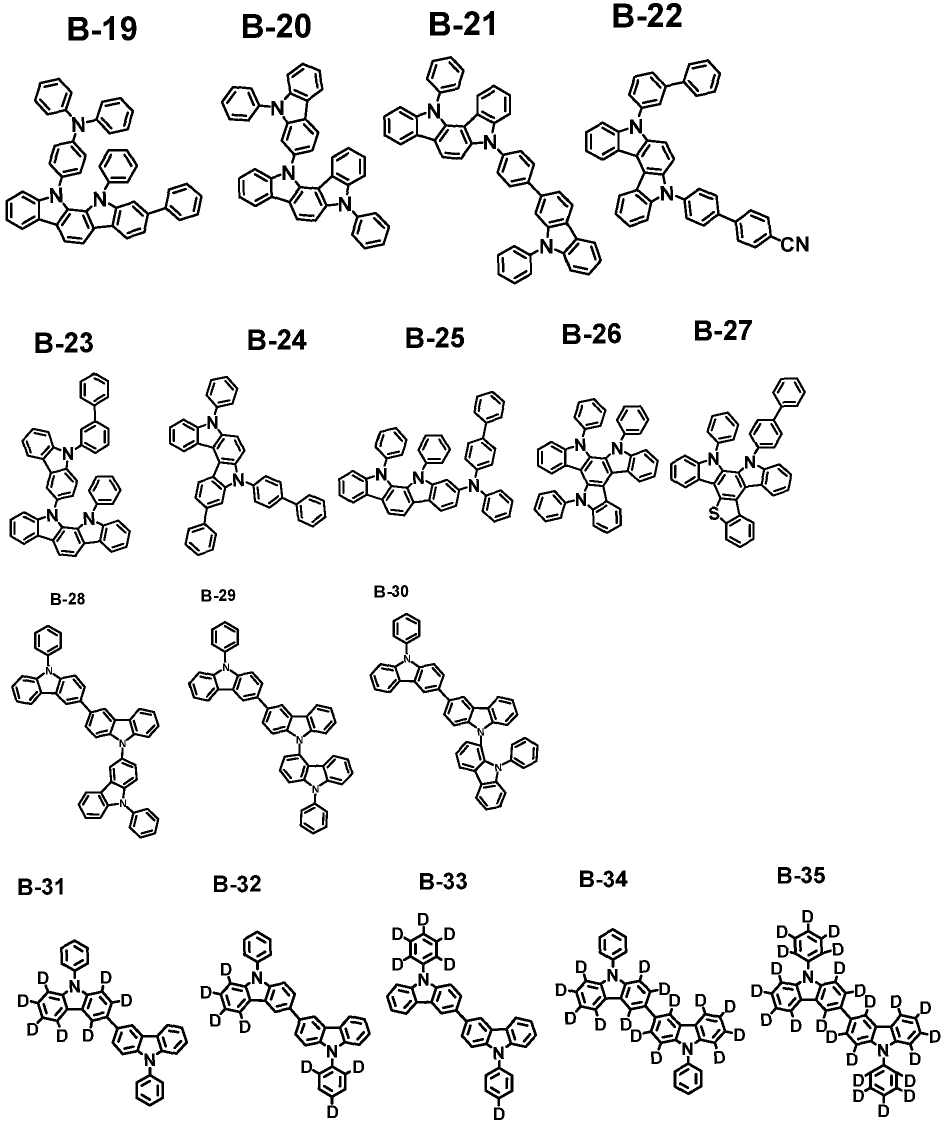

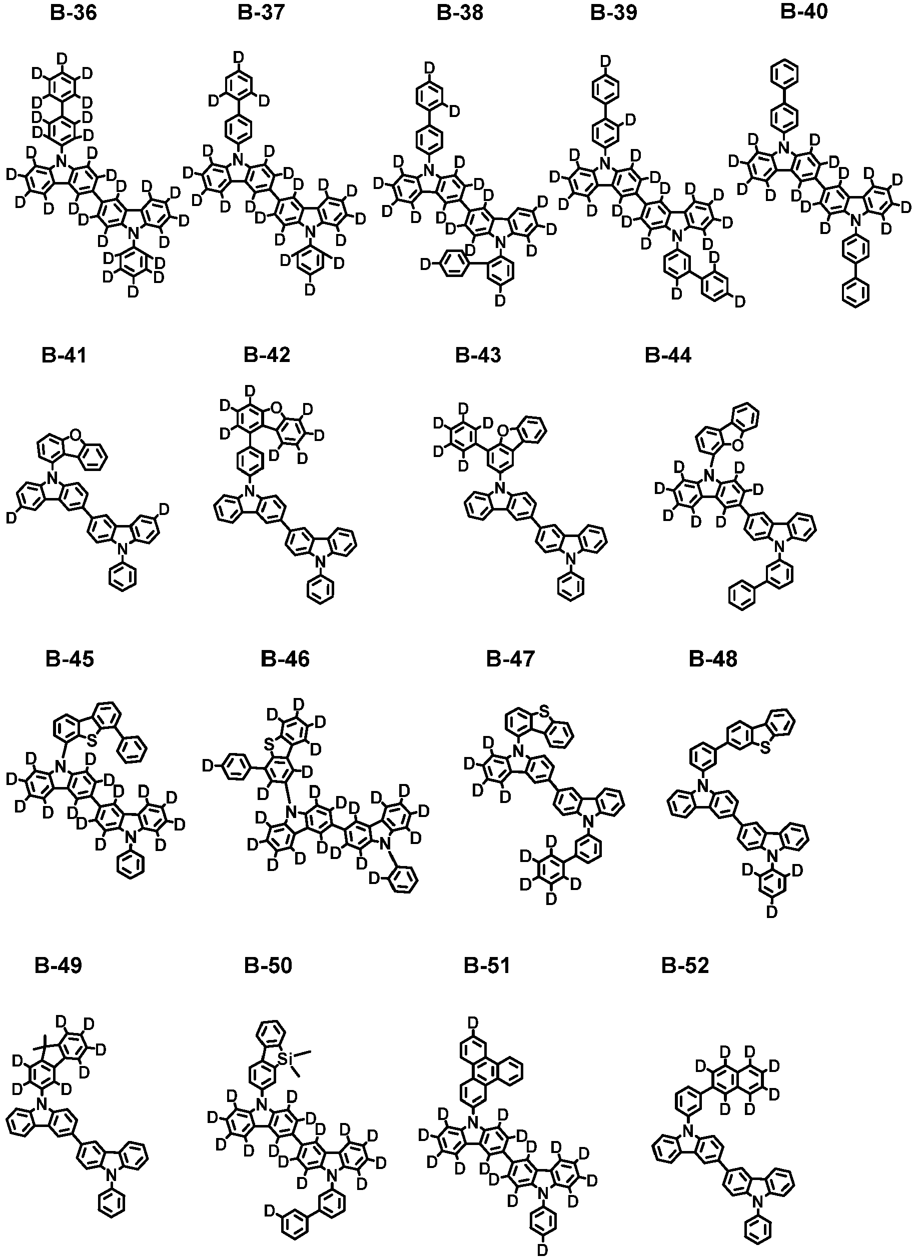

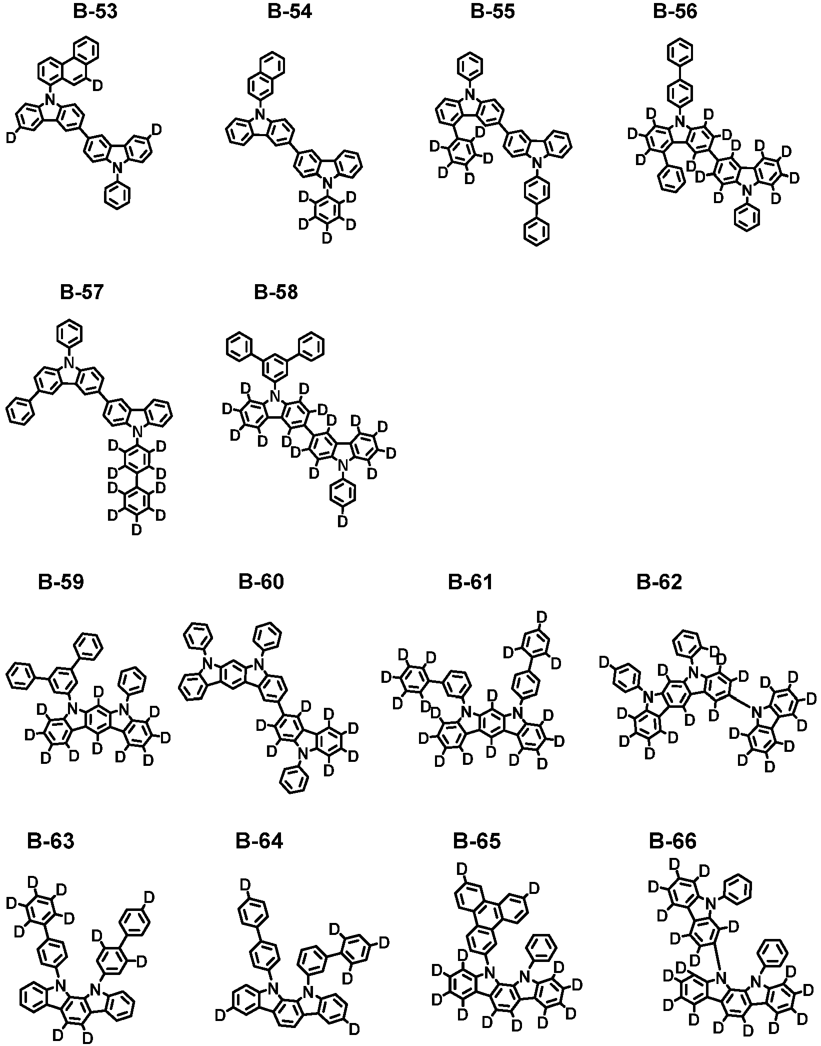

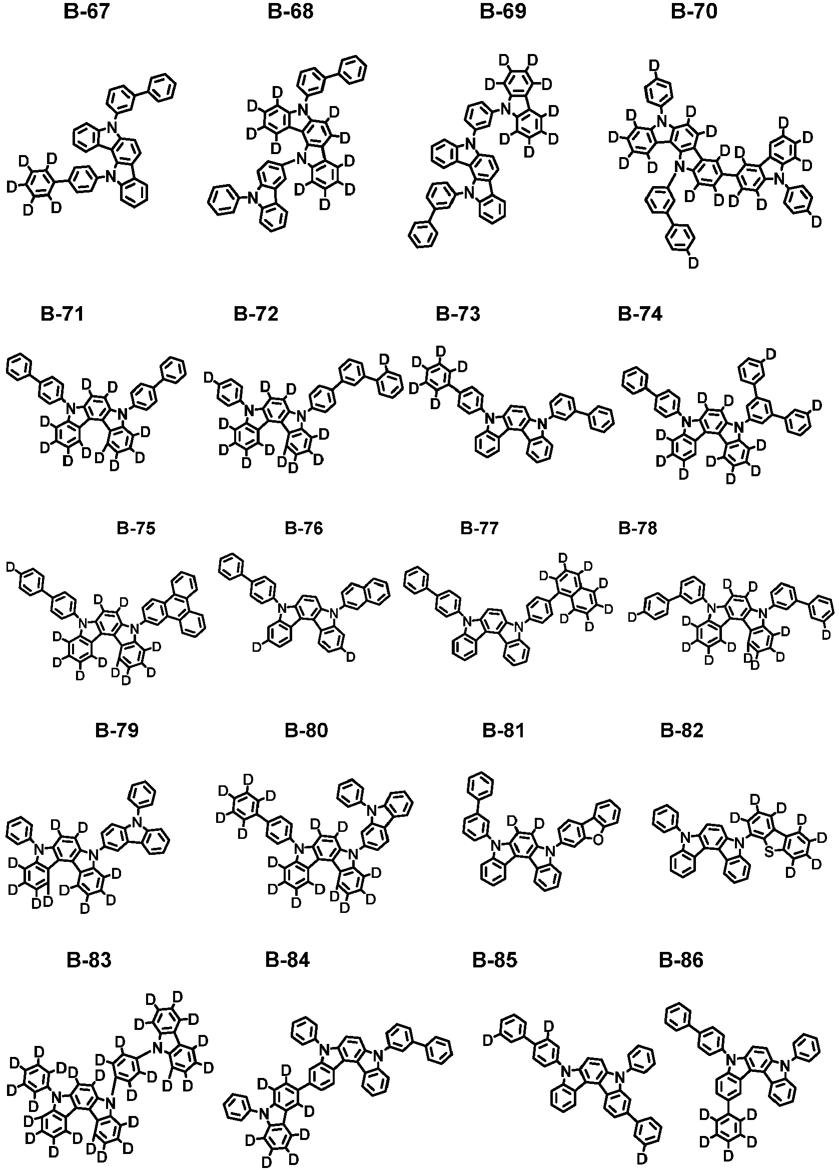

9. An organic optoelectronic device, comprising
an anode and a cathode facing each other, and
an organic layer disposed between the anode and the cathode,
wherein the organic layer includes a light emitting layer, and
the light emitting layer comprises the composition for an organic optoelectronic device of any one of claim 1 to claim 8.

10. A display device comprising the organic optoelectronic device of claim 9.
